# EUROPEAN PATENT APPLICATION

(11) **EP 2 063 529 A2**
(43) Date of publication of application: **27.05.2009**
(21) Application number: 08019434.3
(22) Date of filing: 06.11.2008
(51) Int. Cl.: H03H 7/46, H04B 1/52

(54) **High frequency electronic component**

(30) Priority: 16.11.2007 JP 2007297454; 07.03.2008 JP 2008057225; 13.03.2008 JP 2008064744
(71) Applicant: TDK Corporation, Chuo-ku, Tokyo 103-8272 (JP)
(72) Inventor: Goi, Tomoyuki, Tokyo, 103-8272 (JP); Nagai, Kenta, Tokyo, 103-8272 (JP); Harada, Nobumi, Tokyo, 103-8272 (JP); Miura, Mitsuru, Tokyo, 103-8272 (JP); Yoshida, Shuichi, Tokyo, 103-8272 (JP)
(74) Representative: Grünecker, Kinkeldey, Stockmair & Schwanhäusser Anwaltssozietät

(57) **Abstract**

A high frequency electronic component includes a switch and a balun. The switch performs switching between a first transmission signal in the form of an unbalanced signal received at a first input port and a second transmission signal in the form of an unbalanced signal received at a second input port, and outputs one of the first and second transmission signals from an output port. The balun converts the transmission signal in the form of an unbalanced signal outputted form the output port of the switch to a transmission signal in the form of a balanced signal, and outputs this signal to a balanced input power amplifier.

## Description

### BACKGROUND OF THE INVENTION

### 1. Field of the Invention

The present invention relates to a high frequency electronic component for use in a signal processing circuit that processes a plurality of high frequency signals, and more specifically, to a high frequency electronic component for use in a transmission circuit that processes a plurality of transmission signals or a reception circuit that processes a plurality of reception signals.

### 2. Description of the Related Art

Recently, cellular phones capable of operating in a plurality of frequency bands (multi-bands) have been put to practical use. The third-generation cellular phones having a high-rate data communication function have also been widely used. Accordingly, multi-mode and multi-band capability is demanded of cellular phones.

For example, cellular phones conforming to the time division multiple access (TDMA) system and having multi-band capability are in practical use. Cellular phones conforming to the wide-band code division multiple access (WCDMA) system are also in practical use. Under the circumstances, multi-mode- and multi-band-capable cellular phones having communication functions for both the TDMA system and the WCDMA system are demanded in order to make WCDMA communications available while capitalizing on the existing infrastructure of the TDMA system. For example, in Europe it is demanded that cellular phones of the global system for mobile communications (GSM), which is based on the TDMA system, be capable of performing communications under the universal mobile telecommunications system (UMTS), which is based on the WCDMA system.

In a transmission circuit that performs processing of transmission signals in a wireless communication apparatus such as a cellular phone, a power amplifier for amplifying the transmission signals is an essential component. The power amplifier is more expensive than other electronic components constituting the transmission circuit.

Conventionally, in a multi-band-capable GSM cellular phone, a single power amplifier is used in common for two frequency bands close to each other. In a multi-mode-capable cellular phone having communication functions for both the GSM system and the UMTS, however, a single power amplifier is not shared between the GSM system and the UMTS. In a multi-mode- and multi-band-capable cellular phone having communication functions for one or more bands of the GSM system and a plurality of bands of the UMTS, a single power amplifier is not shared between the plurality of bands of the UMTS.

JP-A-2006-186956 discloses a wireless communication apparatus having a multi-mode transmission circuit for selectively switching between the TDMA mode and the code division multiple access (CDMA) mode. This publication also discloses a technique of connecting a switch to an input terminal of a power amplifier and inputting a plurality of kinds of transmission signals selectively to the power amplifier by using the switch.

JP-A-2003-143033 discloses a high frequency switch module including a switch circuit for switching between a transmission path and a reception path, a balun transformer circuit connected to the transmission path, and a balun transformer circuit connected to the reception path.

In a cellular phone capable of operating under the GSM system and the UMTS, in many cases, an integrated circuit that mainly performs modulation and demodulation of signals generates a GSM transmission signal and a UMTS transmission signal and these transmission signals are inputted to a transmission circuit. In the transmission circuit, conventionally, the GSM transmission signal and the UMTS transmission signal are amplified by different power amplifiers. The transmission circuit thus requires a plurality of power amplifiers, each of which is relatively expensive as previously mentioned, and this impedes reductions in size and cost of the cellular phone.

To cope with this, the common use of a single power amplifier for a plurality of transmission signals is conceivable. To achieve this, a switch for inputting one of the plurality of transmission signals selectively to the single power amplifier may be provided before the power amplifier.

As a power amplifier for use in a cellular phone, one formed of a monolithic microwave integrated circuit (hereinafter, MMIC) and consisting of a plurality of balanced input/output amplifiers connected in multiple stages has been proposed in many publications in recent years. Such a power amplifier is of the balanced input type which receives a transmission signal in the form of a balanced signal. JP-A-2006-186956 discloses a configuration in which a switch is provided before a power amplifier of the unbalanced input type. However, such a configuration deals with only a transmission signal in the form of an unbalanced signal, and therefore cannot use a balanced input power amplifier that has been proposed in many publications as described above.

In a cellular phone capable of operating under the GSM system and the UMTS, in many cases, the GSM transmission signal is generated in the form of a balanced signal and the UMTS transmission signal is generated in the form of an unbalanced signal by the integrated circuit. In the case where a transmission signal in the form of a balanced signal and a transmission signal in the form of an unbalanced signal both exist as above, the common use of a single power amplifier for both the transmission signal in the form of a balanced signal and the transmission signal in the form of an unbalanced signal is not possible.

For a transmission circuit that processes a plurality of transmission signals, such a configuration may be possible that all of the transmission signals are provided in the form of a balanced signal so as to allow the common use of a balanced input power amplifier for the plurality of transmission signals. In this case, a switch for switching between the balanced signals may be provided before the balanced input power amplifier. However, a switch for switching between balanced signals is more expensive than a switch for switching between unbalanced signals. Consequently, while the configuration in which a switch for switching between balanced signals is provided before the balanced input power amplifier allows a cost reduction by reducing the number of the power amplifiers, it causes a cost increase on the other hand, because of the use of the switch for switching between balanced signals.

In a reception circuit that processes a reception signal in a wireless communication apparatus such as a cellular phone, a low-noise amplifier for amplifying the reception signal is an essential component. The low-noise amplifier is more expensive than other electronic components constituting the reception circuit.

Conventionally, for a dual band system in which the distance between reception frequency bands of the two systems is narrower than the distance between the transmission and reception frequency bands, the common use of a single reception circuit including a low-noise amplifier and a reception filter for two reception signals has been proposed, as disclosed in, for example, JP-A-2005-064778.

On the other hand, JP-A-2005-236971 discloses the technique of using a differential input/output low-noise amplifier in a transmission circuit of a wireless communication apparatus such as a cellular phone. JP-A-2006-074749 discloses the technique of outputting a reception signal in the form of a balanced signal from an antenna duplexer and amplifying this reception signal using a differential input/output low-noise amplifier. Typically, in a reception circuit, the use of a differential input/output low-noise amplifier that amplifies a reception signal in the form of a balanced signal reduces common-mode noise of the reception signal and improves the reception sensitivity.

In recent years, as cellular phones have become multi-banded and multi-moded, the number of low-noise amplifiers and the area occupied by the low-noise amplifiers in a cellular phone have increased. This is detrimental to miniaturization of cellular phones. In addition, since a low-noise amplifier is relatively expensive as mentioned previously, the increase in the number of low-noise amplifiers in a cellular phone causes a cost increase.

To cope with this, as disclosed in JP-A-2005-064778, the common use of a reception circuit including a low-noise amplifier and a reception filter for two reception signals is conceivable. However, combinations of two frequency bands allowing the common use of a reception filter are very limited. For example, the common use of a reception filter is not possible for a GSM reception signal of the 850 MHz band (869 to 894 MHz) and a GSM reception signal of the 900 MHz band (925 to 960 MHz), even through the frequency bands are relatively close to each other. The technique disclosed in JP-A-2005-064778 thus has a disadvantage that systems to which the technique is applicable are very limited.

In a reception circuit, a differential input/output low-noise amplifier that amplifies a reception signal in the form of a balanced signal is preferably used for improved reception sensitivity. In the case of using a differential input/output low-noise amplifier in a reception circuit also, an increase in the number of the low-noise amplifiers and an increase in the area occupied by the low-noise amplifiers are detrimental to reductions in size and cost of the cellular phone.

The technique disclosed in JP-A-2005-064778 is intended for reception signals in the form of an unbalanced signal, and is therefore not applicable to a reception circuit that uses a differential input/output low-noise amplifier for amplifying a reception signal in the form of a balanced signal.

For a reception circuit that processes a plurality of reception signals, such a configuration may be possible that all of lines in the reception circuit for all of the reception signals are provided as lines for balanced signals so as to allow the common use of a single differential input/output low-noise amplifier for the plurality of reception signals. In this case, a switch for switching between balanced signals may be provided before the differential input/output low-noise amplifier. A switch for switching between balanced signals is more expensive than a switch for switching between unbalanced signals. Consequently, while the configuration in which a switch for switching between balanced signals is provided before a single balanced input/output low-noise amplifier allows a cost reduction by reducing the number of the low-noise amplifiers, it causes a cost increase on the other hand, because of the use of the switch for switching between balanced signals. In addition, if all reception signals are to be provided in the form of a balanced signal, lines for the balanced signals are required to be longer, which results in a problem that the degree of balance of the balanced signals tends to become lower.

### OBJECT AND SUMMARY OF THE INVENTION

It is an object of the present invention to provide a high frequency electronic component for use in a signal processing circuit that processes a plurality of high frequency signals, i.e., a plurality of transmission signals or a plurality of reception signals, the high frequency electronic component allowing the use of a balanced input amplifier and allowing reductions in size and cost of the signal processing circuit by reducing the number of amplifiers.

A high frequency electronic component of the present invention is for use in a signal processing circuit that processes a plurality of high frequency signals and that includes a balanced input amplifier for amplifying a high frequency signal in the form of a balanced signal. The high frequency electronic component includes a switch and a balun. The switch has an output port and a plurality of input ports. The input ports respectively receive a plurality of high frequency signals each in the form of an unbalanced signal. The switch performs switching between the plurality of high frequency signals each in the form of an unbalanced signal received at the plurality of input ports, and outputs one of the high frequency signals from the output port. The balun converts the high frequency signal in the form of an unbalanced signal outputted from the output port of the switch to a high frequency signal in the form of a balanced signal, and outputs this high frequency signal in the form of a balanced signal to the balanced input amplifier.

The high frequency electronic component of the present invention may further include the balanced input amplifier, or may further include a band-pass filter provided in at least one of signal paths that are respectively connected to the plurality of input ports.

The high frequency electronic component of the present invention may further include a capacitor provided in at least one of signal paths that are respectively connected to the output port and the plurality of input ports.

The high frequency electronic component of the present invention may further include a layered substrate including a plurality of dielectric layers stacked. The layered substrate may further include a plurality of conductor layers provided within the layered substrate. The balun may be formed using the plurality of conductor layers, and the switch may be mounted on the layered substrate.

The signal processing circuit may be a transmission circuit that processes a plurality of transmission signals. The plurality of high frequency signals each in the form of an unbalanced signal may be a plurality of transmission signals each in the form of an unbalanced signal. The balanced input amplifier may be a power amplifier. In this case, the high frequency electronic component may further include a second balun that is provided in one of the signal paths respectively connected to the plurality of input ports and that converts a transmission signal in the form of a balanced signal to a transmission signal in the form of an unbalanced signal.

The signal processing circuit may be a reception circuit that processes a plurality of receptions signals. The plurality of high frequency signals each in the form of an unbalanced signal may be a plurality of reception signals each in the form of an unbalanced signal. The balanced input amplifier may be a differential input/output low-noise amplifier.

According to the high frequency electronic component of the present invention, the switch performs switching between the plurality of high frequency signals each in the form of an unbalanced signal received at the plurality of input ports, and outputs one of the high frequency signals from the output port. The balun converts the high frequency signal in the form of an unbalanced signal outputted from the output port of the switch to a high frequency signal in the form of a balanced signal, and outputs this high frequency signal in the form of a balanced signal to the balanced input amplifier for amplifying the signal. Thus, the present invention allows the use of a balanced input amplifier in a signal processing circuit, and allows reductions in size and cost of the signal processing circuit by reducing the number of amplifiers.

In the case where: the signal processing circuit is a transmission circuit that processes a plurality of transmission signals; the plurality of high frequency signals each in the form of an unbalanced signal are a plurality of transmission signals each in the form of an unbalanced signal; and the balanced input amplifier is a power amplifier, the high frequency electronic component of the present invention may further include a second balun that is provided in at least one of the signal paths respectively connected to the plurality of input ports and that converts a transmission signal in the form of a balanced signal to a transmission signal in the form of an unbalanced signal. In this case, it becomes possible to use a balanced input power amplifier in a transmission circuit that processes a transmission signal in the form of a balanced signal and a transmission signal in the form of an unbalanced signal. This allows a reduction in the number of power amplifiers, and consequently allows reductions in size and cost of the transmission circuit.

Other and further objects, features and advantages of the invention will appear more fully from the following description.

### BRIEF DESCRIPTION OF THE DRAWINGS

FIG. 1 is a block diagram illustrating the circuit configuration of an example of a high frequency circuit of a cellular phone including a high frequency electronic component of a first embodiment of the invention.
FIG. 2 is a block diagram illustrating the circuit configuration of a transmission circuit of the high frequency circuit shown in FIG. 1.
FIG. 3 is a schematic diagram illustrating the circuit configuration of the high frequency electronic component of the first embodiment of the invention.
FIG. 4 is a perspective view of the high frequency electronic component of the first embodiment of the invention.
FIG. 5 is a top view of the high frequency electronic component of the first embodiment of the invention.
FIG. 6A and FIG. 6B are illustrative views respectively showing the top surfaces of first and second dielectric layers of the layered substrate shown in FIG. 4.
FIG. 7A and FIG. 7B are illustrative views respectively showing the top surfaces of third and fourth dielectric layers of the layered substrate shown in FIG. 4.
FIG. 8A and FIG. 8B are illustrative views respectively showing the top surfaces of fifth and sixth dielectric layers of the layered substrate shown in FIG. 4.
FIG. 9A and FIG. 9B are illustrative views respectively showing the top surfaces of seventh and eighth dielectric layers of the layered substrate shown in FIG. 4.
FIG. 10A and FIG. 10B are illustrative views respectively showing the top surface of a ninth dielectric layer of the layered substrate shown in FIG. 4, and a conductor layer below the ninth dielectric layer.
FIG. 11 is a block diagram illustrating a high frequency circuit of a comparative example against the high frequency circuit of the first embodiment of the invention.
FIG. 12 is a schematic diagram illustrating another possible configuration of a balun of the first embodiment of the invention.
FIG. 13 is a block diagram illustrating a first to a third modification example of the high frequency electronic component of the first embodiment of the invention.
FIG. 14 is a block diagram illustrating a transmission circuit including a high frequency electronic component of a second embodiment of the invention.
FIG. 15 is a block diagram illustrating a transmission circuit of a first comparative example against the transmission circuit of the second embodiment of the invention.
FIG. 16 is a block diagram illustrating a transmission circuit of a second comparative example against the transmission circuit of the second embodiment of the invention.
FIG. 17 is a block diagram illustrating a transmission circuit of a third comparative example against the transmission circuit of the second embodiment of the invention.
FIG. 18 is a block diagram illustrating a transmission circuit including a high frequency electronic component of a third embodiment of the invention.
FIG. 19 is a block diagram illustrating a transmission circuit of a first comparative example against the transmission circuit of the third embodiment of the invention.
FIG. 20 is a block diagram illustrating a transmission circuit of a second comparative example against the transmission circuit of the third embodiment of the invention.
FIG. 21 is a block diagram illustrating a transmission circuit of a third comparative example against the transmission circuit of the third embodiment of the invention.
FIG. 22 is a block diagram illustrating a transmission circuit including a high frequency electronic component of a fourth embodiment of the invention.
FIG. 23 is a block diagram illustrating a transmission circuit of a first comparative example against the transmission circuit of the fourth embodiment of the invention.
FIG. 24 is a block diagram illustrating a transmission circuit of a second comparative example against the transmission circuit of the fourth embodiment of the invention.
FIG. 25 is a block diagram illustrating the circuit configuration of an example of a high frequency circuit of a cellular phone including a high frequency electronic component of a fifth embodiment of the invention.
FIG. 26 is a block diagram illustrating the circuit configuration of a reception circuit of the high frequency circuit shown in FIG. 25.
FIG.27 is a schematic diagram illustrating the circuit configuration of the high frequency electronic component of the fifth embodiment of the invention.
FIG. 28 is a perspective view of the high frequency electronic component of the fifth embodiment of the invention.
FIG. 29 is a top view of the high frequency electronic component of the fifth embodiment of the invention.
FIG. 30A and FIG. 30B are illustrative views respectively showing the top surfaces of first and second dielectric layers of the layered substrate shown in FIG. 28.
FIG. 31A and FIG. 31B are illustrative views respectively showing the top surfaces of third and fourth dielectric layers of the layered substrate shown in FIG. 28.
FIG. 32A and FIG. 32B are illustrative views respectively showing the top surfaces of fifth and sixth dielectric layers of the layered substrate shown in FIG. 28.
FIG. 33A and FIG. 33B are illustrative views respectively showing the top surfaces of seventh and eighth dielectric layers of the layered substrate shown in FIG. 28.
FIG. 34A and FIG. 34B are illustrative views respectively showing the top surface of a ninth dielectric layer of the layered substrate shown in FIG. 28, and a conductor layer below the ninth dielectric layer.
FIG. 35 is a block diagram illustrating a high frequency circuit of a comparative example against the high frequency circuit of the fifth embodiment of the invention.
FIG. 36 is a schematic diagram illustrating another possible configuration of a balun of the fifth embodiment of the invention.
FIG. 37 is a block diagram illustrating a first to a third modification example of the high frequency electronic component of the fifth embodiment of the invention.
FIG. 38 is a block diagram illustrating a high frequency circuit including a high frequency electronic component of a sixth embodiment of the invention.
FIG. 39 is a block diagram illustrating a high frequency circuit of a comparative example against the high frequency circuit of the sixth embodiment of the invention.
FIG. 40 is a block diagram illustrating a modification example of the high frequency electronic component of the sixth embodiment of the invention.
FIG. 41 is a block diagram illustrating a high frequency circuit including a high frequency electronic component of a seventh embodiment of the invention.
FIG. 42 is a block diagram illustrating a high frequency circuit of a comparative example against the high frequency circuit of the seventh embodiment of the invention.
FIG. 43 is a block diagram illustrating a high frequency circuit including a high frequency electronic component of an eighth embodiment of the invention.
FIG. 44 is a block diagram illustrating a high frequency circuit including a high frequency electronic component of a ninth embodiment of the invention.
FIG. 45 is a block diagram illustrating a high frequency circuit of a comparative example against the high frequency circuit of the ninth embodiment of the invention.
FIG. 46 is a block diagram illustrating a high frequency circuit including a high frequency electronic component of a tenth embodiment of the invention.
FIG. 47 is a block diagram illustrating a high frequency circuit including a high frequency electronic component of an eleventh embodiment of the invention.

### DETAILED DESCRIPTION OF THE PREFERRED EMBODIMENTS

### [First Embodiment]

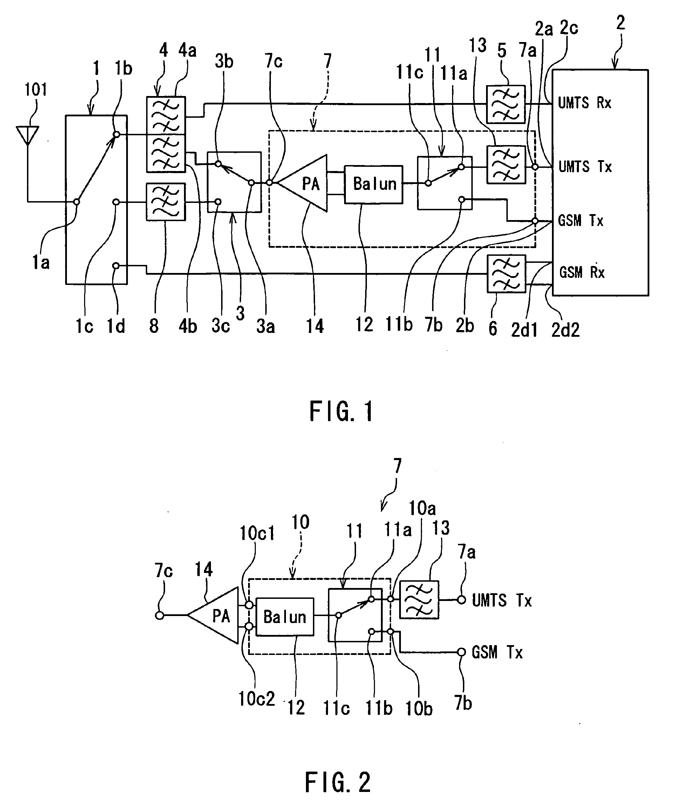

Preferred embodiments of the present invention will now be described in detail with reference to the drawings. Reference is first made to FIG. 1 to describe an example of a high frequency circuit of a cellular phone including a high frequency electronic component of a first embodiment of the invention. FIG. 1 is a block diagram illustrating the circuit configuration of this example of high frequency circuit. This high frequency circuit processes a signal of the GSM system, which is based on the TDMA system, and a signal of the UMTS, which is based on the WCDMA system.

Table 1 shows the types of GSM signals, and Table 2 shows the types of UMTS signals. In Tables 1 and 2 the "Uplink" columns show the frequency bands of transmission signals, and the "Downlink" columns show the frequency bands of reception signals.

**[Table 1]**

| System | Frequency band | Uplink (MHz) | Downlink (MHz) |
|---|---|---|---|
| GSM850 (AGSM) | 850 MHz band | 824 - 849 | 869 - 894 |
| GSM900 (EGSM) | 900 MHz band | 880 - 915 | 925 - 960 |
| GSM1800 (DCS) | 1800 MHz band | 1710 - 1785 | 1805 - 1880 |
| GSM1900 (PCS) | 1900 MHz band | 1850 - 1910 | 1930 - 1990 |

**[Table 2]**

| Band | Frequency band | Uplink (MHz) | Downlink (MHz) |
|---|---|---|---|
| I | 2100 MHz band | 1920 - 1980 | 2110 - 2170 |
| II | 1900 MHz band | 1850 - 1910 | 1930-1990 |
| III | 1800 MHz band | 1710 - 1785 | 1805 - 1880 |
| IV | 1700 MHz band | 1710 - 1755 | 2110 - 2155 |
| V | 850 MHz band | 824 - 849 | 869 - 894 |
| VI | 850 MHz band | 830 - 840 | 875 - 885 |
| VII | 2600 MHz band | 2500 - 2570 | 2620 - 2690 |
| VIII | 900 MHz band | 880 - 915 | 925 - 960 |
| IX | 1800 MHz band | 1749.9 - 1784.9 | 1844.9 - 1879.9 |
| X | 1700 MHz band | 1710 - 1770 | 2110 - 2170 |

The high frequency circuit shown in FIG. 1 includes an antenna 101, a switch 1, and an integrated circuit (hereinafter, IC) 2. The switch 1 has four ports 1a, 1b, 1c and 1d, and connects the port 1a selectively to one of the ports 1b, 1c and 1d. The port 1a is connected to the antenna 101.

The IC 2 is a circuit that mainly performs modulation and demodulation of signals. In the present embodiment, the IC 2 generates and outputs a UMTS transmission signal UMTS Tx and a GSM transmission signal GSM Tx. The transmission signal UMTS Tx and the transmission signal GSM Tx outputted by the IC 2 are each in the form of an unbalanced signal. The IC 2 receives a UMTS reception signal UMTS Rx and a GSM reception signal GSM Rx. The reception signal UMTS Rx received by the IC 2 is in the form of an unbalanced signal. The reception signal GSM Rx received by the IC 2 is in the form of a balanced signal. The IC 2 has terminals 2a, 2b, 2c, 2d1 and 2d2. The transmission signal UMTS Tx is outputted from the terminal 2a, and the transmission signal GSM Tx is outputted from the terminal 2b. The reception signal UMTS Rx is received at the terminal 2c, and the reception signal GSM Rx is received at the terminals 2d1 and 2d2.

The transmission signal GSM Tx and the reception signal GSM Rx are a transmission signal and a reception signal of at least one of GSM850 (AGSM) and GSM900 (EGSM), which are two of the four systems shown in Table 1 and are close to each other in frequency band, or at least one of GSM1800 (DCS) and GSM1900 (PCS), which are the other two of the four systems shown in Table 1 and are close to each other in frequency band. In the present embodiment, in the case where the transmission signal GSM Tx and the reception signal GSM Rx are a transmission signal and a reception signal of at least one of GSM850 (AGSM) and GSM900 (EGSM), the transmission signal UMTS Tx and the reception signal UMTS Rx are a transmission signal and a reception signal of one of the bands V, VI and VIII, the frequency bands of which are close to those of GSM850 (AGSM) and GSM900 (ESGM), among the 10 bands shown in Table 2. In the case where the transmission signal GSM Tx and the reception signal GSM Rx are a transmission signal and a reception signal of at least one of GSM1800 (DCS) and GSM1900 (PCS), the transmission signal UMTS Tx and the reception signal UMTS Rx are a transmission signal and a reception signal of one of the bands I, II, III, IV, IX and X, the frequency bands of which are close to those of GSM1800 (DCS) and GSM1900 (PCS), among the 10 bands shown in Table 2.

The high frequency circuit further includes a switch 3, a duplexer 4, a band-pass filter (hereinafter, BPF) 5, a BPF 6, a transmission circuit 7, and a low-pass filter (hereinafter, LPF) 8. The switch 3 has three ports 3a, 3b and 3c, and connects the port 3a selectively to one of the ports 3b and 3c. The port 3c is connected to the port 1c of the switch 1 via the LPF 8.

The duplexer 4 has first to third ports, and two BPFs 4a and 4b. The first port is connected to the port 1b of the switch 1. The BPF 4a is provided between the first and second ports. The BPF 4b is provided between the first and third ports. The second port of the duplexer 4 is connected to the terminal 2c of the IC 2 via the BPF 5. The third port of the duplexer 4 is connected to the port 3b of the switch 3.

The BPF 6 has an unbalanced input and two balanced outputs. The two balanced outputs of the BPF 6 are connected to the terminals 2d1 and 2d2 of the IC 2. The unbalanced input of the BPF 6 is connected to the port 1d of the switch 1.

FIG. 2 shows the circuit configuration of the transmission circuit 7. The transmission circuit 7 processes a plurality of transmission signals, i.e., the transmission signal UMTS Tx and the transmission signal GSM Tx, as a plurality of high frequency signals. The transmission circuit 7 corresponds to the signal processing circuit of the present invention. The transmission circuit 7 has inputs 7a and 7b, and an output 7c. The input 7a is connected to the terminal 2a of the IC 2. The input 7b is connected to the terminal 2b of the IC 2. The output 7c is connected to the port 3a of the switch 3.

The transmission circuit 7 includes a switch 11, a balun 12, a BPF 13, and a balanced input power amplifier 14. The switch 11 has two input ports 11a and 11b and an output port 11c, and connects the output port 11c selectively to one of the input ports 11a and 11b. The balun 12 has an unbalanced input and two balanced outputs. The input port 11a of the switch 11 is connected to the input 7a of the transmission circuit 7 via the BPF 13. The input port 11b of the switch 11 is connected to the input 7b of the transmission circuit 7. The output port 11c of the switch 11 is connected to the unbalanced input of the balun 12.

The power amplifier 14 has two balanced inputs and an unbalanced output. The two balanced outputs of the balun 12 are connected to the two balanced inputs of the power amplifier 14. The unbalanced output of the power amplifier 14 is connected to the output 7c of the transmission circuit 7. The power amplifier 14 amplifies signals outputted from the balanced outputs of the balun 12. The high frequency electronic component 10 of the present embodiment is for use in the transmission circuit 7 shown in FIG. 2. The power amplifier 14 corresponds to the balanced input amplifier of the present invention.

For example, the switch 11 may be formed of an MMIC, or may be formed using a PIN diode. For example, the balun 12 may be formed of an LC circuit comprising an inductor and a capacitor, or may be formed using a resonator. The BPF 13 may be formed of a surface acoustic wave element, for example. The power amplifier 14 may be formed of an MMIC, for example.

As shown in FIG. 1, while no BPF is provided in the signal path of the transmission signal GSM Tx, the BPF 13 is provided in the signal path of the transmission signal UMTS Tx. The reason is as follows. For the TDMA system, the transmission signal and the reception signal are time-divided, whereas for the UMTS, the transmission signal and the reception signal are not time-divided. The UMTS therefore requires very high isolation between the transmission signal and the reception signal. To achieve the high isolation, a BPF is typically provided between an IC that outputs a UMTS transmission signal and a power amplifier that amplifies the UMTS transmission signal. For this reason, in the present embodiment, the BPF 13 is provided in the signal path of the transmission signal UMTS Tx between the IC 2 and the power amplifier 14. The LPF 8 provided in the signal path of the transmission signal GSM Tx between the port 3c of the switch 3 and the port 1c of the switch 1 is for suppressing a spurious signal generated at the power amplifier 14 and having a frequency which is an integral multiple of the frequency of the transmission signal.

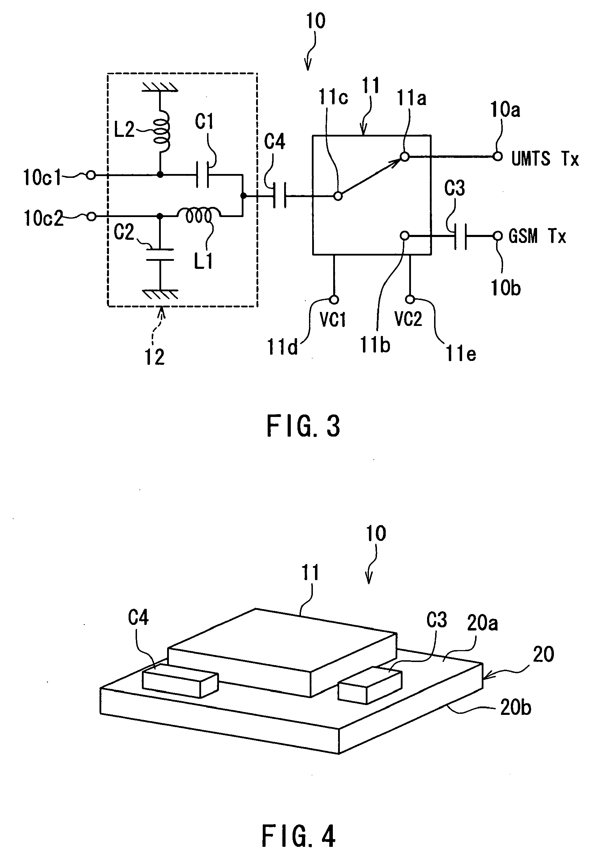

FIG. 3 is a schematic diagram illustrating the circuit configuration of the high frequency electronic component 10. The high frequency electronic component 10 has input terminals 10a and 10b, output terminals 10c1 and 10c2, and the switch 11 and the balun 12 described above. The input terminal 10a is connected to the output of the BPF 13 and the input port 11a of the switch 11. The input terminal 10b is connected to the input 7b of the transmission circuit 7. The output terminals 10c1 and 10c2 are connected to the two balanced outputs of the balun 12 and the two balanced inputs of the power amplifier 14. The switch 11 has control terminals 11d and 11e that receive control signals VC1 and VC2 for controlling the switch 11.

FIG. 3 shows an example in which the balun 12 is formed of an LC circuit comprising an inductor and a capacitor. In this example, the balun 12 has two inductors L1 and L2 and two capacitors C1 and C2. One end of the inductor L1 and one end of the capacitor C1 are connected to the unbalanced input of the balun 12. The other end of the inductor L1 is connected to one of the balanced outputs of the balun 12 connected to the output terminal 10c2, and is also connected to the ground through the capacitor C2. The other end of the capacitor C1 is connected to the other of the balanced outputs of the balun 12 connected to the output terminal 10c1, and is also connected to the ground through the inductor L2.

In the example shown in FIG. 3, the high frequency electronic component 10 includes a capacitor C3 provided in the signal path between the input port 11b of the switch 11 and the input terminal 10b, and a capacitor C4 provided in the signal path between the output port 11c of the switch 11 and the unbalanced input of the balun 12. These capacitors C3 and C4 are provided for preventing direct currents that result from the control signals VC1 and VC2 from flowing into the signal paths connected to the ports 11b and 11c. In the example shown in FIG. 3, no capacitor is provided in the signal path between the input port 11a of the switch 11 and the input terminal 10a. This is because the BPF 13 connected to the input terminal 10a has the function of blocking the passage of direct currents. In the case where direct currents resulting from the control signals VC1 and VC2 are generated from the input port 11a, a capacitor for blocking the passage of the direct currents may be provided in the signal path between the input port 11a of the switch 11 and the input terminal 10a if the BPF 13 does not have the function of blocking the passage of direct currents or if the BPF 13 has a low resistance to direct currents. In the case where there is no need to block the passage of direct currents resulting from the control signals VC1 and VC2 in the signal path connected to the port 11b or the signal path connected to the port 11c, it is not required to provide the capacitor C3 or C4. In each of the signal paths that are respectively connected to the ports 11a, 11b and 11c of the switch 11, a capacitor is provided if it is necessary to block the passage of direct currents resulting from the control signals VC1 and VC2 in the signal path. Whether it is necessary to provide a capacitor in the respective signal paths connected to the ports 11a, 11b and 11c of the switch 11 will be described in detail later. The capacitors C3 and C4 are omitted in FIG. 1 and FIG. 2.

The function of the high frequency circuit including the high frequency electronic component 10 of the present embodiment will now be described. The IC 2 generates and outputs the transmission signal UMTS Tx in the form of an unbalanced signal and the transmission signal GSM Tx in the form of an unbalanced signal. The transmission signal UMTS Tx passes through the BPF 13 of the transmission circuit 7 and is received at the input port 11a of the switch 11 of the high frequency electronic component 10. The transmission signal GSM Tx is received at the input port 11b of the switch 11. According to the state of the control signals VC1 and VC2 received at the control terminals 11d and 11e, the switch 11 performs switching between the transmission signal UMTS Tx in the form of an unbalanced signal received at the input port 11a and the transmission signal GSM Tx in the form of an unbalanced signal received at the input port 11b, and outputs one of the transmission signals from the output port 11c. The transmission signal UMTS Tx in the form of an unbalanced signal and transmission signal GSM Tx in the form of an unbalanced signal correspond to the plurality of high frequency signals each in the form of an unbalanced signal in the present invention. The balun 12 converts the transmission signal in the form of an unbalanced signal outputted from the output port 11c of the switch 11 to a transmission signal in the form of a balanced signal, and outputs this transmission signal in the form of a balanced signal to the balanced input power amplifier 14 for amplifying this signal. The transmission signal received at the power amplifier 14 is amplified by the power amplifier 14, and enters at the port 3a of the switch 3 as a transmission signal in the form of an unbalanced signal.

When transmitting the transmission signal UMTS Tx, the port 3a of the switch 3 is connected to the port 3b, and the port 1a of the switch 1 is connected to the port 1b. In this case, the transmission signal UMTS Tx passes in succession through the switch 3, the BPF 4b of the duplexer 4 and the switch 1 into the antenna 101, and is transmitted from the antenna 101.

When transmitting the transmission signal GSM Tx, the port 3a of the switch 3 is connected to the port 3c, and the port 1a of the switch 1 is connected to the port 1c. In this case, the transmission signal GSM Tx passes in succession through the switch 3, the LPF 8 and the switch 1 into the antenna 101, and is transmitted from the antenna 101.

In the high frequency circuit of FIG. 1, processing of the reception signal UMTS Rx is allowed when the port 1a of the switch 1 is connected to the port 1b. When in this state, the reception signal UMTS Rx received at the antenna 101 passes in succession through the switch 1, the BPF 4a of the duplexer 4 and the BPF 5, and enters the IC 2.

In the high frequency circuit of FIG. 1, processing of the reception signal GSM Rx is allowed when the port 1a of the switch 1 is connected to the port 1d. __When in this state, the reception signal GSM Rx received at the antenna 101 passes in succession through the switch 1 and the BPF 6, and enters the IC 2.

In the high frequency electronic component 10 of the present embodiment, the switch 11 performs switching between the transmission signal UMTS Tx in the form of an unbalanced signal received at the input port 11a and the transmission signal GSM Tx in the form of an unbalanced signal received at the input port 11b, and outputs one of the transmission signals from the output port 11c. The balun 12 converts the transmission signal in the form of an unbalanced signal outputted from the output port 11c of the switch 11 to a transmission signal in the form of a balanced signal, and outputs this transmission signal in the form of a balanced signal to the balanced input power amplifier 14 for amplifying this signal. The present embodiment thus allows the use of the balanced input power amplifier 14 in the transmission circuit 7 that processes the transmission signal GSM Tx and the transmission signal UMTS Tx. According to the present embodiment, it is possible to reduce the number of power amplifiers to be included in the transmission circuit 7, and consequently, it is possible to achieve reductions in size and cost of the transmission circuit 7.

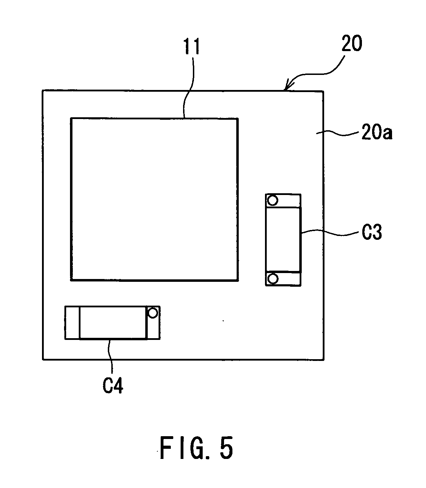

The structure of the high frequency electronic component 10 of the present embodiment will now be described. FIG. 4 is a perspective view showing the outer appearance of the high frequency electronic component 10. FIG. 5 is a top view of the high frequency electronic component 10. As shown in FIG. 4 and FIG. 5, the high frequency electronic component 10 includes a layered substrate 20 for integrating the components of the high frequency electronic component 10. As will be described in detail later, the layered substrate 20 includes a plurality of dielectric layers stacked. The layered substrate 20 is rectangular-solid-shaped, having a top surface 20a, a bottom surface 20b, and four side surfaces.

The circuits of the high frequency electronic component 10 are formed using conductor layers provided within the layered substrate 20, the dielectric layers mentioned above, and elements mounted on the top surface 20a of the layered substrate 20. Here, by way of example, the switch 11 and the capacitors C3 and C4 are mounted on the top surface 20a.

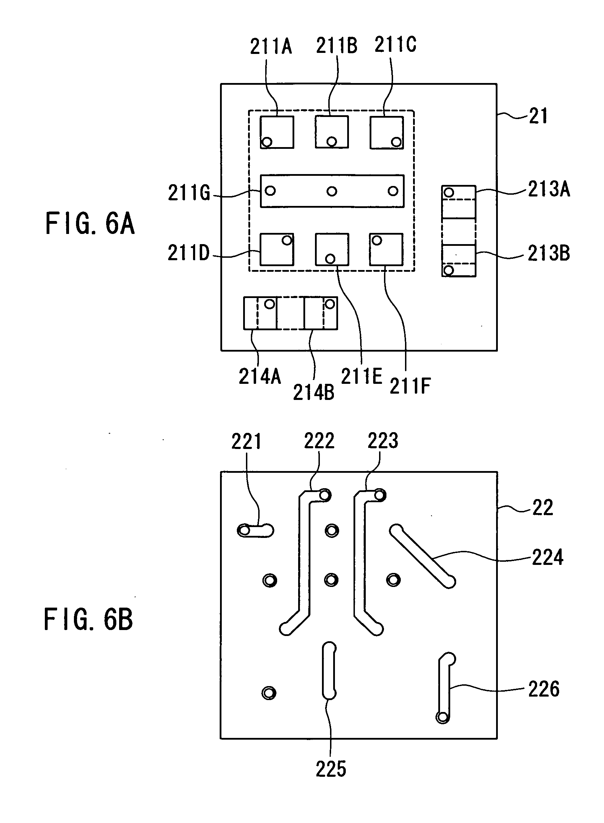

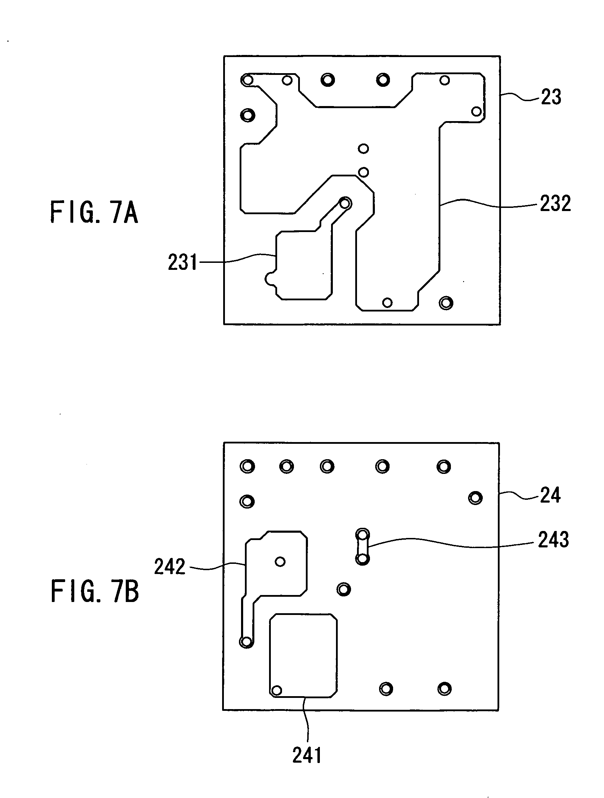

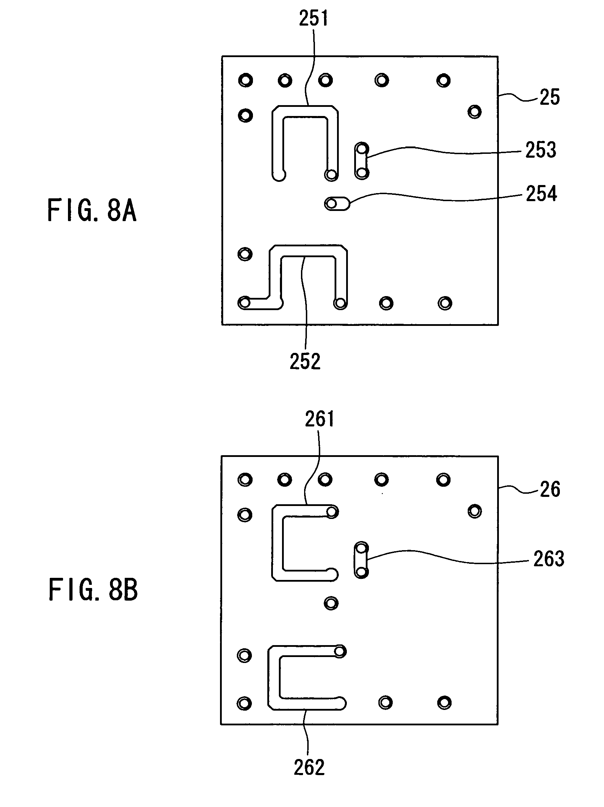

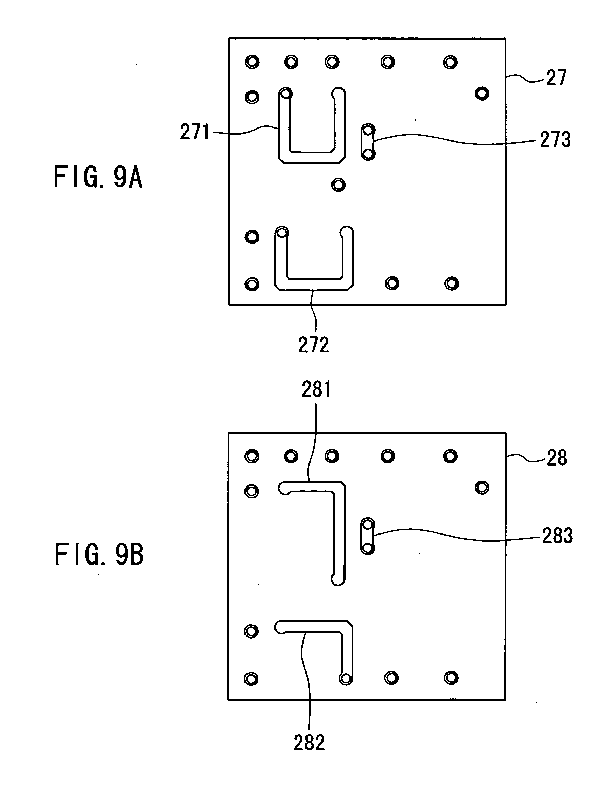

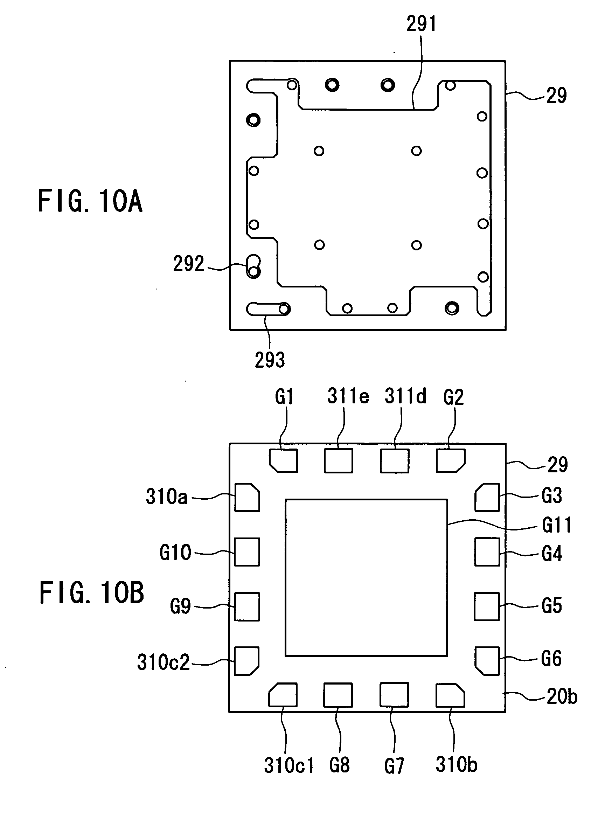

Reference is now made to FIG. 6A to FIG. 10B to describe the dielectric layers and the conductor layers of the layered substrate 20. FIG. 6A and FIG. 6B respectively show the top surfaces of the first and second dielectric layers from the top. FIG. 7A and FIG. 7B respectively show the top surfaces of the third and fourth dielectric layers from the top. FIG. 8A and FIG. 8B respectively show the top surfaces of the fifth and sixth dielectric layers from the top. FIG. 9A and FIG. 9B respectively show the top surfaces of the seventh and eighth dielectric layers from the top. FIG. 10A shows the top surface of the ninth dielectric layer from the top. FIG. 10B shows the ninth dielectric layer and a conductor layer therebelow as seen from above. In FIG. 6A to FIG. 10B, circles represent through holes.

On the top surface of the first dielectric layer 21 of FIG. 6A there are formed conductor layers 211A to 211G to which the switch 11 is connected, conductor layers 213A and 213B to which the capacitor C3 is connected, and conductor layers 214A and 214B to which the capacitor C4 is connected. The conductor layer 211A is connected to the port 11a of the switch 11. The conductor layer 211C is connected to the port 11b of the switch 11. The conductor layer 211E is connected to the port 11c of the switch 11. The conductor layer 211F is connected to the control terminal 11d of the switch 11. The conductor layer 211D is connected to the control terminal 11e of the switch 11. The conductor layers 211B and 211G are connected to the ground of the switch 11. The dielectric layer 21 has a plurality of through holes connected to the above-mentioned conductor layers.

Conductor layers 221, 222, 223, 224, 225 and 226 are formed on the top surface of the second dielectric layer 22 of FIG. 6B. The conductor layer 211A is connected to the conductor layer 221 via a through hole formed in the dielectric layer 21. The conductor layer 211D is connected to the conductor layer 222 via a through hole formed in the dielectric layer 21. The conductor layer 211F is connected to the conductor layer 223 via a through hole formed in the dielectric layer 21. The conductor layers 211C and 213A are connected to the conductor layer 224 via through holes formed in the dielectric layer 21. The conductor layers 211E and 214B are connected to the conductor layer 225 via through holes formed in the dielectric layer 21. The conductor layer 213B is connected to the conductor layer 226 via a through hole formed in the dielectric layer 21. The dielectric layer 22 has through holes connected to the conductor layers 221, 222, 223 and 226, and other through holes.

A capacitor-forming conductor layer 231 and a grounding conductor layer 232 are formed on the top surface of the third dielectric layer 23 of FIG. 7A. The conductor layer 214A is connected to the conductor layer 231 via through holes formed in the dielectric layers 21 and 22. The conductor layers 211B and 211G are connected to the conductor layer 232 via through holes formed in the dielectric layers 21 and 22. The dielectric layer 23 has through holes connected to the conductor layers 231 and 232, and other through holes.

Capacitor-forming conductor layers 241 and 242 and a conductor layer 243 are formed on the top surface of the fourth dielectric layer 24 of FIG. 7B. The conductor layers 231 and 241 and the dielectric layer 23 located therebetween constitute the capacitor C1 of FIG. 3. The conductor layers 232 and 242 and the dielectric layer 23 located therebetween constitute the capacitor C2 of FIG. 3. The conductor layer 232 is connected to the conductor layer 243 via two through holes formed in the dielectric layer 23. The dielectric layer 24 has through holes connected to the conductor layers 241, 242 and 243, and other through holes.

Inductor-forming conductor layers 251 and 252 and conductor layers 253 and 254 are formed on the top surface of the fifth dielectric layer 25 of FIG. 8A. The conductor layer 242 is connected to the conductor layer 251 via through holes formed in the dielectric layer 24. The conductor layer 241 is connected to the conductor layer 252 via a through hole formed in the dielectric layer 24. The conductor layer 243 is connected to the conductor layer 253 via two through holes formed in the dielectric layer 24. The conductor layer 231 is connected to the conductor layer 254 via through holes formed in the dielectric layers 23 and 24. The dielectric layer 25 has through holes connected to the conductor layers 251, 252, 253 and 254, and other through holes.

Inductor-forming conductor layers 261 and 262 and a conductor layer 263 are formed on the top surface of the sixth dielectric layer 26 of FIG. 8B. The conductor layer 251 is connected to the conductor layer 261 via a through hole formed in the dielectric layer 25. The conductor layer 252 is connected to the conductor layer 262 via through holes formed in the dielectric layer 25. The conductor layer 253 is connected to the conductor layer 263 via two through holes formed in the dielectric layer 25. The dielectric layer 26 has through holes connected to the conductor layers 261, 262 and 263, and other through holes.

Inductor-forming conductor layers 271 and 272 and a conductor layer 273 are formed on the top surface of the seventh dielectric layer 27 of FIG. 9A. The conductor layer 261 is connected to the conductor layer 271 via a through hole formed in the dielectric layer 26. The conductor layer 262 is connected to the conductor layer 272 via a through hole formed in the dielectric layer 26. The conductor layer 263 is connected to the conductor layer 273 via two through holes formed in the dielectric layer 26. The dielectric layer 27 has through holes connected to the conductor layers 271, 272 and 273, and other through holes.

Inductor-forming conductor layers 281 and 282 and a conductor layer 283 are formed on the top surface of the eighth dielectric layer 28 of FIG. 9B. The conductor layer 271 is connected to the conductor layer 281 via a through hole formed in the dielectric layer 27. The conductor layer 231 is connected to the conductor layer 281 via through holes formed in the dielectric layers 23 to 27 and the conductor layer 254. The conductor layer 272 is connected to the conductor layer 282 via a through hole formed in the dielectric layer 27. The conductor layer 273 is connected to the conductor layer 283 via two through holes formed in the dielectric layer 27. The dielectric layer 28 has through holes connected to the conductor layers 282 and 283, and other through holes.

The inductor L1 of FIG. 3 is composed of the conductor layers 251, 261, 271 and 281 and the through holes connecting these conductor layers in series. The inductor L2 of FIG. 3 is composed of the conductor layers 252, 262, 272 and 282 and the through holes connecting these conductor layers in series.

A grounding conductor layer 291 and conductor layers 292 and 293 are formed on the top surface of the ninth dielectric layer 29 of FIG. 10A. The conductor layers 282 and 283 are connected to the conductor layer 291 via through holes formed in the dielectric layer 28. The conductor layer 232 is also connected to the conductor layer 291 via through holes formed in the dielectric layers 23 to 28. The conductor layer 242 is connected to the conductor layer 292 via through holes formed in the dielectric layers 24 to 28. The conductor layer 252 is connected to the conductor layer 293 via through holes formed in the dielectric layers 25 to 28. The dielectric layer 29 has through holes connected to the conductor layer 291, 292 and 293, and other through holes.

As shown in FIG. 10B, on the lower surface of the dielectric layer 29, that is, on the bottom surface 20b of the layered substrate 20, there are formed conductor layers 310a and 310b that form the input terminals 10a and 10b, conductor layers 310c1 and 310c2 that form the output terminals 10c1 and 10c2, conductor layers 311d and 311e that form the control terminals 11d and 11e, and conductor layers G1 to G11 that form ground terminals.

The conductor layer 211A is connected to the conductor layer 310a via through holes formed in the dielectric layers 21 to 29 and the conductor layer 221. The conductor layer 213B is connected to the conductor layer 310b via through holes formed in the dielectric layers 21 to 29 and the conductor layer 226. The conductor layer 252 is connected to the conductor layer 310c1 via through holes formed in the dielectric layers 25 to 29 and the conductor layer 293. The conductor layer 242 is connected to the conductor layer 310c2 via through holes formed in the dielectric layers 24 to 29 and the conductor layer 292. The conductor layer 211F is connected to the conductor layer 311d via through holes formed in the dielectric layers 21 to 29 and the conductor layer 223. The conductor layer 211D is connected to the conductor layer 311e via through holes formed in the dielectric layers 21 to 29 and the conductor layer 222. The conductor layer 291 is connected to the conductor layers G1 to G11 via through holes formed in the dielectric layer 29. The conductor layers G1 to G11 are configured to be connected to the ground.

The first to ninth dielectric layers 21 to 29 and the conductor layers described above are stacked to form the layered substrate 20 of FIG. 4. The switch 11 and the capacitors C3 and C4 are mounted on the top surface 20a of the layered substrate 20. The balun 12 is formed using, among the above-described conductor layers, a plurality of ones provided within the layered substrate 20. In the present embodiment, a variety of types of substrates are employable as the layered substrate 20, such as one in which the dielectric layers are formed of a resin, ceramic, or a resin-ceramic composite material. However, a low-temperature co-fired ceramic multilayer substrate, which is excellent in high frequency response, is particularly preferable as the layered substrate 20.

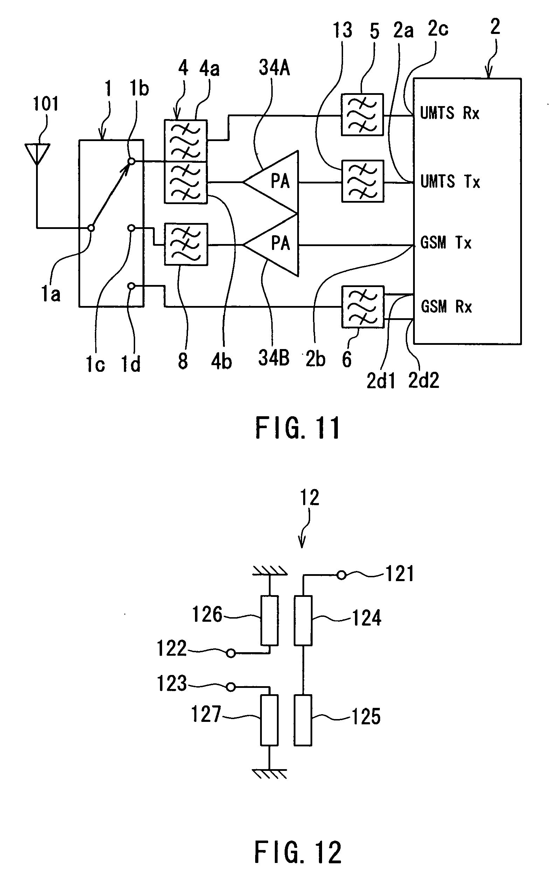

The advantages of the present embodiment will now be described with reference to a comparative example. FIG. 11 is a block diagram illustrating the circuit configuration of a high frequency circuit of the comparative example. The high frequency circuit of the comparative example does not have the switches 3 and 11 and the balun 12 provided in the high frequency circuit shown in FIG. 1, but has two power amplifiers 34A and 34B instead of the power amplifier 14 provided in the high frequency circuit shown in FIG. 1. Each of the power amplifiers 34A and 34B is of the unbalanced input type. In the high frequency circuit of the comparative example, the transmission signal UMTS Tx outputted from the BPF 13 is amplified by the power amplifier 34A, and then enters the BPF 4b of the duplexer 4. The transmission signal GSM Tx outputted from the IC 2 is amplified by the power amplifier 34B, passes through the LPF 8, and enters at the port 1c of the switch 1. In the high frequency circuit of the comparative example, the BPF 13 and the power amplifiers 34A and 34B constitute the transmission circuit. The remainder of configuration of the high frequency circuit of the comparative example is the same as that of the high frequency circuit shown in FIG. 1.

The comparative example shown in FIG. 11 is unable to use a balanced input power amplifier that has been proposed in many publications as a power amplifier for use in a cellular phone, and requires two power amplifiers, each of which is relatively expensive. This impedes reductions in size and cost of the transmission circuit and the high frequency circuit of a cellular phone including the transmission circuit. In contrast, according to the present embodiment, a single power amplifier 14 is used in common for both the transmission signal UMTS Tx and the transmission signal GSM Tx. Compared with the comparative example, the present embodiment thus allows a reduction in the number of power amplifiers to be included in the transmission circuit 7 by one, and thereby allows reductions in size and cost of the transmission circuit 7 and the high frequency circuit of a cellular phone including the transmission circuit 7. Furthermore, according to the present embodiment, the balun 12 converts the transmission signal in the form of an unbalanced signal outputted from the output port 11c of the switch 11 to a transmission signal in the form of a balanced signal, and outputs this signal to the power amplifier 14. The present embodiment thus allows the use of the balanced input power amplifier 14 that has been proposed in many publications as a power amplifier for use in a cellular phone. According to the present embodiment, while the number of power amplifiers is reduced by one compared with the comparative example, two additional switches 3 and 11 are required. However, since a switch is less expensive than a power amplifier, the present embodiment allows a cost reduction compared with the comparative example.

By forming a single high frequency electronic component 10 including the switch 11 and the balun 12 as in the present embodiment, it is possible to reduce the area occupied by the switch 11 and the balun 12 in the transmission circuit 7, compared with the case of forming the switch 11 and the balun 12 as discrete elements and mounting them on a substrate. In this respect also, the present embodiment allows miniaturization of the transmission circuit 7 and the high frequency circuit of a cellular phone including the transmission circuit 7.

The high frequency electronic component 10 of the present embodiment includes the layered substrate 20, the balun 12 is formed using a plurality of conductor layers provided within the layered substrate 20, and the switch 11 is mounted on the layered substrate 20. The balun 12 is easily formable using a plurality of conductor layers provided within the layered substrate 20 as shown in FIG. 6A to FIG. 10B. By forming the balun 12 using a plurality of conductor layers provided within the layered substrate 20 and mounting the switch 11 on the layered substrate 20 as in the present embodiment, it is possible to reduce the area occupied by the high frequency electronic component 10 in the transmission circuit 7, in particular. The present embodiment thus allows further miniaturization of the transmission circuit 7 and the high frequency circuit of a cellular phone including the transmission circuit 7.

Detailed descriptions will now be made concerning the structure of the switch 11 of the high frequency electronic component 10 of the present embodiment and concerning whether a capacitor is needed in the signal paths connected to the switch 11. First, as the switch 11 it is possible to use a switch formed of an MMIC, or a switch formed using a PIN diode. Examples of the switch formed of an MMIC include one that uses a depletion mode field-effect transistor (FET) and one that uses an enhancement mode FET. In the depletion mode FET, a drain current flows even when the gate voltage is zero. In the enhancement mode FET, no drain current flows when the gate voltage is zero. Examples of the depletion mode FET include a GaAs-base pseudomorphic high electron mobility transistor (pHEMT). Examples of the enhancement mode FET include a complementary metal oxide semiconductor (CMOS).

In the case where a switch formed of an MMIC using a depletion mode FET or a switch formed using a PIN diode is used as the switch 11, it is in principle necessary to provide a capacitor for blocking the passage of direct currents in the signal paths connected to the respective ports of the switch 11. However, if any element connected to any of those signal paths has the function of blocking the passage of direct currents and has a high resistance to direct currents, it is not necessary to provide a capacitor for blocking the passage of direct currents in the signal path.

In the case where a switch formed of an MMIC using an enhancement mode FET is used as the switch 11, it is not necessary to provide a capacitor for blocking the passage of direct currents in any of the signal paths connected to the respective ports of the switch 11.

Reference is now made to FIG. 12 to describe another possible configuration of the balun 12. The balun 12 shown in FIG. 12 is formed using resonators. This balun 12 has an unbalanced input 121, two balanced outputs 122 and 123, and four quarter-wave resonators 124, 125, 126 and 127. One end of the quarter-wave resonator 124 is connected to the unbalanced input 121, and the other end of the quarter-wave resonator 124 is connected to one end of the quarter-wave resonator 125. One end of the quarter-wave resonator 126 is connected to the balanced output 122, and the other end of the quarter-wave resonator 126 is connected to the ground. One end of the quarter-wave resonator 127 is connected to the balanced output 123, and the other end of the quarter-wave resonator 127 is connected to the ground. The quarter-wave resonator 126 is coupled to the quarter-wave resonator 124, and the quarter-wave resonator 127 is coupled to the quarter-wave resonator 125.

The balun 12 formed of the LC circuit shown in FIG. 3 is small in insertion loss, but narrow in frequency band in which a good amplitude balance characteristic is obtained. On the other hand, the balun 12 formed using the resonators shown in FIG. 12 is slightly greater in insertion loss, but broad in frequency band in which a good amplitude balance characteristic is obtained. The balun 12 formed using the resonators shown in FIG. 12 blocks the passage of direct currents between the unbalanced input 121 and each of the balanced outputs 122 and 123. Therefore, if the balun 12 of FIG. 12 is used, it is unnecessary to provide a capacitor for blocking the passage of direct currents in the signal paths between the switch 11 and the balun 12 even in the case where the switch 11 is of the type which in principle requires a capacitor for blocking the passage of direct currents in the signal paths connected to the respective ports of the switch 11.

The balun 12 of FIG. 12 can be formed using a plurality of conductor layers provided within the layered substrate 20, like the balun 12 of FIG. 3.

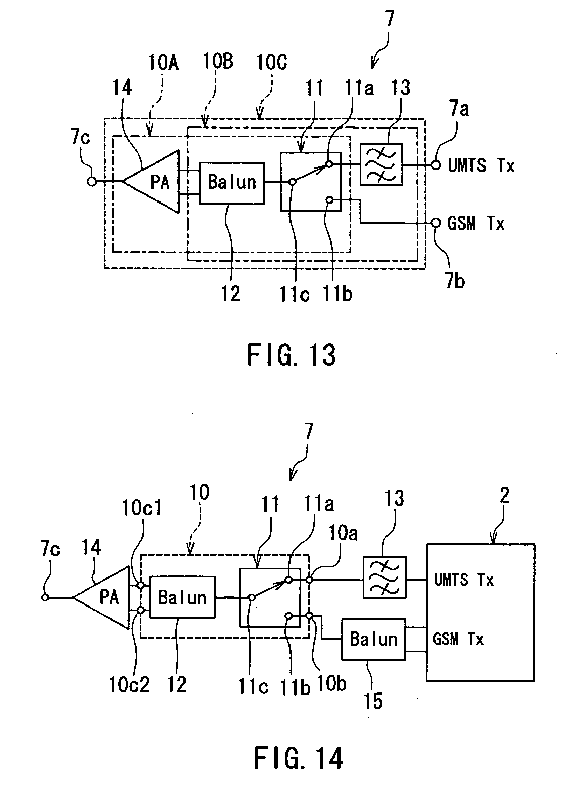

Reference is now made to FIG. 13 to describe first to third modification examples of the high frequency electronic component of the present embodiment. FIG. 13 shows a portion of the transmission circuit 7 included in the high frequency electronic component of each modification example. The high frequency electronic component 10A of the first modification example includes the power amplifier 14 in addition to the switch 11 and the balun 12. In this high frequency electronic component 10A, the power amplifier 14 may be mounted on the top surface 20a of the layered substrate 20. The inputs of the power amplifier 14 are connected to the balanced outputs of the balun 12, and the output of the power amplifier 14 is connected to the output of the high frequency electronic component 10A. The power amplifier 14 is thus provided between the output of the high frequency electronic component 10A and the balanced outputs of the balun 12.

The high frequency electronic component 10B of the second modification example includes the BPF 13 in addition to the switch 11 and the balun 12. In this high frequency electronic component 10B, the BPF 13 may be mounted on the top surface 20a of the layered substrate 20. The input of the BPF 13 is connected to an input terminal of the high frequency electronic component 10B at which the transmission signal UMTS Tx is received. The output of the BPF 13 is connected to the input port 11a of the switch 11. The BPF 13 is thus provided between the input port 11a and the input terminal of the high frequency electronic component 10B at which the transmission signal UMTS Tx is received.

The high frequency electronic component 10C of the third modification example includes the power amplifier 14 and the BPF 13 in addition to the switch 11 and the balun 12. In this high frequency electronic component 10C, the power amplifier 14 and the BPF 13 may be mounted on the top surface 20a of the layered substrate 20. The inputs of the power amplifier 14 are connected to the balanced outputs of the balun 12, and the output of the power amplifier 14 is connected to the output of the high frequency electronic component 10C. The input of the BPF 13 is connected to an input terminal of the high frequency electronic component 10C at which the transmission signal UMTS Tx is received, and the output of the BPF 13 is connected to the input port 11a of the switch 11.

### [Second Embodiment]

A high frequency electronic component of a second embodiment of the invention will now be described with reference to FIG. 14. FIG. 14 shows a transmission circuit 7 including the high frequency electronic component 10 of the second embodiment. In the second embodiment, the IC 2 generates and outputs a transmission signal GSM Tx in the form of a balanced signal, not in the form of an unbalanced signal. The transmission circuit 7 of the second embodiment includes a balun 15, in addition to the components of the transmission circuit 7 of the first embodiment. The balun 15 has two balanced inputs and an unbalanced output. The two balanced inputs of the balun 15 are connected to terminals of the IC2 that output the transmission signal GSM Tx in the form of a balanced signal. The unbalanced output of the balun 15 is connected to the input terminal 10b of the high frequency electronic component 10. The balun 15 converts the transmission signal GSM Tx in the form of a balanced signal to a transmission signal GSM Tx in the form of an unbalanced signal and outputs this signal. The circuit configuration of the balun 15 is the same as that of the balun 12 except that the two balanced outputs of the balun 12 are replaced with the two balanced inputs, and the unbalanced input of the balun 12 is replaced with the unbalanced output.

The high frequency electronic component 10 of the second embodiment is for use in the transmission circuit 7 that processes the transmission signal GSM Tx in the form of a balanced signal and the transmission signal UMTS Tx in the form of an unbalanced signal. The configuration of the high frequency electronic component 10 of the second embodiment is the same as that of the high frequency electronic component 10 of the first embodiment.

In the second embodiment, the transmission signal UMTS Tx in the form of an unbalanced signal outputted from the IC 2 passes through the BPF 13, and is received at the input port 11a of the switch 11 of the high frequency electronic component 10. The transmission signal GSM Tx in the form of a balanced signal outputted from the IC 2 is converted by the balun 15 to the transmission signal GSM Tx in the form of an unbalanced signal, and this transmission signal GSM Tx in the form of an unbalanced signal is received at the input port 11b of the switch 11.

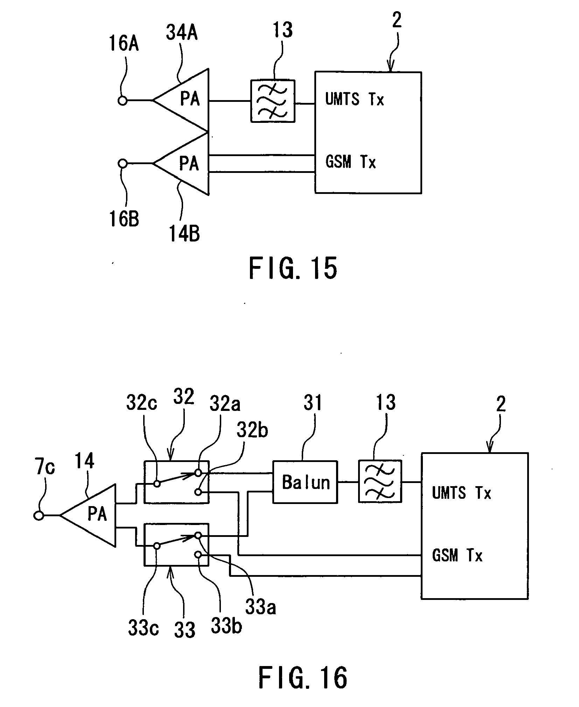

The advantages of the second embodiment will now be described with reference to a first to a third comparative example. FIG. 15 is a block diagram illustrating the circuit configuration of a transmission circuit of the first comparative example. The transmission circuit of the first comparative example has two power amplifiers 34A and 14B and two outputs 16A and 16B, instead of the balun 15, the switch 11, the balun 12, the power amplifier 14 and the output 7c of the transmission circuit shown in FIG. 14. In the transmission circuit of the first comparative example, the transmission signal UMTS Tx in the form of an unbalanced signal outputted from the BPF 13 is amplified by the power amplifier 34A, and is outputted from the output 16A. The transmission signal GSM Tx in the form of a balanced signal outputted from the IC 2 is amplified by the power amplifier 14B, and is outputted from the output 16B as a transmission signal GSM Tx in the form of an unbalanced signal. The transmission signal UMTS Tx outputted from the output 16A enters the BPF 4b of the duplexer 4 of FIG. 11. The transmission signal GSM Tx outputted from the output 16B is received at the port 1c of the switch 1 of FIG. 11.

The first comparative example shown in FIG. 15 requires two power amplifiers, each of which is relatively expensive. This impedes reductions in size and cost of the transmission circuit and the high frequency circuit of a cellular phone including the transmission circuit. In contrast, according to the second embodiment, a single power amplifier 14 is used in common for both the transmission signal UMTS Tx and the transmission signal GSM Tx. Compared with the first comparative example, the second embodiment thus allows a reduction in the number of power amplifiers to be included in the transmission circuit 7 by one, and thereby allows reductions in size and cost of the transmission circuit 7 and the high frequency circuit of a cellular phone including the transmission circuit 7.

FIG. 16 is a block diagram illustrating the circuit configuration of a transmission circuit of the second comparative example. The transmission circuit of the second comparative example has a balun 31 and two switches 32 and 33, instead of the balun 15, the switch 11 and the balun 12 of the transmission circuit shown in FIG. 14. The balun 31 has an unbalanced input and two balanced outputs. The unbalanced input of the balun 31 is connected to the output of the BPF 13. The switch 32 has two input ports 32a and 32b and an output port 32c, and connects the output port 32c selectively to one of the input ports 32a and 32b. The switch 33 has two input ports 33a and 33b and an output port 33c, and connects the output port 33c selectively to one of the input ports 33a and 33b. The input port 32a and the input port 33a are connected to the balanced outputs of the balun 31. The input port 32b and the input port 33b receive the transmission signal GSM Tx in the form of a balanced signal outputted from the IC 2. The output port 32c and the output port 33c are connected to the balanced inputs of the power amplifier 14.

The transmission circuit of the second comparative example shown in FIG. 16 requires two switches. According to the second embodiment, compared with the second comparative example, the number of the switches decreases by one, while the number of the baluns increases by one. Compared with a switch, a balun can be formed at a lower cost and in a smaller size. The second embodiment therefore allows reductions in size and cost of the transmission circuit 7 and the high frequency circuit of a cellular phone including the transmission circuit 7, compared with the second comparative example.

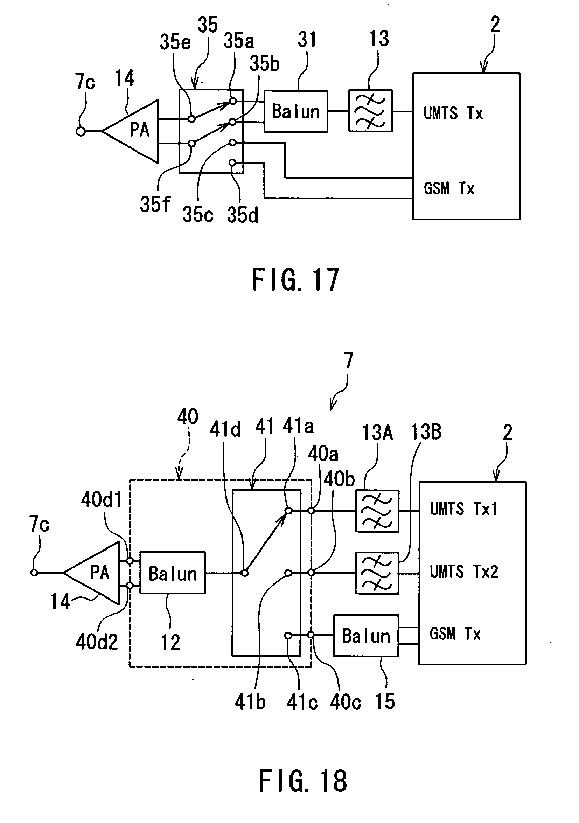

FIG. 17 is a block diagram illustrating the circuit configuration of a transmission circuit of the third comparative example. The transmission circuit of the third comparative example has a switch 35 for switching between balanced signals, instead of the switches 32 and 33 of the second comparative example shown in FIG 16. The switch 35 has four input ports 35a, 35b, 35c and 35d, and two output ports 35e and 35f. The switch 35 is capable of switching between a state in which the output port 35e is connected to the input port 35a while the output port 35f is connected to the input port 35b and a state in which the output port 35e is connected to the input port 35c while the output port 35f is connected to the input port 35d. The input ports 35a and 35b are connected to the balanced outputs of the balun 31. The input ports 35c and 35d receive the transmission signal GSM Tx in the form of a balanced signal outputted from the IC 2. The output ports 35e and 35f are connected to the balanced inputs of the power amplifier 14.

The transmission circuit of the third comparative example shown in FIG. 17 requires the switch 35 for switching between balanced signals. A switch for switching between balanced signals is more expensive than a switch for switching between unbalanced signals. Compared with the third comparative example, the second embodiment increases the number of the baluns by one. However, the second embodiment allows the use of the switch 11 for switching between unbalanced signals, which is inexpensive, and does not use the expensive switch 35 for switching between balanced signals. Furthermore, a balun can be formed at a lower cost. The second embodiment therefore allows reductions in size and cost of the transmission circuit 7 and the high frequency circuit of a cellular phone including the transmission circuit 7, compared with the third comparative example.

The high frequency electronic component of the second embodiment may include at least one of the power amplifier 14 and the BPF 13 in addition to the switch 11 and the balun 12, like the first to third modification examples of the first embodiment. The high frequency electronic component of the second embodiment may include the balun 15. In this case, the balun 15 corresponds to the second balun of the present invention. In the case where the high frequency electronic component includes the balun 15, the balun 15 can be formed using a plurality of conductor layers provided within the layered substrate 20, like the balun 12. The remainder of configuration, functions and advantages of the second embodiment are similar to those of the first embodiment.

### [Third Embodiment]

A high frequency electronic component of a third embodiment of the invention will now be described with reference to FIG. 18. FIG. 18 shows a transmission circuit 7 including the high frequency electronic component 40 of the third embodiment. The high frequency electronic component 40 of the third embodiment is for use in the transmission circuit 7 that processes two UMTS transmission signals UMTS Tx1 and UMTS Tx2 and a GSM transmission signal GSM Tx. In the third embodiment, in the case where the transmission signal GSM Tx is a transmission signal of at least one of GSM850 (AGSM) and GSM900 (EGSM), the transmission signals UMTS Tx1 and UMTS Tx2 are transmission signals of two different bands among the bands V, VI and VIII whose frequency bands are close to those of GSM850 (AGSM) and GSM900 (ESGM). In the case where the transmission signal GSM Tx is a transmission signal of at least one of GSM1800 (DCS) and GSM1900 (PCS), the transmission signals UMTS Tx1 and UMTS Tx2 are transmission signals of two different bands among the bands I, II, III, IV, IX and X whose frequency bands are close to those of GSM1800 (DCS) and GSM1900 (PCS). In the high frequency circuit including the transmission circuit 7 of the third embodiment, the IC 2 generates and outputs UMTS transmission signals UMTS Tx1 and UMTS Tx2 each in the form of an unbalanced signal and a GSM transmission signal GSM Tx in the form of a balanced signal.

The transmission circuit 7 of the third embodiment includes two BPFs 13A and 13B instead of the BPF 13 of the second embodiment, and includes the high frequency electronic component 40 instead of the high frequency electronic component 10 of the second embodiment. The transmission signals UMTS Tx1 and UMTS Tx2 outputted from the IC 2 enter the BPFs 13A and 13B, respectively.

The high frequency electronic component 40 has input terminals 40a, 40b and 40c, output terminals 40d1 and 40d2, a switch 41, the balun 12. The switch 41 has three input ports 41a, 41b and 41c and an output port 41d, and connects the output port 41d selectively to one of the input ports 41a, 41b and 41c.

The input terminal 40a is connected to the output of the BPF 13A and the input port 41a of the switch 41. The input terminal 40b is connected to the output of the BPF 13B and the input port 41b of the switch 41. The input terminal 40c is connected to the unbalanced output of the balun 15 and the input port 41c of the switch 41. The unbalanced input of the balun 12 is connected to the output port 41d of the switch 41. The output terminals 40d1 and 40d2 are connected to the balanced outputs of the balun 12 and the balanced inputs of the power amplifier 14.

In the transmission circuit 7 including the high frequency electronic component 40, the transmission signal UMTS Tx1 in the form of an unbalanced signal outputted from the IC 2 passes through the BPF 13A and the input terminal 40a, and is received at the input port 41a of the switch 41. The transmission signal UMTS Tx2 in the form of an unbalanced signal outputted from the IC 2 passes through the BPF 13B and the input terminal 40b, and is received at the input port 41b of the switch 41. The transmission signal GSM Tx in the form of a balanced signal outputted from the IC 2 is converted by the balun 15 to a transmission signal GSM Tx in the form of an unbalanced signal. This transmission signal GSM Tx in the form of an unbalanced signal passes through the input terminal 40c and is received at the input port 41c of the switch 41. The switch 41 performs switching among the transmission signal UMTS Tx1 in the form of an unbalanced signal received at the input port 41a, the transmission signal UMTS Tx2 in the form of an unbalanced signal received at the input port 41b and the transmission signal GSM Tx in the form of an unbalanced signal received at the input port 41c, and outputs one of the transmission signals from the output port 41d to the balun 12. The transmission signal UMTS Tx1 in the form of an unbalanced signal, the transmission signal UMTS Tx2 in the form of an unbalanced signal and the transmission signal GSM Tx in the form of an unbalanced signal correspond to the plurality of high frequency signals each in the form of an unbalanced signal in the present invention. The balun 12 converts the transmission signal in the form of an unbalanced signal outputted from the output port 41d of the switch 41 to a transmission signal in the form of a balanced signal, and outputs this transmission signal in the form of a balanced signal to the balanced input power amplifier 14 for amplifying this. The transmission signal received at the power amplifier 14 is amplified by the power amplifier 14, and is outputted to the output 7c of the transmission circuit 7 as a transmission signal in the form of an unbalanced signal. In the third embodiment, the output 7c is connected to an input port of a switch (not shown) having the input port and three output ports. This switch selectively connects one of the three output ports to the input port, and outputs the transmission signals UMTS Tx1, UMTS Tx2 and GSM Tx received at the input port from different ones of the output ports.

Like the high frequency electronic component 10 of the first embodiment, the high frequency electronic component 40 of the third embodiment can be constructed by forming the balun 12 using a plurality of conductor layers provided within the layered substrate 20 and by mounting the switch 41 on the layered substrate 20.

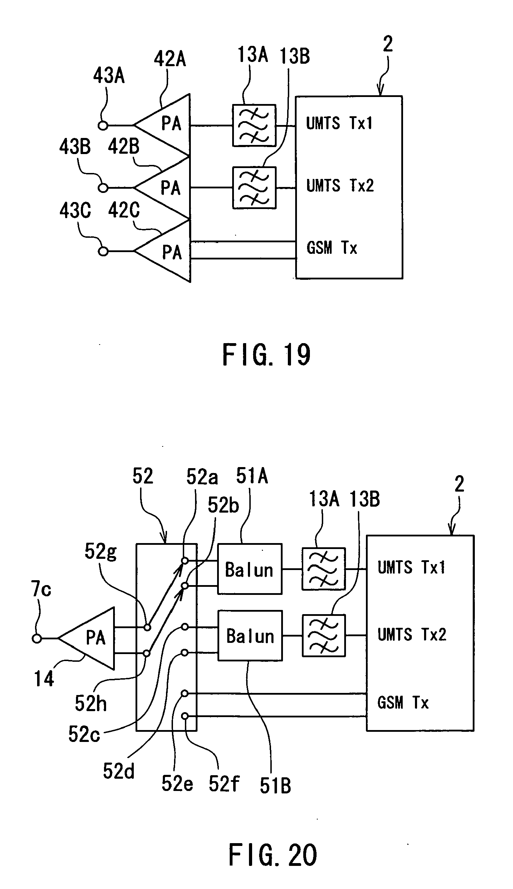

The advantages of the third embodiment will now be described with reference to a first to a third comparative example. FIG. 19 is a block diagram illustrating the circuit configuration of a transmission circuit of the first comparative example. The transmission circuit of the first comparative example has three power amplifiers 42A, 42B and 42C and three outputs 43A, 43B and 43C, instead of the balun 15, the switch 41, the balun 12, the power amplifier 14 and the output 7c of the transmission circuit shown in FIG. 18. In the transmission circuit of the first comparative example, the transmission signal UMTS Tx1 in the form of an unbalanced signal outputted from the BPF 13A is amplified by the power amplifier 42A, and is outputted from the output 43A. The transmission signal UMTS Tx2 in the form of an unbalanced signal outputted from the BPF 13B is amplified by the power amplifier 42B, and is outputted from the output 43B. The transmission signal GSM Tx in the form of a balanced signal outputted from the IC 2 is amplified by the power amplifier 42C, and is outputted from the output 43C as a transmission signal GSM Tx in the form of an unbalanced signal.

The first comparative example shown in FIG. 19 requires three power amplifiers, each of which is relatively expensive. This impedes reductions in size and cost of the transmission circuit and the high frequency circuit of a cellular phone including the transmission circuit. In contrast, according to the third embodiment, a single power amplifier 14 is used in common for the three transmission signals UMTS Tx1, UMTS Tx2 and GSM Tx. Compared with the first comparative example, the third embodiment thus allows a reduction in the number of power amplifiers to be included in the transmission circuit 7 by two, and thereby allows reductions in size and cost of the transmission circuit 7 and the high frequency circuit of a cellular phone including the transmission circuit 7.

FIG. 20 is a block diagram illustrating the circuit configuration of a transmission circuit of the second comparative example. The transmission circuit of the second comparative example has two baluns 51A and 51B and a switch 52, instead of the balun 15, the switch 41 and the balun 12 of the transmission circuit shown in FIG. 18. Each of the baluns 51A and 51B has an unbalanced input and two balanced outputs. The switch 52 has six input ports 52a, 52b, 52c, 52d, 52e and 52f, and two output ports 52g and 52h. The switch 52 is capable of switching among a state in which the output port 52g is connected to the input port 52a while the output port 52h is connected to the input port 52b, a state in which the output port 52g is connected to the input port 52c while the output port 52h is connected to the input port 52d, and a state in which the output port 52g is connected to the input port 52e while the output port 52h is connected to the input port 52f.

The unbalanced input of the balun 51A is connected to the output of the BPF 13A. The unbalanced input of the balun 51B is connected to the output of the BPF 13B. The two balanced outputs of the balun 51A are connected to the input ports 52a and 52b of the switch 52. The two balanced outputs of the balun 51B are connected to the input ports 52c and 52d of the switch 52. The input ports 52e and 52f of the switch 52 receive the transmission signal GSM Tx in the form of a balanced signal outputted from the IC 2. The output ports 52g and 52h of the switch 52 are connected to the balanced inputs of the power amplifier 14.

The second comparative example shown in FIG. 20 requires the switch 52 for switching between balanced signals, which is expensive. The third embodiment allows the use of the switch 41 for switching between unbalanced signals, which is inexpensive, and does not use the expensive switch 52 for switching between balanced signals. The third embodiment therefore allows reductions in size and cost of the transmission circuit 7 and the high frequency circuit of a cellular phone including the transmission circuit 7, compared with the second comparative example.

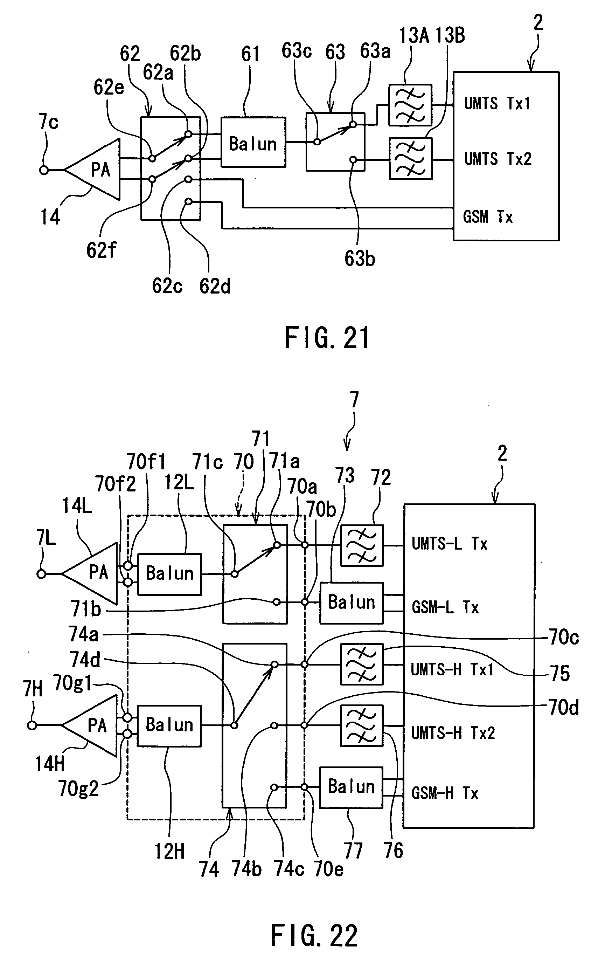

FIG. 21 is a block diagram illustrating the circuit configuration of a transmission circuit of the third comparative example. The transmission circuit of the third comparative example has a switch 63, a balun 61 and a switch 62, instead of the balun 15, the switch 41 and the balun 12 of the transmission circuit shown in FIG. 18. The switch 63 has an input port 63a connected to the output of the BPF 13A, an input port 63b connected to the output of the BPF 13B, and an output 63c, and connects the output port 63c selectively to one of the input ports 63a and 63b. The balun 61 has an unbalanced input and two balanced outputs. The unbalanced input of the balun 61 is connected to the output port 63c of the switch 63.

The switch 62 has four input ports 62a, 62b, 62c and 62d, and two output ports 62e and 62f. The switch 62 is capable of switching between a state in which the output port 62e is connected to the input port 62a while the output port 62f is connected to the input port 62b and a state in which the output port 62e is connected to the input port 62c while the output port 62f is connected to the input port 62d. The two balanced outputs of the balun 61 are connected to the input ports 62a and 62b of the switch 62. The input ports 62c and 62d of the switch 62 receive the transmission signal GSM Tx in the form of a balanced signal outputted from the IC 2. The output ports 62e and 62f of the switch 62 are connected to the balanced inputs of the power amplifier 14.

The third comparative example shown in FIG. 21 requires the switch 62 for switching between balanced signals, which is expensive, and also requires other two switches to be provided between the IC 2 and the power amplifier 14. The third embodiment uses the switch 41 for switching between unbalanced signals, which is inexpensive, and requires only one switch between the IC 2 and the power amplifier 14. The third embodiment therefore allows reductions in size and cost of the transmission circuit 7 and the high frequency circuit of a cellular phone including the transmission circuit 7, compared with the third comparative example.

Like the first to third modification examples of the first embodiment, the high frequency electronic component of the third embodiment may include the power amplifier 14, or the BPFs 13A and 13B, or both the power amplifier 14 and the BPFs 13A and 13B, in addition to the switch 41 and the balun 12. The high frequency electronic component of the third embodiment may include the balun 15. In this case, the balun 15 can be formed using a plurality of conductor layers provided within the layered substrate 20, like the balun 12. The remainder of configuration, functions and advantages of the third embodiment are similar to those of the second embodiment.

### [Fourth Embodiment]

A high frequency electronic component of a fourth embodiment of the invention will now be described with reference to FIG. 22. FIG. 22 shows a transmission circuit 7 including the high frequency electronic component 70 of the fourth embodiment. The high frequency electronic component 70 of the fourth embodiment is for use in the transmission circuit 7 that processes three UMTS transmission signals UMTS-L Tx, UMTS-H Tx1 and UMTS-H Tx2, and two GSM transmission signals GSM-L Tx and GSM-H Tx. The transmission signal GSM-L Tx includes a transmission signal of at least one of GSM850 (AGSM) and GSM900 (EGSM), which are two of the four systems shown in Table 1 and are close to each other in frequency band. The transmission signal GSM-H Tx includes a transmission signal of at least one of GSM1800 (DCS) and GSM1900 (PCS), which are the other two of the four systems shown in Table 1 and are close to each other in frequency band. The transmission signal UMTS-L Tx is a transmission signal of one of the bands V, VI and VIII whose frequency bands are close to those of GSM850 (AGSM) and GSM900 (ESGM). The transmission signals UMTS-H Tx1 and UMTS-H Tx2 are transmission signals of two different bands among the bands I, II, III, IV, IX and X whose frequency bands are close to those of GSM1800 (DCS) and GSM1900 (PCS). In the high frequency circuit including the transmission circuit 7 of the fourth embodiment, the IC 2 generates and outputs UMTS transmission signals UMTS-L Tx, UMTS-H Tx1 and UMTS-H Tx2 each in the form of an unbalanced signal, and GSM transmission signals GSM-L Tx and GSM-H Tx each in the form of a balanced signal.

The transmission circuit 7 of the fourth embodiment has the high frequency electronic component 70 of the embodiment, three BPFs 72, 75 and 76, two baluns 73 and 77, two power amplifiers 14L and 14H, and two outputs 7L and 7H. The transmission signals UMTS-L Tx, UMTS-H Tx1 and UMTS-H Tx2 outputted from the IC 2 enter the BPFs 72, 75 and 76, respectively.

Each of the baluns 73 and 77 has two balanced inputs and an unbalanced output. The configuration of each of the baluns 73 and 77 is the same as that of the balun 15 of the second embodiment. The two balanced inputs of the balun 73 receive the transmission signal GSM-L Tx in the form of a balanced signal outputted from the IC 2. The two balanced inputs of the balun 77 receive the transmission signal GSM-H Tx in the form of a balanced signal outputted from the IC 2.

The high frequency electronic component 70 has input terminals 70a, 70b, 70c, 70d and 70e, output terminals 70f1, 70f2, 70g1 and 70g2, switches 71 and 74, and baluns 12L and 12H.

The switch 71 has two input ports 71a and 71b and an output port 71c, and connects the output port 71c selectively to one of the input ports 71a and 71b. The switch 74 has three input ports 74, 74b and 74c and an output port 74d, and connects the output port 74d selectively to one of the input ports 74a, 74b and 74c.

The input terminal 70a is connected to the output of the BPF 72 and the input port 71a of the switch 71. The input terminal 70b is connected to the unbalanced output of the balun 73 and the input port 71b of the switch 71. The input terminal 70c is connected to the output of the BPF 75 and the input port 74a of the switch 74. The input terminal 70d is connected to the output of the BPF 76 and the input port 74b of the switch 74. The input terminal 70e is connected to the unbalanced output of the balun 77 and the input port 74c of the switch 74.

Each of the baluns 12L and 12H has an unbalanced input and two balanced outputs. The configuration of each of the baluns 12L and 12H is the same as that of the balun 12 of the first embodiment. The output port 71c of the switch 71 is connected to the unbalanced input of the balun 12L. The output terminals 70f1 and 70f2 are connected to the balanced outputs of the balun 12L and the balanced inputs of the power amplifier 14L. The output of the power amplifier 14L is connected to the output 7L of the transmission circuit 7. The output port 74d of the switch 74 is connected to the unbalanced input of the balun 12H. The output terminals 70g1 and 70g2 are connected to the balanced outputs of the balun 12H and the balanced inputs of the power amplifier 14H. The output of the power amplifier 14H is connected to the output 7H of the transmission circuit 7.

In the transmission circuit 7 including the high frequency electronic component 70, the transmission signal UMTS-L Tx in the form of an unbalanced signal outputted from the IC 2 passes through the BPF 72 and the input terminal 70a, and is received at the input port 71a of the switch 71. The transmission signal GSM-L Tx in the form of a balanced signal outputted from the IC 2 is converted by the balun 73 to a transmission signal GSM-L Tx in the form of an unbalanced signal. This transmission signal GSM-L Tx in the form of an unbalanced signal passes through the input terminal 70b, and is received at the input port 71b of the switch 71. The switch 71 performs switching between the transmission signal UMTS-L Tx in the form of an unbalanced signal received at the input port 71a and the transmission signal GSM-L Tx in the form of an unbalanced signal received at the input port 71b, and outputs one of the transmission signals from the output port 71c to the balun 12L. The transmission signal UMTS-L Tx in the form of an unbalanced signal and the transmission signal GSM-L Tx in the form of an unbalanced signal correspond to the plurality of high frequency signals each in the form of an unbalanced signal in the present invention. The balun 12L converts the transmission signal in the form of an unbalanced signal outputted from the output port 71c of the switch 71 to a transmission signal in the form of a balanced signal, and outputs this transmission signal in the form of a balanced signal to the balanced input power amplifier 14L for amplifying this. The transmission signal received at the power amplifier 14L is amplified by the power amplifier 14L, and is outputted to the output 7L of the transmission circuit 7 as a transmission signal in the form of an unbalanced signal.

The transmission signal UMTS-H Tx1 in the form of an unbalanced signal outputted from the IC 2 passes through the BPF 75 and the input terminal 70c, and is received at the input port 74a of the switch 74. The transmission signal UMTS-H Tx2 in the form of an unbalanced signal outputted from the IC 2 passes through the BPF 76 and the input terminal 70d, and is received at the input port 74b of the switch 74. The transmission signal GSM-H Tx in the form of a balanced signal outputted from the IC 2 is converted by the balun 77 to a transmission signal GSM-H Tx in the form of an unbalanced signal. This transmission signal GSM-H Tx in the form of an unbalanced signal passes through the input terminal 70e, and is received at the input port 74c of the switch 74. The switch 74 performs switching among the transmission signal UMTS-H Tx1 in the form of an unbalanced signal received at the input port 74a, the transmission signal UMTS-H Tx2 in the form of an unbalanced signal received at the input port 74b, and the transmission signal GSM-H Tx in the form of an unbalanced signal received at the input port 74c, and outputs one of the transmission signals from the output port 74d to the balun 12H. The transmission signal UMTS-H Tx1 in the form of an unbalanced signal, the transmission signal UMTS-H Tx2 in the form of an unbalanced signal, and the transmission signal GSM-H Tx in the form of an unbalanced signal correspond to the plurality of high frequency signals each in the form of an unbalanced signal in the present invention. The balun 12H converts the transmission signal in the form of an unbalanced signal outputted from the output port 74d of the switch 74 to a transmission signal in the form of a balanced signal, and outputs this transmission signal in the form of a balanced signal to the balanced input power amplifier 14H for amplifying this. The transmission signal received at the power amplifier 14H is amplified by the power amplifier 14H, and is outputted to the output 7H of the transmission circuit 7 as a transmission signal in the form of an unbalanced signal.

In the fourth embodiment, the output 7L is connected to an input port of a switch (not shown) having the input port and two output ports. This switch selectively connects one of the two output ports to the input port, and outputs the transmission signals UMTS-L Tx and GSM-L Tx received at the input port from different ones of the output ports. The output 7H is connected to an input port of a switch (not shown) having the input port and three output ports. This switch selectively connects one of the three output ports to the input port, and outputs the transmission signals UMTS-H Tx1, UMTS-H Tx2 and GSM-H Tx received at the input port from different ones of the output ports.

Like the high frequency electronic component 10 of the first embodiment, the high frequency electronic component 70 of the fourth embodiment can be constructed by forming the baluns 12L and 12H using a plurality of conductor layers provided within the layered substrate 20 and by mounting the switches 71 and 74 on the layered substrate 20.

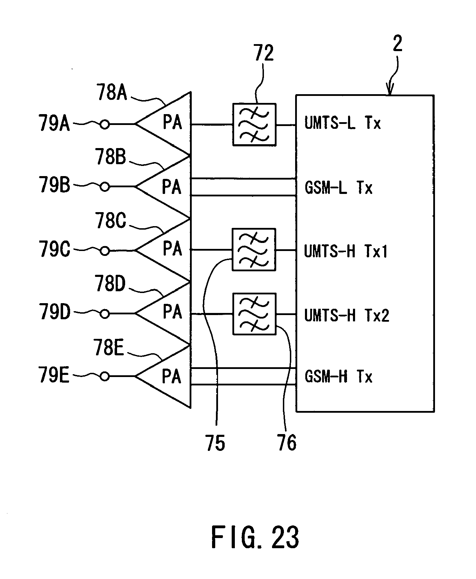

The advantages of the fourth embodiment will now be described with reference to a first and a second comparative example. FIG. 23 is a block diagram illustrating the circuit configuration of a transmission circuit of the first comparative example. The transmission circuit of the first comparative example has five power amplifiers 78A, 78B, 78C, 78D and 78E and five outputs 79A, 79B, 79C, 79D and 79E, instead of the baluns 73 and 77, the switches 71 and 74, the power amplifiers 14L and 14H and the outputs 7L and 7H of the transmission circuit shown in FIG. 22. In the transmission circuit of the first comparative example, the transmission signal UMTS-L Tx in the form of an unbalanced signal outputted from the BPF 72 is amplified by the power amplifier 78A, and is outputted from the output 79A. The transmission signal GSM-L Tx in the form of a balanced signal outputted from the IC 2 is amplified by the power amplifier 78B, and is outputted from the output 79B as a transmission signal GSM-L Tx in the form of an unbalanced signal. The transmission signal UMTS-H Tx1 in the form of an unbalanced signal outputted from the BPF 75 is amplified by the power amplifier 78C, and is outputted from the output 79C. The transmission signal UMTS-H Tx2 in the form of an unbalanced signal outputted from the BPF 76 is amplified by the power amplifier 78D, and is outputted from the output 79D. The transmission signal GSM-H Tx in the form of a balanced signal outputted from the IC 2 is amplified by the power amplifier 78E, and is outputted from the output 79E as a transmission signal GSM-H Tx in the form of an unbalanced signal.

The first comparative example shown in FIG. 23 requires five power amplifiers, each of which is relatively expensive. This impedes reductions in size and cost of the transmission circuit and the high frequency circuit of a cellular phone including the transmission circuit. In contrast, according to the fourth embodiment, a single power amplifier 14L is used in common for the transmission signals UMTS-L Tx and GSM-L Tx that are in frequency bands close to each other, and a single power amplifier 14H is used in common for the transmission signals UMTS-H Tx1, UMTS-H Tx2 and GSM-H Tx that are in frequency bands close to each other. Compared with the first comparative example, the fourth embodiment thus allows a reduction in the number of power amplifiers to be included in the transmission circuit 7 by three, and thereby allows reductions in size and cost of the transmission circuit 7 and the high frequency circuit of a cellular phone including the transmission circuit 7.

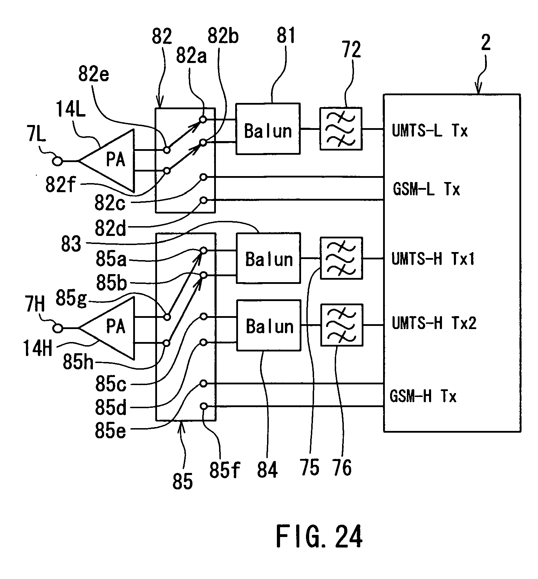

FIG. 24 is a block diagram illustrating the circuit configuration of a transmission circuit of the second comparative example. The transmission circuit of the second comparative example has baluns 81, 83 and 84 and switches 82 and 85, instead of the baluns 73 and 77 and the switches 71 and 74 of the transmission circuit shown in FIG. 22. Each of the baluns 81, 83 and 84 has an unbalanced input and two balanced outputs. The switch 82 has four input ports 82a, 82b, 82c and 82d, and two output ports 83e and 82f. The switch 82 is capable of switching between a state in which the output port 82e is connected to the input port 82a while the output port 82f is connected to the input port 82b and a state in which the output port 82e is connected to the input port 82c while the output port 82f is connected to the input port 82d. The switch 85 has six input ports 85a, 85b, 85c, 85d, 85e and 85f, and two output ports 85g and 85h. The switch 85 is capable of switching among a state in which the output port 85g is connected to the input port 85a while the output port 85h is connected to the input port 85b, a state in which the output port 85g is connected to the input port 85c while the output port 85h is connected to the input port 85d, and a state in which the output port 85g is connected to the input port 85e while the output port 85h is connected to the input port 85f.

The unbalanced input of the balun 81 is connected to the output of the BPF 72. The balanced outputs of the balun 81 are connected to the input ports 82a and 82b of the switch 82. The input ports 82c and 82d of the switch 82 receive the transmission signal GSM-L Tx in the form of a balanced signal outputted from the IC 2. The output ports 82e and 82f of the switch 82 are connected to the balanced inputs of the power amplifier 14L. The unbalanced input of the balun 83 is connected to the output of the BPF 75. The balanced outputs of the balun 83 are connected to the input ports 85a and 85b of the switch 85. The unbalanced input of the balun 84 is connected to the output of the BPF 76. The balanced outputs of the balun 84 are connected to the input ports 85c and 85d of the switch 85. The input ports 85e and 85f of the switch 85 receive the transmission signal GSM-H Tx in the form of a balanced signal outputted from the IC 2. The output ports 85g and 85h of the switch 85 are connected to the balanced inputs of the power amplifier 14H.

The second comparative example shown in FIG. 24 requires two expensive switches for switching between balanced signals. The fourth embodiment allows the use of the switches 71 and 74 for switching between unbalanced signals, which are inexpensive, and does not use the expensive switches 82 and 85 for switching between balanced signals. The fourth embodiment therefore allows reductions in size and cost of the transmission circuit 7 and the high frequency circuit of a cellular phone including the transmission circuit 7, compared with the second comparative example.

Like the first to third modification examples of the first embodiment, the high frequency electronic component of the fourth embodiment may include the power amplifiers 14L and 14H, or the BPFs 72, 75 and 76, or both the power amplifiers 14L, 14H and the BPFs 72, 75, 76, in addition to the switches 71 and 74 the baluns 12L and 12H. The high frequency electronic component of the fourth embodiment may include the baluns 73 and 77. In this case, the baluns 73 and 77 correspond to the second balun of the present invention. In the case where the high frequency electronic component includes the baluns 73 and 77, the baluns 73 and 77 can be formed using a plurality of conductor layers provided within the layered substrate 20, like the baluns 12L and 12H. The remainder of configuration, functions and advantages of the fourth embodiment are similar to those of the first embodiment.

### [Fifth Embodiment]

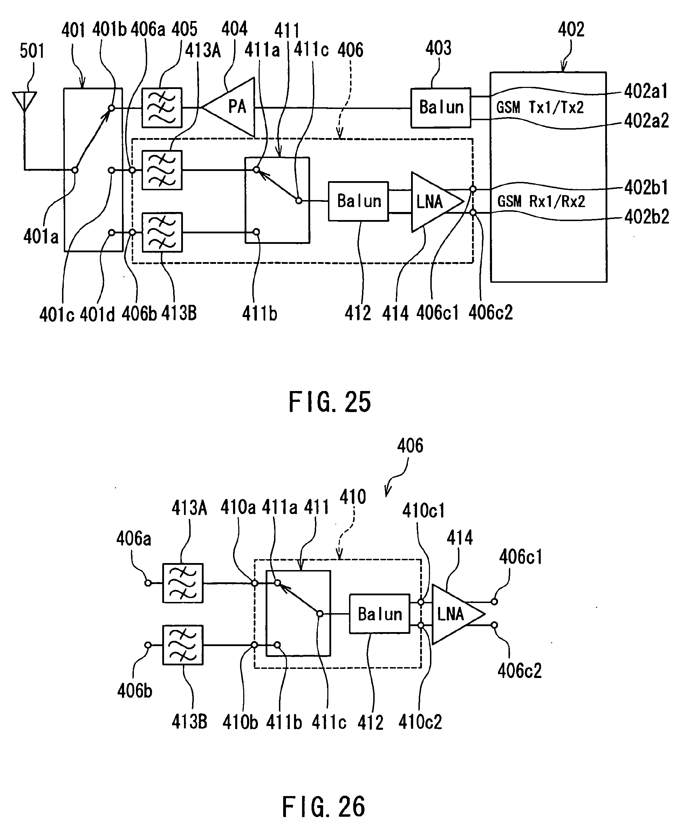

A fifth embodiment of the invention will now be described. Reference is now made to FIG. 25 to describe an example of a high frequency circuit of a cellular phone including a high frequency electronic component of the fifth embodiment of the invention. FIG. 25 is a block diagram illustrating the circuit configuration of this example of high frequency circuit. This high frequency circuit processes two GSM signals.

The high frequency circuit shown in FIG. 25 includes an antenna 501, a switch 401, and an IC 402. The switch 401 has four ports 401a, 401b, 401c and 401d, and connects the port 401a selectively to one of the ports 401b, 401c and 401d. The port 401a is connected to the antenna 501.

The IC 402 is a circuit that mainly performs modulation and demodulation of signals. In the fifth embodiment, the IC 402 generates and outputs two GSM transmission signals GSM Tx1 and GSM Tx2. Each of the transmission signals GSM Tx1 and GSM Tx2 outputted by the IC 402 is in the form of a balanced signal. The IC 402 receives two GSM reception signals GSM Rx1 and GSM Rx2. Each of the reception signals GSM Rx1 and GSM Rx2 received by the IC 402 is in the form of a balanced signal. The IC 402 has terminals 402a1, 402a2, 402b1 and 402b2. The transmission signals GSM Tx1 and GSM Tx2 are outputted from the terminals 402a1 and 402a2. The reception signals GSM Rx1 and GSM Rx2 are received at the terminals 402b1 and 402b2.

In the fifth embodiment, in the case where the transmission signal GSM Tx1 and the reception signal GSM Rx1 are a transmission signal and a reception signal of one of GSM850 (AGSM) and GSM900 (EGSM), which are two of the four systems shown in Table 1 and are close to each other in frequency band, the transmission signal GSM Tx2 and the reception signal GSM Rx2 are a transmission signal and a reception signal of the other of GSM850 (AGSM) and GSM900 (EGSM). In the case where the transmission signal GSM Tx1 and the reception signal GSM Rx1 are a transmission signal and a reception signal of one of GSM1800 (DCS) and GSM1900 (PCS), which are the other two of the four systems shown in Table 1 and are close to each other in frequency band, the transmission signal GSM Tx2 and the reception signal GSM Rx2 are a transmission signal and a reception signal of the other of GSM1800 (DCS) and GSM1900 (PCS).

The high frequency circuit further includes a balun 403, a power amplifier 404, an LPF 405, and a reception circuit 406. The balun 403 has two balanced inputs and an unbalanced output. The two balanced inputs of the balun 403 are connected to the terminals 402a1 and 402a2 of the IC 402. The power amplifier 404 has an unbalanced input and an unbalanced output. The unbalanced input of the power amplifier 404 is connected to the unbalanced output of the balun 403. The unbalanced output of the power amplifier 404 is connected to the port 401b of the switch 401 via the LPF 405.

FIG. 26 shows the circuit configuration of the reception circuit 406. The reception circuit 406 processes a plurality of reception signals, i.e., the reception signals GSM Rx1 and GSM Rx2, as a plurality of high frequency signals. The reception circuit 406 corresponds to the signal processing circuit of the present invention. The reception circuit 406 has inputs 406a. and 406b, and outputs 406c1 and 406c2. The input 406a is connected to the port 401c of the switch 401. The input 406b is connected to the port 401d of the switch 401. The output 406c1 is connected to the terminal 402b1 of the IC 402. The output 406c2 is connected to the terminal 402b2 of the IC 402.

The reception circuit 406 includes a switch 411, a balun 412, two BPFs 413A and 413B, and a differential input/output low-noise amplifier 414. The switch 411 has two input ports 411a and 411b and an output port 411c, and connects the output port 411c selectively to one of the input ports 411a and 411b. The balun 412 has an unbalanced input and two balanced outputs. The input port 411a of the switch 411 is connected to the input 406a of the reception circuit 406 via the BPF 413A. The input port 411b of the switch 411 is connected to the input 406b of the reception circuit 406 via the BPF 413B. The output port 411c of the switch 411 is connected to the unbalanced input of the balun 412.

The low-noise amplifier 414 has two differential inputs (balanced inputs) and two differential outputs (balanced outputs). The two balanced outputs of the balun 412 are connected to the two differential inputs of the low-noise amplifier 414. The two differential outputs of the low-noise amplifier 414 are connected to the two outputs 406c1 and 406c2 of the reception circuit 406. The low-noise amplifier 414 amplifies signals outputted from the balanced outputs of the balun 412. The high frequency electronic component 410 of the fifth embodiment is for use in the reception circuit 406 shown in FIG. 26. The low-noise amplifier 414 corresponds to the balanced input amplifier of the present invention.

For example, the switch 411 may be formed of an MMIC, or may be formed using a PIN diode. For example, the balun 412 may be formed of an LC circuit comprising an inductor and a capacitor, or may be formed using a resonator. The BPFs 413A and 41B may be formed of a surface acoustic wave element, for example. The low-noise amplifier 414 may be formed of an MMIC, for example.

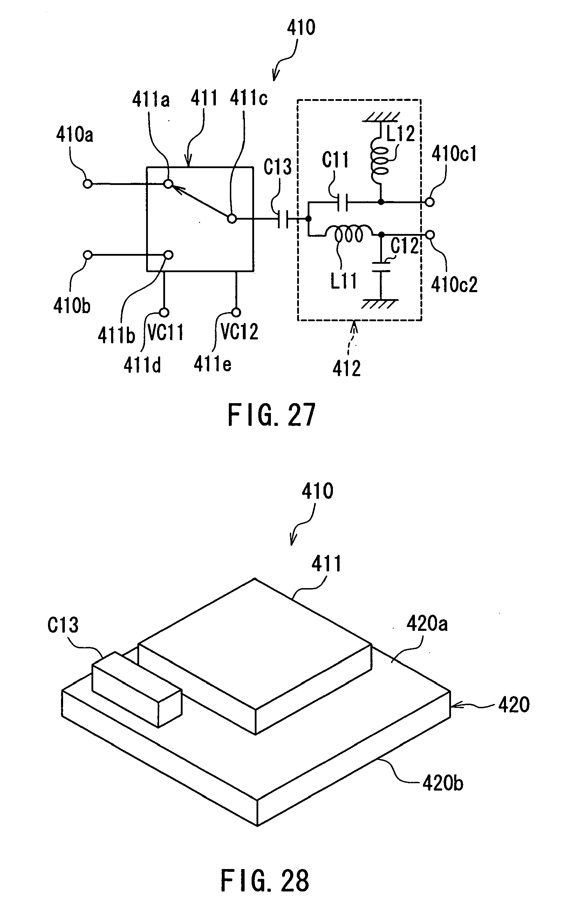

FIG. 27 is a schematic diagram illustrating the circuit configuration of the high frequency electronic component 410. The high frequency electronic component 410 has input terminals 410a and 410b, output terminals 410c1 and 410c2, and the switch 411 and the balun 412 described above. The input terminal 410a is connected to the output of the BPF 413A and the input port 411a of the switch 411. The input terminal 410b is connected to the output of the BPF 413B and the input port 411b of the switch 411. The output terminals 410c1 and 410c2 are connected to the two balanced outputs of the balun 412 and the two differential inputs of the low-noise amplifier 414. The switch 411 has control terminals 411d and 411e that receive control signals VC11 and VC12 for controlling the switch 411.

FIG. 27 shows an example in which the balun 412 is formed of an LC circuit comprising an inductor and a capacitor. In this example, the balun 412 has two inductors L11 and L12 and two capacitors C11 and C12. One end of the inductor L11 and one end of the capacitor C11 are connected to the unbalanced input of the balun 412. The other end of the inductor L11 is connected to one of the balanced outputs of the balun 412 connected to the output terminal 410c2, and is also connected to the ground through the capacitor C12. The other end of the capacitor C11 is connected to the other of the balanced outputs of the balun 412 connected to the output terminal 410c1, and is also connected to the ground through the inductor L12.

In the example shown in FIG. 27, the high frequency electronic component 410 includes a capacitor C13 provided in the signal path between the output port 411c of the switch 411 and the unbalanced input of the balun 412. The capacitor C13 is provided for preventing direct currents that result from the control signals VC11 and VC12 from flowing into the signal path connected to the output port 411c. In the example shown in FIG. 27, no capacitor is provided in the signal path between the input port 411a of the switch 411 and the input terminal 410a and in the signal path between the input port 411b of the switch 411 and the input terminal 410b. This is because the BPFs 413A and 413B connected to the input terminals 410a and 410b have the function of blocking the passage of direct currents. In the case where direct currents resulting from the control signals VC11 and VC12 are generated from the input ports 411a and 411b, a capacitor for blocking the passage of the direct currents may be provided in the signal path between the input port 411a of the switch 411 and the input terminal 410a and the signal path between the input port 411b of the switch 411 and the input terminal 410b if the BPFs 413A and 413B do not have the function of blocking the passage of direct currents or if the BPFs 413A and 413B have a low resistance to direct currents. In the case where there is no need to block the passage of direct currents resulting from the control signals VC11 and VC12 in the signal path connected to the output port 411c, it is not required to provide the capacitor C13. In each of the signal paths that are respectively connected to the ports 411a, 411b and 411c of the switch 411, a capacitor is provided if it is necessary to block the passage of direct currents resulting from the control signals VC11 and VC12 in the signal path. The configuration of the switch 411 is the same as that of the switch 11 of the first embodiment. Whether it is necessary to provide a capacitor in the respective signal paths connected to the ports 411a, 411b and 411c of the switch 411 is the same as whether it is necessary to provide a capacitor in the signal paths connected to the switch 11 described for the first embodiment. The capacitor C13 is omitted in FIG. 25 and FIG. 26.

The function of the high frequency circuit including the high frequency electronic component 410 of the fifth embodiment will now be described. The IC 402 generates and outputs the transmission signals GSM Tx1 and GSM Tx2 each in the form of a balanced signal. When transmitting the transmission signal GSM Tx1 or GSM Tx2, the port 401a of the switch 401 is connected to the port 401b. When in this state, the transmission signal GSM Tx1 or GSM Tx2 in the form of a balanced signal outputted by the IC 402 is converted by the balun 403 to a transmission signal GSM Tx1 or GSM Tx2 in the form of an unbalanced signal. This transmission signal passes in succession through the power amplifier 404, the LPF 405 and the switch 401 into the antenna 501, and is transmitted from the antenna 501.

When receiving the reception signal GSM Rx1, the port 401a of the switch 401 is connected to the port 401c. When in this state, the reception signal GSM Rx1 in the form of an unbalanced signal received by the antenna 501 passes through the switch 401 and the BPF 413A, and is received at the input port 411a of the switch 411 of the high frequency electronic component 410.

When receiving the reception signal GSM Rx2, the port 401a of the switch 401 is connected to the port 401d. When in this state, the reception signal GSM Rx2 in the form of an unbalanced signal received by the antenna 501 passes through the switch 401 and the BPF 413B, and is received at the input port 411b of the switch 411 of the high frequency electronic component 410.

According to the state of the control signals VC11 and VC12 received at the control terminals 411d and 411e, the switch 411 performs switching between the reception signal GSM Rx1 in the form of an unbalanced signal received at the input port 411a and the reception signal GSM Rx2 in the form of an unbalanced signal received at the input port 411b, and outputs one of the reception signals from the output port 411c. The reception signal GSM Rx1 in the form of an unbalanced signal and reception signal GSM Rx2 in the form of an unbalanced signal correspond to the plurality of high frequency signals each in the form of an unbalanced signal in the present invention. The balun 412 converts the reception signal in the form of an unbalanced signal outputted from the output port 411c of the switch 411 to a reception signal in the form of a balanced signal, and outputs this reception signal in the form of a balanced signal to the differential input/output low-noise amplifier 414 for amplifying this. The reception signal received at the low-noise amplifier 414 is amplified by the low-noise amplifier 414, and enters the IC 402 as a reception signal in the form of a balanced signal.

In the high frequency electronic component 410 of the fifth embodiment, the switch 411 performs switching between the reception signal GSM Rx1 in the form of an unbalanced signal received at the input port 411a and the reception signal GSM Rx2 in the form of an unbalanced signal received at the input port 411b, and outputs one of the reception signals from the output port 411c. The balun 412 converts the reception signal in the form of an unbalanced signal outputted from the output port 411c of the switch 411 to a reception signal in the form of a balanced signal, and outputs this reception signal in the form of a balanced signal to the differential input/output low-noise amplifier 414 for amplifying this. The fifth embodiment thus allows the use of the differential input/output low-noise amplifier 414 in the reception circuit 406 that processes the two reception signals GSM Rx1 and GSM Rx2, and thereby allows an improvement in reception sensitivity. Furthermore, the fifth embodiment allows a reduction in the number of low-noise amplifiers to be included in the reception circuit 406, and consequently allows reductions in size and cost of the reception circuit 406.

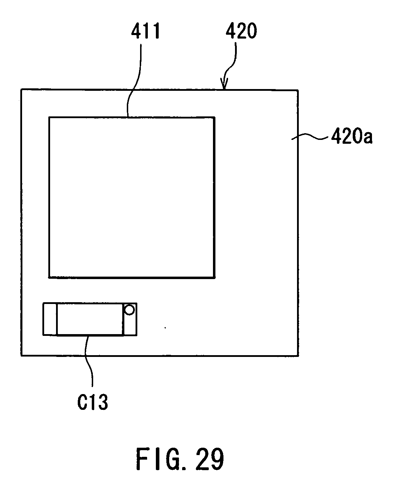

The structure of the high frequency electronic component 410 of the fifth embodiment will now be described. FIG. 28 is a perspective view showing the outer appearance of the high frequency electronic component 410. FIG. 29 is a top view of the high frequency electronic component 410. As shown in FIG. 28 and FIG. 29, the high frequency electronic component 410 includes a layered substrate 420 for integrating the components of the high frequency electronic component 410. As will be described in detail later, the layered substrate 420 includes a plurality of dielectric layers stacked. The layered substrate 420 is rectangular-solid-shaped, having a top surface 420a, a bottom surface 420b, and four side surfaces.

The circuits of the high frequency electronic component 410 are formed using conductor layers provided within the layered substrate 420, the dielectric layers mentioned above, and elements mounted on the top surface 420a of the layered substrate 420. Here, by way of example, the switch 411 and the capacitor C13 are mounted on the top surface 420a.

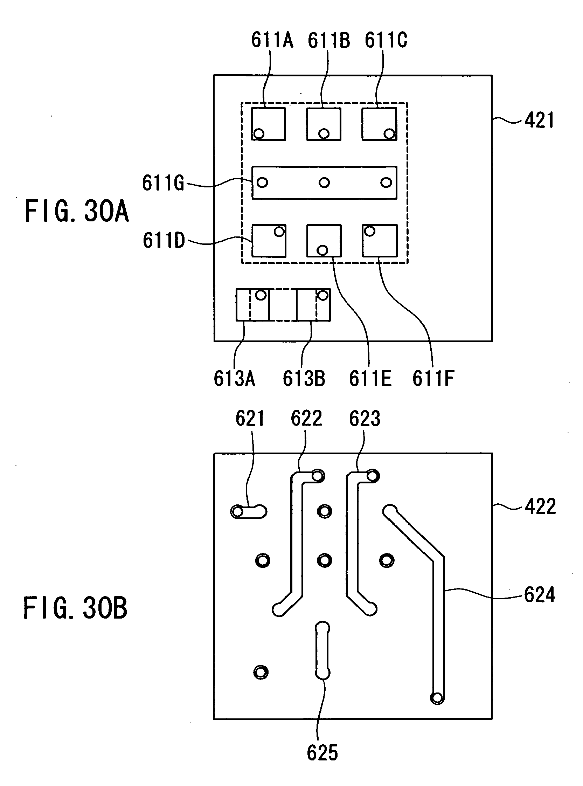

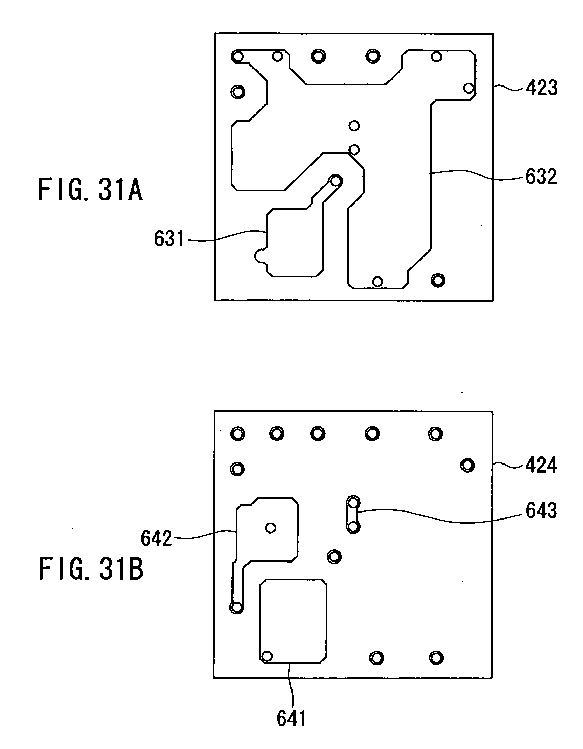

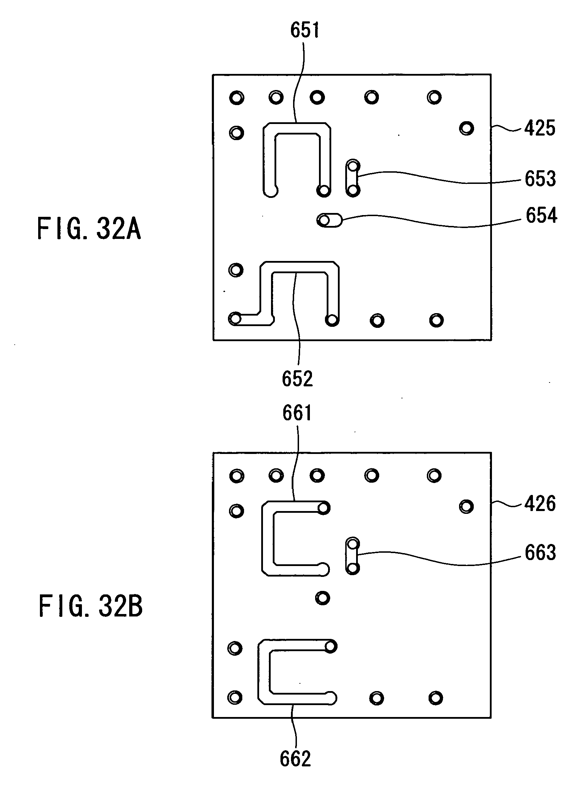

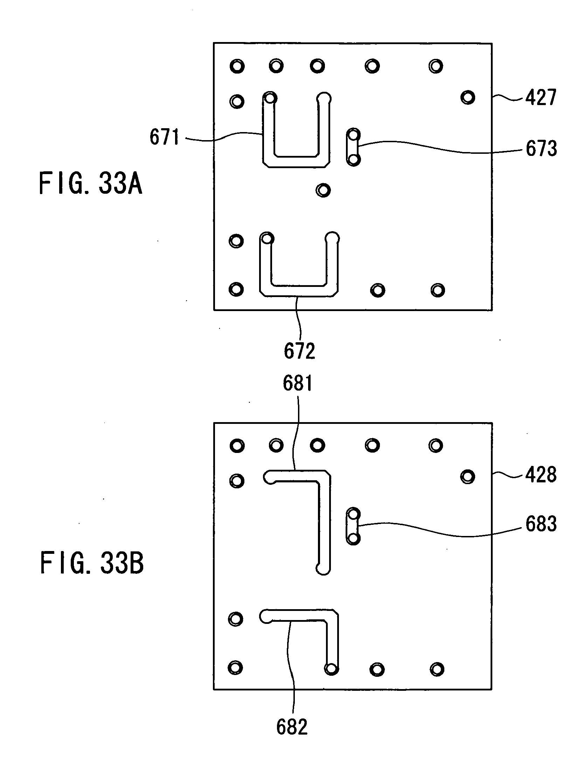

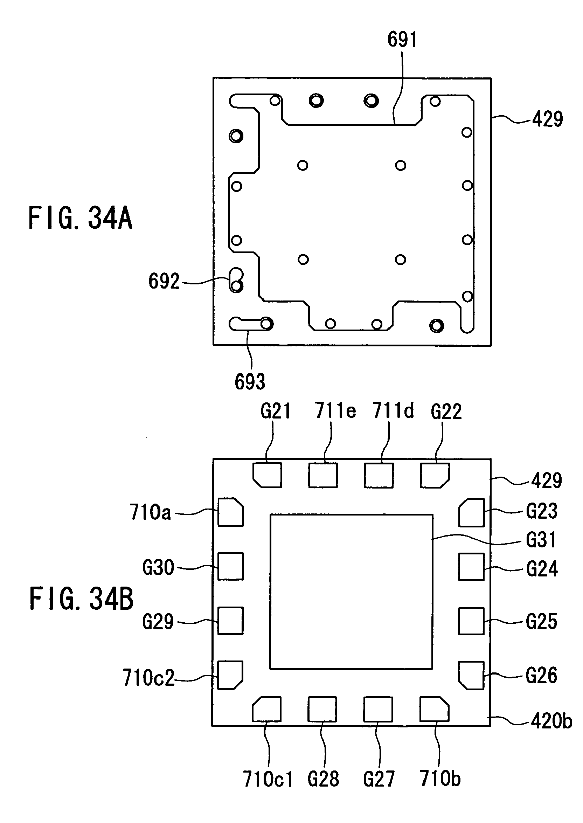

Reference is now made to FIG. 30A to FIG. 34B to describe the dielectric layers and the conductor layers of the layered substrate 420. FIG. 30A and FIG. 30B respectively show the top surfaces of the first and second dielectric layers from the top. FIG. 31A and FIG. 31B respectively show the top surfaces of the third and fourth dielectric layers from the top. FIG. 32A and FIG. 32B respectively show the top surfaces of the fifth and sixth dielectric layers from the top. FIG. 33A and FIG. 33B respectively show the top surfaces of the seventh and eighth dielectric layers from the top. FIG. 34A shows the top surface of the ninth dielectric layer from the top. FIG. 34B shows the ninth dielectric layer and a conductor layer therebelow as seen from above. In FIG. 30A to FIG. 34B, circles represent through holes.

On the top surface of the first dielectric layer 421 of FIG. 30A there are formed conductor layers 611A to 611G to which the switch 411 is connected, and conductor layers 613A and 613B to which the capacitor C13 is connected. The conductor layer 611A is connected to the port 411a of the switch 411. The conductor layer 611C is connected to the port 411b of the switch 411. The conductor layer 611E is connected to the port 411c of the switch 411. The conductor layer 611F is connected to the control terminal 411d of the switch 411. The conductor layer 611D is connected to the control terminal 411e of the switch 411. The conductor layers 611B and 611G are connected to the ground of the switch 411. The dielectric layer 421 has a plurality of through holes connected to the above-mentioned conductor layers.

Conductor layers 621, 622, 623, 624 and 625 are formed on the top surface of the second dielectric layer 422 of FIG. 30B. The conductor layer 611A is connected to the conductor layer 621 via a through hole formed in the dielectric layer 421. The conductor layer 611D is connected to the conductor layer 622 via a through hole formed in the dielectric layer 421. The conductor layer 611F is connected to the conductor layer 623 via a through hole formed in the dielectric layer 421. The conductor layer 611C is connected to the conductor layer 624 via a through hole formed in the dielectric layer 421. The conductor layers 611E and 613B are connected to the conductor layer 625 via through holes formed in the dielectric layer 421. The dielectric layer 422 has through holes connected to the conductor layers 621, 622, 623 and 624, and other through holes.

A capacitor-forming conductor layer 631 and a grounding conductor layer 632 are formed on the top surface of the third dielectric layer 423 of FIG. 31A. The conductor layer 613A is connected to the conductor layer 631 via through holes formed in the dielectric layers 421 and 422. The conductor layers 611B and 611G are connected to the conductor layer 632 via through holes formed in the dielectric layers 421 and 422. The dielectric layer 423 has through holes connected to the conductor layers 631 and 632, and other through holes.

Capacitor-forming conductor layers 641 and 642 and a conductor layer 643 are formed on the top surface of the fourth dielectric layer 424 of FIG. 31B. The conductor layers 631 and 641 and the dielectric layer 423 located therebetween constitute the capacitor C11 of FIG. 27. The conductor layers 632 and 642 and the dielectric layer 423 located therebetween constitute the capacitor C12 of FIG. 27. The conductor layer 632 is connected to the conductor layer 643 via two through holes formed in the dielectric layer 423. The dielectric layer 424 has through holes connected to the conductor layers 641, 642 and 643, and other through holes.

Inductor-forming conductor layers 651 and 652 and conductor layers 653 and 654 are formed on the top surface of the fifth dielectric layer 425 of FIG. 32A. The conductor layer 642 is connected to the conductor layer 651 via through holes formed in the dielectric layer 424. The conductor layer 641 is connected to the conductor layer 652 via a through hole formed in the dielectric layer 424. The conductor layer 643 is connected to the conductor layer 653 via two through holes formed in the dielectric layer 424. The conductor layer 631 is connected to the conductor layer 654 via through holes formed in the dielectric layers 423 and 424. The dielectric layer 425 has through holes connected to the conductor layers 651, 652, 653 and 654, and other through holes.

Inductor-forming conductor layers 661 and 662 and a conductor layer 663 are formed on the top surface of the sixth dielectric layer 426 of FIG. 32B. The conductor layer 651 is connected to the conductor layer 661 via a through hole formed in the dielectric layer 425. The conductor layer 652 is connected to the conductor layer 662 via through holes formed in the dielectric layer 425. The conductor layer 653 is connected to the conductor layer 663 via two through holes formed in the dielectric layer 425. The dielectric layer 426 has through holes connected to the conductor layers 661, 662 and 663, and other through holes.

Inductor-forming conductor layers 671 and 672 and a conductor layer 673 are formed on the top surface of the seventh dielectric layer 427 of FIG. 33A. The conductor layer 661 is connected to the conductor layer 671 via a through hole formed in the dielectric layer 426. The conductor layer 662 is connected to the conductor layer 672 via a through hole formed in the dielectric layer 426. The conductor layer 663 is connected to the conductor layer 673 via two through holes formed in the dielectric layer 426. The dielectric layer 427 has through holes connected to the conductor layers 671, 672 and 673, and other through holes.

Inductor-forming conductor layers 681 and 682 and a conductor layer 683 are formed on the top surface of the eighth dielectric layer 428 of FIG.

33B. The conductor layer 671 is connected to the conductor layer 681 via a through hole formed in the dielectric layer 427. The conductor layer 631 is connected to the conductor layer 681 via through holes formed in the dielectric layers 423 to 427 and the conductor layer 654. The conductor layer 672 is connected to the conductor layer 682 via a through hole formed in the dielectric layer 427. The conductor layer 673 is connected to the conductor layer 683 via two through holes formed in the dielectric layer 427. The dielectric layer 428 has through holes connected to the conductor layers 682 and 683, and other through holes.

The inductor L11 of FIG. 27 is composed of the conductor layers 651, 661, 671 and 681 and the through holes connecting these conductor layers in series. The inductor L12 of FIG. 27 is composed of the conductor layers 652, 662, 672 and 682 and the through holes connecting these conductor layers in series.

A grounding conductor layer 691 and conductor layers 692 and 693 are formed on the top surface of the ninth dielectric layer 429 of FIG. 34A. The conductor layers 682 and 683 are connected to the conductor layer 691 via through holes formed in the dielectric layer 428. The conductor layer 632 is also connected to the conductor layer 691 via through holes formed in the dielectric layers 423 to 428. The conductor layer 642 is connected to the conductor layer 692 via through holes formed in the dielectric layers 424 to 428. The conductor layer 652 is connected to the conductor layer 693 via through holes formed in the dielectric layers 425 to 428. The dielectric layer 429 has through holes connected to the conductor layer 691, 692 and 693, and other through holes.

As shown in FIG. 34B, on the lower surface of the dielectric layer 429, that is, on the bottom surface 420b of the layered substrate 420, there are formed conductor layers 710a and 710b that form the input terminals 410a and 410b, conductor layers 710c1 and 710c2 that form the output terminals 410c1 and 410c2, conductor layers 711d and 711e that form the control terminals 411d and 411e, and conductor layers G21 to G31 that form ground terminals.

The conductor layer 611A is connected to the conductor layer 710a via through holes formed in the dielectric layers 421 to 429 and the conductor layer 621. The conductor layer 611C is connected to the conductor layer 710b via through holes formed in the dielectric layers 421 to 429 and the conductor layer 624. The conductor layer 652 is connected to the conductor layer 710c1 via through holes formed in the dielectric layers 425 to 429 and the conductor layer 693. The conductor layer 642 is connected to the conductor layer 710c2 via through holes formed in the dielectric layers 424 to 429 and the conductor layer 692. The conductor layer 611F is connected to the conductor layer 711d via through holes formed in the dielectric layers 421 to 429 and the conductor layer 623. The conductor layer 611D is connected to the conductor layer 711e via through holes formed in the dielectric layers 421 to 429 and the conductor layer 622. The conductor layer 691 is connected to the conductor layers G21 to G31 via through holes formed in the dielectric layer 429. The conductor layers G21 to G31 are configured to be connected to the ground.

The first to ninth dielectric layers 421 to 429 and the conductor layers described above are stacked to form the layered substrate 420 of FIG. 28. The switch 411 and the capacitor C13 are mounted on the top surface 420a of the layered substrate 420. The balun 412 is formed using, among the above-described conductor layers, a plurality of ones provided within the layered substrate 420. In the present embodiment, a variety of types of substrates are employable as the layered substrate 420, such as one in which the dielectric layers are formed of a resin, ceramic, or a resin-ceramic composite material. However, a low-temperature co-fired ceramic multilayer substrate, which is excellent in high frequency response, is particularly preferable as the layered substrate 420.

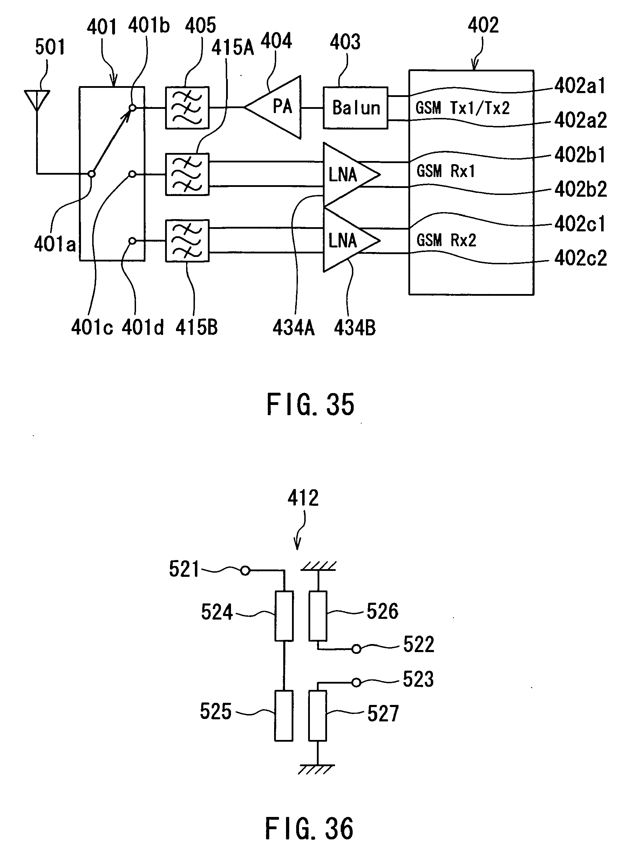

The advantages of the fifth embodiment will now be described with reference to a comparative example. FIG. 35 is a block diagram illustrating the circuit configuration of a high frequency circuit of the comparative example. The high frequency circuit of the comparative example does not have the switch 411 and the balun 412 provided in the high frequency circuit shown in FIG. 25, but has BPFs 415A and 415B instead of the BPFs 413A and 413B of the high frequency circuit shown in FIG. 25, and has two low-noise amplifiers 434A and 434B instead of the low-noise amplifier 414 of the high frequency circuit shown in FIG. 25. The BPF 415A outputs the reception signal GSM Rx1 in the form of a balanced signal, and the BPF 415B outputs the reception signal GSM Rx2 in the form of a balanced signal. Each of the low-noise amplifiers 434A and 434B is of the differential input/output type. In the high frequency circuit of the comparative example, the reception signal GSM Rx1 outputted from the port 401c of the switch 401 passes through the BPF 415A and enters the low-noise amplifier 434A. The reception signal GSM Rx2 outputted from the port 401d of the switch 401 passes through the BPF 415B and enters the low-noise amplifier 434B. In the high frequency circuit of the comparative example, the BPFs 415A and 415B and the low-noise amplifiers 434A and 434B constitute the reception circuit. The remainder of configuration of the high frequency circuit of the comparative example is the same as that of the high frequency circuit shown in FIG. 25.

The comparative example shown in FIG. 35 requires two low-noise amplifiers, each of which is relatively expensive. This impedes reductions in size and cost of the reception circuit and the high frequency circuit of a cellular phone including the reception circuit. In contrast, according to the fifth embodiment, a single low-noise amplifier 414 is used in common for the two reception signals GSM Rx1 and GSM Rx2. Compared with the comparative example, the fifth embodiment thus allows a reduction in the number of low-noise amplifiers to be included in the reception circuit 406 by one, and thereby allows reductions in size and cost of the reception circuit 406 and the high frequency circuit of a cellular phone including the reception circuit 406. Furthermore, according to the fifth embodiment, the balun 412 converts the reception signal in the form of an unbalanced signal outputted from the output port 411c of the switch 411 to a reception signal in the form of a balanced signal, and outputs this signal to the low-noise amplifier 414. The fifth embodiment thus allows the use the differential input/output low-noise amplifier 414, and thereby allows an improvement in reception sensitivity. According to the fifth embodiment, while the number of low-noise amplifiers is reduced by one compared with the comparative example, an additional switch 411 for switching between unbalanced signals is required. However, since a switch for switching between unbalanced signals is less expensive than a low-noise amplifier, the fifth embodiment allows a cost reduction compared with the comparative example.

In the comparative example shown in FIG. 35, a switch for switching between balanced signals may be provided to allow the common use of a low-noise amplifier for the two reception signals GSM Rx1 and GSM Rx2. In this case, the BPFs 415A and 415B will be connected to the input ports of the switch for switching between balanced signals and a single low-noise amplifier will be connected to the output port of this switch. Such a configuration, however, causes a cost increase because the switch for switching between balanced signals is more expensive than a switch for switching between unbalanced signals. In addition, the above-described configuration requires that the lines for balanced signals be greater in length, which makes the degree of balance of the balanced signals tend to become lower.

As compared with the above-described configuration in which a switch for switching between balanced signals is used, the fifth embodiment allows the use of an inexpensive switch for switching unbalanced signals, without requiring the expensive switch for switching between balanced signals. While the fifth embodiment requires an additional balun compared with the above-described configuration, the balun can be formed at a low cost. The fifth embodiment therefore allows reductions in size and cost of the reception circuit 406 and the high frequency circuit of a cellular phone including the reception circuit 406, compared with the configuration in which a switch for switching between balanced signals is used. Furthermore, according to the fifth embodiment, since the lines for the balanced signals are shorter than in the above-described configuration, it is possible to prevent a reduction in the degree of balance of the balanced signals.

By forming a single high frequency electronic component 410 including the switch 411 and the balun 412 as in the fifth embodiment, it is possible to reduce the area occupied by the switch 411 and the balun 412 in the reception circuit 406, compared with the case of forming the switch 411 and the balun 412 as discrete elements and mounting them on a substrate. In this respect also, the fifth embodiment allows miniaturization of the reception circuit 406 and the high frequency circuit of a cellular phone including the reception circuit 406.

The high frequency electronic component 410 of the fifth embodiment includes the layered substrate 420, the balun 412 is formed using a plurality of conductor layers provided within the layered substrate 420, and the switch 411 is mounted on the layered substrate 420. The balun 412 is easily formable using a plurality of conductor layers provided within the layered substrate 420 as shown in FIG. 30A to FIG. 34B. By forming the balun 412 using a plurality of conductor layers provided within the layered substrate 420 and mounting the switch 411 on the layered substrate 420 as in the fifth embodiment, it is possible to reduce the area occupied by the high frequency electronic component 410 in the reception circuit 406, in particular. The fifth embodiment thus allows further miniaturization of the reception circuit 406 and the high frequency circuit of a cellular phone including the reception circuit 406.

Reference is now made to FIG. 36 to describe another possible configuration of the balun 412. The balun 412 shown in FIG. 36 is formed using resonators. This balun 412 has an unbalanced input 521, two balanced outputs 522 and 523, and four quarter-wave resonators 524, 525, 526 and 527. One end of the quarter-wave resonator 524 is connected to the unbalanced input 521, and the other end of the quarter-wave resonator 524 is connected to one end of the quarter-wave resonator 525. One end of the quarter-wave resonator 526 is connected to the balanced output 522, and the other end of the quarter-wave resonator 526 is connected to the ground. One end of the quarter-wave resonator 527 is connected to the balanced output 523, and the other end of the quarter-wave resonator 527 is connected to the ground. The quarter-wave resonator 526 is coupled to the quarter-wave resonator 524, and the quarter-wave resonator 527 is coupled to the quarter-wave resonator 525.

The balun 412 formed of the LC circuit shown in FIG. 27 is small in insertion loss, but narrow in frequency band in which a good amplitude balance characteristic is obtained. On the other hand, the balun 412 formed using the resonators shown in FIG. 36 is slightly greater in insertion loss, but broad in frequency band in which a good amplitude balance characteristic is obtained. The balun 412 formed using the resonators shown in FIG. 36 blocks the passage of direct currents between the unbalanced input 521 and each of the balanced outputs 522 and 523. Therefore, if the balun 412 of FIG. 36 is used, it is unnecessary to provide a capacitor for blocking the passage of direct currents in the signal paths between the switch 411 and the balun 412 even in the case where the switch 411 is of the type which in principle requires a capacitor for blocking the passage of direct currents in the signal paths connected to the respective ports of the switch 411.

The balun 412 of FIG. 36 can be formed using a plurality of conductor layers provided within the layered substrate 420, like the balun 412 of FIG. 27.

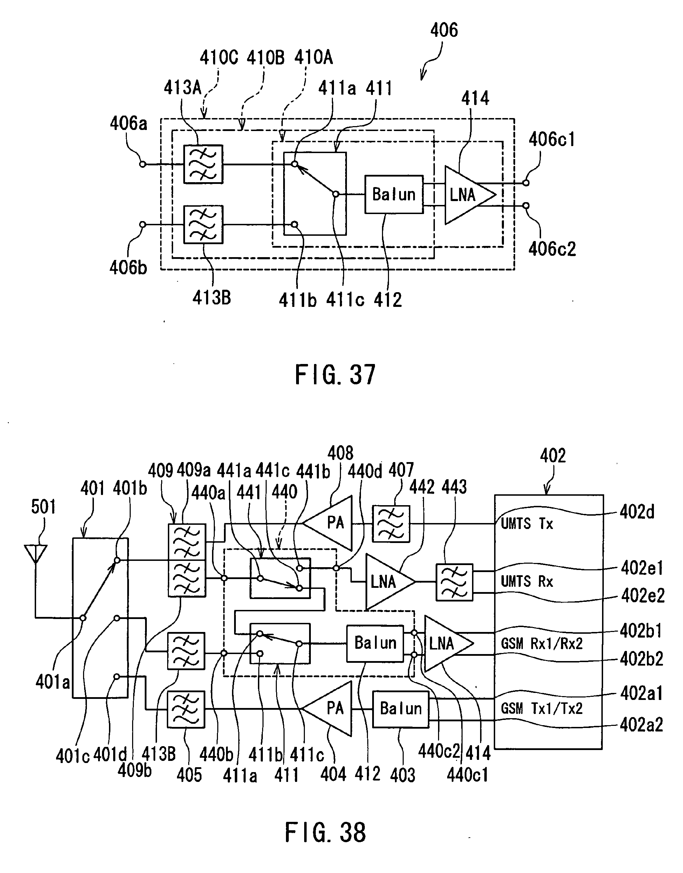

Reference is now made to FIG. 37 to describe first to third modification examples of the high frequency electronic component of the fifth embodiment. FIG. 37 shows a portion of the reception circuit 406 included in the high frequency electronic component of each modification example. The high frequency electronic component 410A of the first modification example includes the low-noise amplifier 414 in addition to the switch 411 and the balun 412. In this high frequency electronic component 410A, the low-noise amplifier 414 may be mounted on the top surface 420a of the layered substrate 420. The inputs of the low-noise amplifier 414 are connected to the balanced outputs of the balun 412, and the outputs of the low-noise amplifier 414 are connected to the outputs of the high frequency electronic component 410A. The low-noise amplifier 414 is thus provided between the balanced outputs of the balun 412 and the outputs of the high frequency electronic component 410A.

The high frequency electronic component 410B of the second modification example includes the two BPFs 413A and 413B in addition to the switch 411 and the balun 412. In this high frequency electronic component 410B, the BPFs 413A and 413B may be mounted on the top surface 420a of the layered substrate 420. The input of the BPF 413A is connected to an input terminal of the high frequency electronic component 410B at which the reception signal GSM Rx1 is received. The output of the BPF 413A is connected to the input port 411a of the switch 411. The BPF 413A is thus provided between the input port 411a and the input terminal of the high frequency electronic component 410B at which the reception signal GSM Rx1 is received. The input of the BPF 413B is connected to an input terminal of the high frequency electronic component 410B at which the reception signal GSM Rx2 is received. The output of the BPF 413B is connected to the input port 411b of the switch 411. The BPF 413B is thus provided between the input port 411b and the input terminal of the high frequency electronic component 410B at which the reception signal GSM Rx2 is received. The high frequency electronic component 410B may be configured to include only one of the BPFs 413A and 413B.

The high frequency electronic component 410C of the third modification example includes the low-noise amplifier 414 and the BPFs 413A and 413B, in addition to the switch 411 and the balun 412. In this high frequency electronic component 410C, the low-noise amplifier 414 and the BPFs 413A and 413B may be mounted on the top surface 420a of the layered substrate 420. The inputs of the low-noise amplifier 414 are connected to the balanced outputs of the balun 412, and the outputs of the low-noise amplifier 414 are connected to the outputs of the high frequency electronic component 410C. The input of the BPF 413A is connected to an input terminal of the high frequency electronic component 410C at which the reception signal GSM Rx1 is received, and the output of the BPF 413A is connected to the input port 411a of the switch 411. The input of the BPF 413B is connected to an input terminal of the high frequency electronic component 410C at which the reception signal GSM Rx2 is received, and the output of the BPF 413B is connected to the input port 411b of the switch 411.

### [Sixth Embodiment]

A high frequency electronic component of a sixth embodiment of the invention will now be described with reference to FIG. 38. FIG. 38 is a block diagram illustrating the circuit configuration of an example of a high frequency circuit including the high frequency electronic component 440 of the sixth embodiment. This high frequency circuit processes two GSM signals and a UMTS signal.

The high frequency circuit shown in FIG. 38 includes the antenna 501, the switch 401 and the IC 402, as in the fifth embodiment. In the sixth embodiment, the IC 402 generates and outputs a UMTS transmission signal UMTS Tx and two GSM transmission signals GSM Tx1 and GSM Tx2. The transmission signal UMTS Tx outputted by the IC 402 is in the form of an unbalanced signal. The two transmission signals GSM Tx1 and GSM Tx2 outputted by the IC 402 are each in the form of a balanced signal. The IC 402 receives a UMTS reception signal UMTS Rx and two GSM reception signals GSM Rx1 and GSM Rx2. The reception signals UMTS Rx, GSM Rx1 and GSM Rx2 received by the IC 402 are each in the form of a balanced signal. The IC 402 has terminals 402a1, 402a2, 402b1, 402b2, 402d, 402e1 and 402e2. The transmission signals GSM Tx1 and GSM Tx2 are outputted from the terminals 402a1 and 402a2. The reception signals GSM Rx1 and GSM Rx2 are received at the terminals 402b1 and 402b2. The transmission signal UMTS Tx is outputted from the terminal 402d. The reception signal UMTS Rx is received at the terminals 402e1 and 402e2.

In the sixth embodiment, in the case where the transmission signal GSM Tx1 and the reception signal GSM Rx1 are a transmission signal and a reception signal of GSM850 (AGSM) among the four systems shown in Table 1, the transmission signal GSM Tx2 and the reception signal GSM Rx2 are a transmission signal and a reception signal of GSM900 (EGSM) whose frequency band is close to that of GSM850 (AGSM), and the transmission signal UMTS Tx and the reception signal UMTS Rx are a transmission signal and a reception signal of the band V, the frequency band of which is the same as that of GSM850 (AGSM), among the 10 bands shown in Table 2.

In the case where the transmission signal GSM Tx1 and the reception signal GSM Rx1 are a transmission signal and a reception signal of GSM900 (EGSM) among the four systems shown in Table 1, the transmission signal GSM Tx2 and the reception signal GSM Rx2 are a transmission signal and a reception signal of GSM850 (AGSM) whose frequency band is close to that of GSM900 (EGSM), and the transmission signal UMTS Tx and the reception signal UMTS Rx are a transmission signal and a reception signal of the band VIII, the frequency band of which is the same as that of GSM900 (EGSM), among the 10 bands shown in Table 2.

In the case where the transmission signal GSM Tx1 and the reception signal GSM Rx1 are a transmission signal and a reception signal of GSM1800 (DCS) among the four systems shown in Table 1, the transmission signal GSM Tx2 and the reception signal GSM Rx2 are a transmission signal and a reception signal of GSM1900 (PCS) whose frequency band is close to that of GSM1800 (DCS), and the transmission signal UMTS Tx and the reception signal UMTS Rx are a transmission signal and a reception signal of the band III, the frequency band of which is the same as that of GSM1800 (DCS), among the 10 bands shown in Table 2.

In the case where the transmission signal GSM Tx1 and the reception signal GSM Rx1 are a transmission signal and a reception signal of GSM1900 (PCS) among the four systems shown in Table 1, the transmission signal GSM Tx2 and the reception signal GSM Rx2 are a transmission signal and a reception signal of GSM1800 (DCS) whose frequency band is close to that of GSM1900 (PCS), and the transmission signal UMTS Tx and the reception signal UMTS Rx are a transmission signal and a reception signal of the band II, the frequency band of which is the same as that of GSM1900 (PCS), among the 10 bands shown in Table 2.

The high frequency circuit of the sixth embodiment does not include the BPF 413A of the fifth embodiment. The high frequency circuit of the sixth embodiment includes the high frequency electronic component 440 of the embodiment, instead of the high frequency electronic component 410 of the fifth embodiment. The high frequency circuit of the sixth embodiment further includes a BPF 407, a power amplifier 408, a duplexer 409, a low-noise amplifier 442 and a BPF 443, in addition to the components of the high frequency circuit of the fifth embodiment.

The high frequency electronic component 440 has input terminals 440a and 440b, output terminals 440c1, 440c2 and 440d, a switch 441, a switch 411, and a balun 412. The switch 441 has an input port 441a and two output ports 441b and 441c, and connects the input port 441a selectively to one of the output ports 441b and 441c. The switch 411 has two input ports 411a and 411b and an output port 411c, and connects the output port 411c selectively to one of the input ports 411a and 411b. The balun 412 has an unbalanced input and two balanced outputs. Of the two switches 411 and 441, the switch 411 corresponds to the switch of the present invention.

The input port 441a of the switch 441 is connected to the input terminal 440a of the high frequency electronic component 440. The output port 441b of the switch 441 is connected to the output terminal 440d of the high frequency electronic component 440. The output port 441c of the switch 441 is connected to the input port 411a of the switch 411. The input port 411b of the switch 411 is connected to the input terminal 440b of the high frequency electronic component 440. The output port 411c of the switch 411 is connected to the unbalanced input of the balun 412. The two balanced outputs of the balun 412 are connected to the output terminals 440c1 and 440c2 of the high frequency electronic component 440.

The duplexer 409 has first to third ports, and two BPFs 409a and 409b. The first port is connected to the port 401b of the switch 401. The BPF 409a is provided between the first and second ports. The BPF 409b is provided between the first and third ports. The second port of the duplexer 409 is connected to the output of the power amplifier 408. The third port of the duplexer 409 is connected to the input terminal 440a of the high frequency electronic component 440.

The BPF 407 has an unbalanced input and an unbalanced output. The unbalanced input of the BPF 407 is connected to the terminal 402d of the IC 402. The unbalanced output of the BPF 407 is connected to the input of the power amplifier 408.

The balun 403 has two balanced inputs and an unbalanced output. The two balanced inputs of the balun 403 are connected to the terminals 402a1 and 402a2 of the IC 402. The power amplifier 404 has an unbalanced input and an unbalanced output. The unbalanced input of the power amplifier 404 is connected to the unbalanced output of the balun 403. The unbalanced output of the power amplifier 404 is connected to the port 401d of the switch 401 via the LPF 405.

The BPF 413B has an unbalanced input and an unbalanced output. The unbalanced input of the BPF 413B is connected to the port 401c of the switch 401. The unbalanced output of the BPF 413B is connected to the input terminal 440b of the high frequency electronic component 440.

The low-noise amplifier 414 has two differential inputs and two differential outputs. The two differential inputs of the low-noise amplifier 414 are connected to the two output terminals 440c1 and 440c2 of the high frequency electronic component 440. The two differential outputs of the low-noise amplifier 414 are connected to the terminals 402b1 and 402b2 of the IC 402.

The low-noise amplifier 442 has an unbalanced input and an unbalanced output. The BPF 443 has an unbalanced input and two balanced outputs. The unbalanced input of the low-noise amplifier 442 is connected to the output terminal 440d of the high frequency electronic component 440. The unbalanced output of the low-noise amplifier 442 is connected to the unbalanced input of the BPF 443. The two balanced outputs of the BPF 443 are connected to the terminals 402e1 and 402e2 of the IC 402.

In the high frequency circuit of the sixth embodiment, the BPF 409b of the duplexer 409, the high frequency electronic component 440, the BPFs 413B and 443 and the low-noise amplifiers 414 and 442 constitute the reception circuit.

The function of the high frequency circuit including the high frequency electronic component 440 of the sixth embodiment will now be described. The IC 402 generates and outputs the transmission signals GSM Tx1 and GSM Tx2 each in the form of a balanced signal, and the transmission signal UMTS Tx in the form of an unbalanced signal.

When transmitting the transmission signal GSM Tx1 or GSM Tx2, the port 401a of the switch 401 is connected to the port 401d. When in this state, the transmission signal GSM Tx1 or GSM Tx2 in the form of a balanced signal outputted by the IC 402 is converted by the balun 403 to a transmission signal GSM Tx1 or GSM Tx2 in the form of an unbalanced signal. This transmission signal passes in succession through the power amplifier 404, the LPF 405 and the switch 401 into the antenna 501, and is transmitted from the antenna 501.

When transmitting the transmission signal UMTS Tx, the port 401a of the switch 401 is connected to the port 401b. When in this state, the transmission signal UMTS Tx outputted by the IC 402 passes in succession through the BPF 407, the power amplifier 408, the BPF 409a of the duplexer 409 and the switch 401 into the antenna 501, and is transmitted from the antenna 501.

When receiving the reception signal GSM Rx1, the port 401a of the switch 401 is connected to the port 401b, the input port 441a of the switch 441 is connected to the output port 441c, and the output port 411c of the switch 411 is connected to the input port 411a. When in this state, the reception signal GSM Rx1 in the form of an unbalanced signal received by the antenna 501 passes in succession through the switch 401, the BPF 409b of the duplexer 409, the switch 441 and the switch 411, and enters the balun 412. The balun 412 converts the reception signal GSM Rx1 in the form of an unbalanced signal outputted from the switch 411 to a reception signal GSM Rx1 in the form of a balanced signal, and outputs this signal to the differential input/output low-noise amplifier 414. The reception signal GSM Rx1 received at the low-noise amplifier 414 is amplified by the low-noise amplifier 414, and enters the IC 402.

When receiving the reception signal GSM Rx2, the port 401a of the switch 401 is connected to the port 401c, and the output port 411c of the switch 411 is connected to the input port 411b. When in this state, the reception signal GSM Rx2 in the form of an unbalanced signal received by the antenna 501 passes in succession through the switch 401, the BPF 413B and the switch 411, and enters the balun 412. The balun 412 converts the reception signal GSM Rx2 in the form of an unbalanced signal outputted from the switch 411 to a reception signal GSM Rx2 in the form of a balanced signal, and outputs this signal to the differential input/output low-noise amplifier 414. The reception signal GSM Rx2 received at the low-noise amplifier 414 is amplified by the low-noise amplifier 414, and enters the IC 402.

When receiving the reception signal UMTS Rx, the port 401a of the switch 401 is connected to the port 401b, and the input port 441a of the switch 441 is connected to the output port 441b. When in this state, the reception signal UMTS Rx in the form of an unbalanced signal received by the antenna 501 passes in succession through the switch 401, the BPF 409b of the duplexer 409 and the switch 441, and is received at the low-noise amplifier 442. The reception signal UMTS Rx received at the low-noise amplifier 442 is amplified by the low-noise amplifier 442, passes through the BPF 443 to be converted to a reception signal UMTS Rx in the form of a balanced signal, and then enters the IC 402.

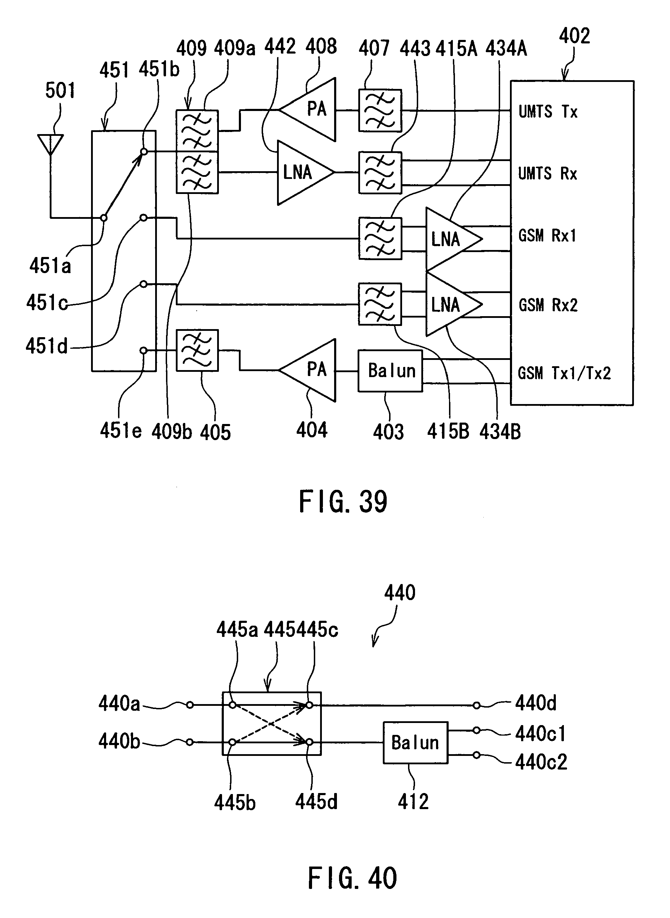

The advantages of the sixth embodiment will now be described with reference to a comparative example. FIG. 39 is a block diagram illustrating the circuit configuration of a high frequency circuit of the comparative example. The high frequency circuit of the comparative example does not have the switch 441, the switch 411 and the balun 412 provided in the high frequency circuit shown in FIG. 38, but has a switch 451 instead of the switch 401 of the high frequency circuit shown in FIG. 38, has two BPFs 415A and 415B instead of the BPF 413B of the high frequency circuit shown in FIG. 38, and has two low-noise amplifiers 434A and 434B instead of the low-noise amplifier 414 of the high frequency circuit shown in FIG. 38.

The switch 451 has five ports 451a, 451b, 451c, 451d and 451e, and connects the port 451a selectively to one of the ports 451b, 451c, 451d and 451e. The port 451a is connected to the antenna 501. The port 451b is connected to the first port of the duplexer 409. The port 451c is connected to the input of the BPF 415A. The port 451d is connected to the input of the BPF 415B. The port 451e is connected to the output of the BPF 405.

The third port of the duplexer 409 is connected to the input of the low-noise amplifier 442. The outputs of the BPF 415A are connected to the inputs of the low-noise amplifier 434A. The outputs of the BPF 415B are connected to the inputs of the low-noise amplifier 434B. Each of the BPFs 415A and 415B outputs a reception signal in the form of a balanced signal. Each of the low-noise amplifiers 434A and 434B is of the differential input/output type.

According to the high frequency circuit of the comparative example, when transmitting the transmission signal GSM Tx1 or GSM Tx2, the port 451a of the switch 451 is connected to the port 451e. When in this state, the transmission signal GSM Tx1 or GSM Tx2 in the form of a balanced signal outputted by the IC 402 is converted by the balun 403 to a transmission signal GSM Tx1 or GSM Tx2 in the form of an unbalanced signal. This transmission signal passes in succession through the power amplifier 404, the LPF 405 and the switch 451 into the antenna 501, and is transmitted from the antenna 501. When transmitting the transmission signal UMTS Tx, the port 451a of the switch 451 is connected to the port 451b. When in this state, the transmission signal UMTS Tx outputted by the IC 402 passes in succession through the BPF 407, the power amplifier 408, the BPF 409a of the duplexer 409 and the switch 451 into the antenna 501, and is transmitted from the antenna 501.

When receiving the reception signal GSM Rx1, the port 451a of the switch 451 is connected to the port 451c. When in this state, the reception signal GSM Rx1 in the form of an unbalanced signal received by the antenna 501 passes through the switch 451, and through the BPF 415A to be converted to a reception signal GSM Rx1 in the form of a balanced signal, and is then amplified by the low-noise amplifier 434A and enters the IC 402.

When receiving the reception signal GSM Rx2, the port 451a of the switch 451 is connected to the port 451d. When in this state, the reception signal GSM Rx2 in the form of an unbalanced signal received by the antenna 501 passes through the switch 451, and through the BPF 415B to be converted to a reception signal GSM Rx2 in the form of a balanced signal. This reception signal is amplified by the low-noise amplifier 434B and enters the IC 402.

When receiving the reception signal UMTS Rx, the port 451a of the switch 451 is connected to the port 451b. When in this state, the reception signal UMTS Rx in the form of an unbalanced signal received by the antenna 501 passes in succession through the switch 451, the BPF 409b of the duplexer 409 and the low-noise amplifier 442, and further through the BPF 443 to be converted to a reception signal UMTS Rx in the form of a balanced signal, and enters the IC 402.

In the high frequency circuit of the comparative example, the BPF 409b of the duplexer 409, the BPFs 415A, 415B and 443 and the low-noise amplifiers 434A, 434B and 442 constitute the reception circuit. The remainder of configuration of the high frequency circuit of the comparative example is the same as that of the high frequency circuit shown in FIG. 38.

The comparative example shown in FIG. 39 requires three low-noise amplifiers, each of which is relatively expensive. This impedes reductions in size and cost of the reception circuit and the high frequency circuit of a cellular phone including the reception circuit. In contrast, according to the sixth embodiment, a single low-noise amplifier 414 is used in common for the two reception signals GSM Rx1 and GSM Rx2. Compared with the comparative example, the sixth embodiment thus allows a reduction in the number of low-noise amplifiers to be included in the reception circuit by one, and thereby allows reductions in size and cost of the reception circuit and the high frequency circuit of a cellular phone including the reception circuit. Furthermore, according to the sixth embodiment, the balun 412 converts the reception signal in the form of an unbalanced signal outputted from the output port 411c of the switch 411 to a reception signal in the form of a balanced signal and outputs this signal to the low-noise amplifier 414. The sixth embodiment thus allows the use of the differential input/output low-noise amplifier 414, thereby allowing an improvement in reception sensitivity. According to the sixth embodiment, while the number of low-noise amplifiers is reduced by one compared with the comparative example, additional switches 441 and 411 for switching between unbalanced signals are required. However, since a switch for switching between unbalanced signals is less expensive than a low-noise amplifier, the sixth embodiment allows a cost reduction compared with the comparative example.

Furthermore, according to the sixth embodiment, a single BPF 409b is used in common for the two reception signals UMTS Rx and GSM Rx1. Compared with the comparative example, the sixth embodiment thus allows a reduction in the number of BPFs by one. This also contributes to reductions in size and cost of the reception circuit and the high frequency circuit of a cellular phone including the reception circuit.

The comparative example shown in FIG. 39 has such a configuration that the reception signal UMTS Rx in the form of an unbalanced signal outputted from the BPF 409b of the duplexer 409 is amplified by the low-noise amplifier 442. For such a configuration, BPF 443 is required in the signal path of the reception signal UMTS Rx between the low-noise amplifier 442 and the IC 402. The reason is as follows. For the TDMA system, the transmission signal and the reception signal are time-divided, whereas for the UMTS, the transmission signal and the reception signal are not time-divided. The UMTS therefore requires very high isolation between the transmission signal and the reception signal. To achieve the high isolation, the BPF 443 is required in the signal path of the reception signal UMTS Rx between the low-noise amplifier 442 and the IC 402.

In the case where the reception signal UMTS Rx in the form of an unbalanced signal is designed to be amplified by the low-noise amplifier 442 as described above, it is not preferable to use any low-noise amplifier in common for the UMTS reception signal UMTS Rx and the GSM reception signals GSM Rx1, GSM Rx2. This is because, if any low-noise amplifier is used in common for the UMTS and GSM reception signals, a BPF is required in the signal path between the low-noise amplifier and the IC 402 in order to achieve high isolation between the UMTS transmission and reception signals, and this BPF causes an increase in loss of the GSM reception signals GSM Rx1 and GSM Rx2. Therefore, in the case where the reception signal UMTS Rx in the form of an unbalanced signal is designed to be amplified by the low-noise amplifier 442, it is preferable that no low-noise amplifier be used in common for the UMTS reception signal UMTS Rx and the GSM reception signals GSM Rx1, GSM Rx2, and that a low-noise amplifier 414 be used in common for the two GSM reception signals GSM Rx1 and GSM Rx2, as shown in FIG. 38.

The high frequency electronic component of the sixth embodiment may include at least one of the low-noise amplifier 414 and the BPF 413B in addition to the switches 441 and 411 and the balun 412, like the first to third modification examples of the fifth embodiment. The high frequency electronic component of the sixth embodiment may include the low-noise amplifier 442, or may include both the low-noise amplifier 442 and the BPF 443.

Reference is now made to FIG. 40 to describe a modification example of the high frequency electronic component 440 of the sixth embodiment. FIG. 40 shows a portion of the high frequency circuit included in the high frequency electronic component 440. The high frequency electronic component 440 of this modification example includes a double-pole, double-throw switch 445 instead of the two switches 411 and 441 of FIG. 38. The switch 445 has two input ports 445a and 445b, and two output ports 445c and 445c. The switch 445 connects the input port 445a selectively to one of the output ports 445c and 445d, and connects the input port 445b selectively to one of the output ports 445c and 445d.

The input sport 445a of the switch 445 is connected to the input terminal 440a of the high frequency electronic component 440. The input port 445b of the switch 445 is connected to the input terminal 440b of the high frequency electronic component 440. The output port 445c of the switch 445 is connected to the output terminal 440d of the high frequency electronic component 440. The output port 445d of the switch 445 is connected to the unbalanced output of the balun 412. The two balanced outputs of the balun 412 are connected to the output terminals 440c1 and 440c2 of the high frequency electronic component 440.

When receiving the reception signal UMTS Rx, the input port 445a of the switch 445 is connected to the output port 445c. When receiving the reception signal GSM Rx1, the input port 445a of the switch 445 is connected to the output port 445d. When receiving the reception signal GSM Rx2, the input port 445b of the switch 445 is connected to the output port 445d.

In the high frequency electronic component 440 shown in FIG. 38, the reception signal GSM Rx1 passes through the two switches 411 and 441, whereas in the modification example of the high frequency electronic component 440 shown in FIG. 40, the reception signal GSM Rx1 passes through only one switch 445. Accordingly, as compared with the high frequency electronic component 440 shown in FIG. 38, the modification example shown in FIG. 40 allows a reduction in loss of the reception signal GSM Rx1.

The remainder of configuration, functions and advantages of the sixth embodiment are similar to those of the fifth embodiment.

### [Seventh Embodiment]

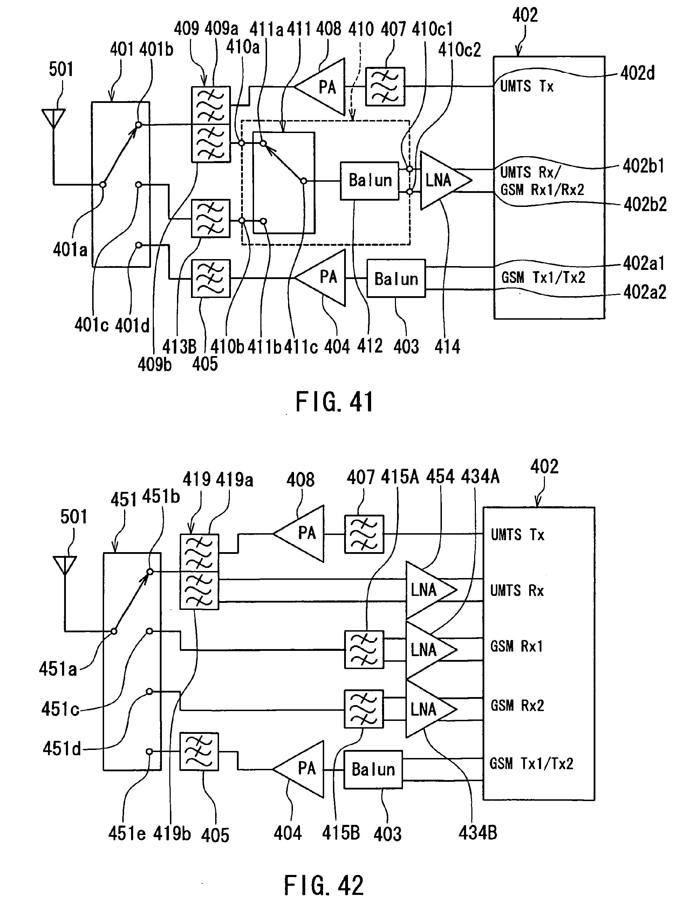

A high frequency electronic component of a seventh embodiment of the invention will now be described with reference to FIG. 41. FIG. 41 is a block diagram illustrating the circuit configuration of an example of a high frequency circuit including the high frequency electronic component 410 of the seventh embodiment. This high frequency circuit processes two GSM signals and a UMTS signal, as in the sixth embodiment.

The high frequency circuit shown in FIG. 41 includes the antenna 501, the switch 401 and the IC 402, as in the fifth and sixth embodiments. In the seventh embodiment, the IC 402 generates and outputs a UMTS transmission signal UMTS Tx and two GSM transmission signals GSM Tx1 and GSM Tx2. The transmission signal UMTS Tx outputted by the IC 402 is in the form of an unbalanced signal. The two transmission signals GSM Tx1 and GSM Tx2 outputted by the IC 402 are each in the form of a balanced signal. The IC 402 receives a UMTS reception signal UMTS Rx and two GSM reception signals GSM Rx1 and GSM Rx2. The reception signals UMTS Rx, GSM Rx1 and GSM Rx2 received by the IC 402 are each in the form of a balanced signal. The IC 402 has terminals 402a1, 402a2, 402b1, 402b2 and 402d. The transmission signal UMTS Tx is outputted from the terminal 402d. The transmission signals GSM Tx1 and GSM Tx2 are outputted from the terminals 402a1 and 402a2. The reception signals UMTS Rx, GSM Rx1 and GSM Rx2 are received at the terminals 402b1 and 402b2. The combinations of the systems and the bands for the transmission signals UMTS Tx, GSM Tx1 and GSM Tx2 and the reception signals UMTS Rx, GSM Rx1 and GSM Rx2 for the seventh embodiment are the same as those for the sixth embodiment.

The high frequency circuit of the seventh embodiment includes the high frequency electronic component 410 of the embodiment, instead of the high frequency electronic component 440 of the sixth embodiment. The high frequency circuit of the seventh embodiment does not include the low-noise amplifier 442 and the BPF 443 of FIG. 38. The remainder of configuration of the high frequency circuit of the seventh embodiment is the same as that of the high frequency circuit of the sixth embodiment shown in FIG. 38.

The high frequency electronic component 410 has input terminals 410a and 410b, output terminals 410c1 and 410c2, a switch 411, and a balun 412. The switch 411 has two input ports 411a and 411b and an output port 411c, and connects the output port 411c selectively to one of the input ports 411a and 411b. The balun 412 has an unbalanced input and two balanced outputs.

The third port of the duplexer 409 is connected to the input terminal 410a of the high frequency electronic component 410. The unbalanced output of the BPF 413B is connected to the input terminal 410b of the high frequency electronic component 410.

The input port 411a of the switch 411 is connected to the input terminal 410a of the high frequency electronic component 410. The input port 411b of the switch 411 is connected to the input terminal 410b of the high frequency electronic component 410. The output port 411c of the switch 411 is connected to the unbalanced input of the balun 412. The two balanced outputs of the balun 412 are connected to the output terminals 410c1 and 410c2 of the high frequency electronic component 410.

The low-noise amplifier 414 has two differential inputs and two differential outputs. The two differential inputs of the low-noise amplifier 414 are connected to the two output terminals 410c1 and 410c2 of the high frequency electronic component 410. The two differential outputs of the low-noise amplifier 414 are connected to the terminals 402b1 and 402b2 of the IC 402.

In the high frequency circuit of the seventh embodiment, the BPF 409b of the duplexer 409, the high frequency electronic component 410, the BPF 413B and the low-noise amplifier 414 constitute the reception circuit.

The function of the high frequency circuit including the high frequency electronic component 410 of the seventh embodiment will now be described. The IC 402 generates and outputs the transmission signals GSM Tx1 and GSM Tx2 each in the form of a balanced signal, and the transmission signal UMTS Tx in the form of an unbalanced signal.

When transmitting the transmission signal GSM Tx1 or GSM Tx2, the port 401a of the switch 401 is connected to the port 401d. When in this state, the transmission signal GSM Tx1 or GSM Tx2 in the form of a balanced signal outputted by the IC 402 is converted by the balun 403 to a transmission signal GSM Tx1 or GSM Tx2 in the form of an unbalanced signal. This transmission signal passes in succession through the power amplifier 404, the LPF 405 and the switch 401 into the antenna 501, and is transmitted from the antenna 501.

When transmitting the transmission signal UMTS Tx, the port 401a of the switch 401 is connected to the port 401b. When in this state, the transmission signal UMTS Tx outputted by the IC 402 passes in succession through the BPF 407, the power amplifier 408, the BPF 409a of the duplexer 409 and the switch 401 into the antenna 501, and is transmitted from the antenna 501.

When receiving the reception signal GSM Rx1, the port 401a of the switch 401 is connected to the port 401b, and the output port 411c of the switch 411 is connected to the input port 411a. When in this state, the reception signal GSM Rx1 in the form of an unbalanced signal received by the antenna 501 passes in succession through the switch 401, the BPF 409b of the duplexer 409 and the switch 411, and enters the balun 412. The balun 412 converts the reception signal GSM Rx1 in the form of an unbalanced signal outputted from the switch 411 to a reception signal GSM Rx1 in the form of a balanced signal, and outputs this signal to the differential input/output low-noise amplifier 414. The reception signal GSM Rx1 received at the low-noise amplifier 414 is amplified by the low-noise amplifier 414, and enters the IC 402.

When receiving the reception signal GSM Rx2, the port 401a of the switch 401 is connected to the port 401c, and the output port 411c of the switch 411 is connected to the input port 411b. When in this state, the reception signal GSM Rx2 in the form of an unbalanced signal received by the antenna 501 passes in succession through the switch 401, the BPF 413B and the switch 411, and enters the balun 412. The balun 412 converts the reception signal GSM Rx2 in the form of an unbalanced signal outputted from the switch 411 to a reception signal GSM Rx2 in the form of a balanced signal, and outputs this signal to the differential input/output low-noise amplifier 414. The reception signal GSM Rx2 received at the low-noise amplifier 414 is amplified by the low-noise amplifier 414, and enters the IC 402.

When receiving the reception signal UMTS Rx, the port 401a of the switch 401 is connected to the port 401b, and the output port 411c of the switch 411 is connected to the input port 411a. When in this state, the reception signal UMTS Rx in the form of an unbalanced signal received by the antenna 501 passes in succession through the switch 401, the BPF 409b of the duplexer 409 and the switch 411, and enters the balun 412. The balun 412 converts the reception signal UMTS Rx in the form of an unbalanced signal outputted from the switch 411 to a reception signal UMTS Rx in the form of a balanced signal, and outputs this signal to the differential input/output low-noise amplifier 414. The reception signal UMTS Rx received at the low-noise amplifier 414 is amplified by the low-noise amplifier 414, and enters the IC 402. The plurality of reception signals received at the input ports 411a and 411b of the switch 411 correspond to the plurality of high frequency signals each in the form of an unbalanced signal in the present invention.

The advantages of the seventh embodiment will now be described with reference to a comparative example. FIG. 42 is a block diagram illustrating the circuit configuration of a high frequency circuit of the comparative example. The high frequency circuit of the comparative example does not have the switch 411 and the balun 412 provided in the high frequency circuit shown in FIG. 41, but has a switch 451 instead of the switch 401 of the high frequency circuit shown in FIG. 41, has a duplexer 419 instead of the duplexer 409 of the high frequency circuit shown in FIG. 41, has two BPFs 415A and 415B instead of the BPF 413B of the high frequency circuit shown in FIG. 41, and has three low-noise amplifiers 434A, 434B and 454 instead of the low-noise amplifier 414 of the high frequency circuit shown in FIG. 41.

The switch 451 has five ports 451a, 451b, 451c, 451d and 451e, and connects the port 451a selectively to one of the ports 451b, 451c, 451d and 451e. The port 451a is connected to the antenna 501. The duplexer 419 has first to third ports, and two BPFs 419a and 419b.

The port 451b is connected to the first port of the duplexer 419. The port 451c is connected to the input of the BPF 415A. The port 451d is connected to the input of the BPF 415B. The port 451e is connected to the output of the BPF 405.

In the duplexer 419, the BPF 419a is provided between the first and second ports, and the BPF 419b is provided between the first and third ports. The second port of the duplexer 419 is connected to the output of the power amplifier 408. The third port of the duplexer 419 outputs a reception signal in the form of a balanced signal. The third port of the duplexer 419 is connected to an input of the low-noise amplifier 454. The low-noise amplifier 454 is of the differential input/output type.

The outputs of the BPF 415A are connected to the inputs of the low-noise amplifier 434A. The outputs of the BPF 415B are connected to the inputs of the low-noise amplifier 434B. Each of the BPFs 415A and 415B outputs a reception signal in the form of a balanced signal. Each of the low-noise amplifiers 434A and 434B is of the differential input/output type.

According to the high frequency circuit of the comparative example, when transmitting the transmission signal GSM Tx1 or GSM Tx2, the port 451a of the switch 451 is connected to the port 451e. When in this state, the transmission signal GSM Tx1 or GSM Tx2 in the form of a balanced signal outputted by the IC 402 is converted by the balun 403 to a transmission signal GSM Tx1 or GSM Tx2 in the form of an unbalanced signal. This transmission signal passes in succession through the power amplifier 404, the LPF 405 and the switch 451 into the antenna 501, and is transmitted from the antenna 501. When transmitting the transmission signal UMTS Tx, the port 451a of the switch 451 is connected to the port 451b. When in this state, the transmission signal UMTS Tx outputted by the IC 402 passes in succession through the BPF 407, the power amplifier 408, the BPF 419a of the duplexer 419 and the switch 451 into the antenna 501, and is transmitted from the antenna 501.

When receiving the reception signal GSM Rx1, the port 451a of the switch 451 is connected to the port 451c. When in this state, the reception signal GSM Rx1 in the form of an unbalanced signal received by the antenna 501 passes through the switch 451, and through the BPF 415A to be converted to a reception signal GSM Rx1 in the form of a balanced signal, and is then amplified by the low-noise amplifier 434A and enters the IC 402.

When receiving the reception signal GSM Rx2, the port 451a of the switch 451 is connected to the port 451d. When in this state, the reception signal GSM Rx2 in the form of an unbalanced signal received by the antenna 501 passes through the switch 451, and through the BPF 415B to be converted to a reception signal GSM Rx2 in the form of a balanced signal, and is then amplified by the low-noise amplifier 434B and enters the IC 402.

When receiving the reception signal UMTS Rx, the port 451a of the switch 451 is connected to the port 451b. When in this state, the reception signal UMTS Rx in the form of an unbalanced signal received by the antenna 501 passes through the switch 451, and through the BPF 419b of the duplexer 419 to be converted to a reception signal UMTS Rx in the form of a balanced signal, and is then amplified by the low-noise amplifier 454 and enters the IC 402.

In the high frequency circuit of the comparative example, the BPF 419b of the duplexer 419, the BPFs 415A and 415B, and the low-noise amplifiers 434A, 434B and 454 constitute the reception circuit. The remainder of configuration of the high frequency circuit of the comparative example is the same as that of the high frequency circuit shown in FIG. 38.

The comparative example shown in FIG. 42 requires three low-noise amplifiers, each of which is relatively expensive. This impedes reductions in size and cost of the reception circuit and the high frequency circuit of a cellular phone including the reception circuit. In contrast, according to the seventh embodiment, a single low-noise amplifier 414 is used in common for the three reception signals UMTS Rx, GSM Rx1 and GSM Rx2. Compared with the comparative example, the seventh embodiment thus allows a reduction in the number of low-noise amplifiers to be included in the reception circuit by two, and thereby allows reductions in size and cost of the reception circuit and the high frequency circuit of a cellular phone including the reception circuit. Furthermore, according to the seventh embodiment, the balun 412 converts the reception signal in the form of an unbalanced signal outputted from the output port 411c of the switch 411 to a reception signal in the form of a balanced signal, and outputs this signal to the low-noise amplifier 414. The seventh embodiment thus allows the use of the differential input/output low-noise amplifier 414, thereby allowing an improvement in reception sensitivity. According to the seventh embodiment, while the number of low-noise amplifiers is reduced by two compared with the comparative example, an additional switch 411 is required. However, since a switch is less expensive than a low-noise amplifier, the seventh embodiment allows a cost reduction compared with the comparative example.

The comparative example shown in FIG. 42 is configured so that the reception signal UMTS Rx in the form of a balanced signal outputted from the BPF 419b of the duplexer 419 is amplified by the low-noise amplifier 454. Such a configuration reduces common mode noise of the reception signal UMTS Rx and thereby improves the reception sensitivity for the reception signal UMTS Rx. It is therefore unnecessary to provide a BPF in the signal path of the reception signal UMTS Rx between the low-noise amplifier 454 and the IC 402.

In the case where a reception signal UMTS Rx in the form of a balanced signal is designed to be amplified by a low-noise amplifier (e.g., 454) as described above, even if the low-noise amplifier 414 is used in common for the UMTS reception signal UMTS Rx and the GSM reception signals GSM Rx1 and GSM Rx2 as in the seventh embodiment, there is no need to provide a BPF in the signal path of the reception signal between the low-noise amplifier 414 and the IC 402 and no increase in loss of the GSM reception signals GSM Rx1 and GSM Rx2 is caused by a BPF

The high frequency electronic component of the seventh embodiment may include at least one of the low-noise amplifier 414 and the BPF 413B in addition to the switch 411 and the balun 412, like the first to third modification examples of the fifth embodiment. The remainder of configuration, functions and advantages of the seventh embodiment are similar to those of the sixth embodiment.

### [Eighth Embodiment]

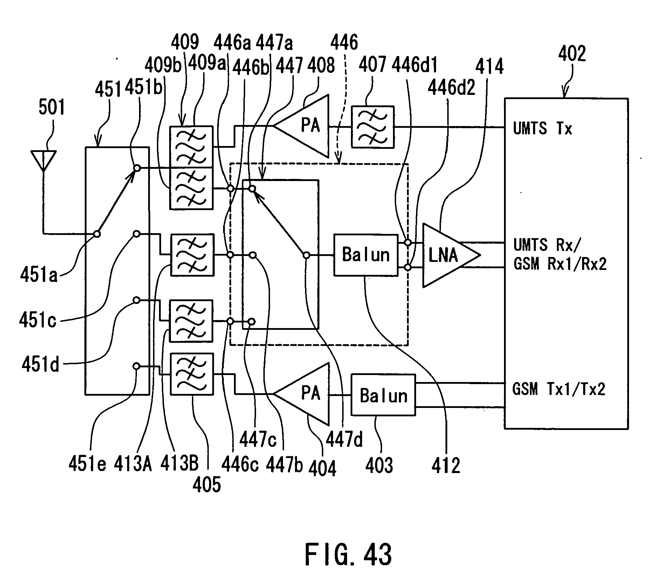

A high frequency electronic component of an eighth embodiment of the invention will now be described with reference to FIG. 43. FIG. 43 is a block diagram illustrating the circuit configuration of an example of a high frequency circuit including the high frequency electronic component 446 of the eighth embodiment. This high frequency circuit processes two GSM signals and a UMTS signal, as in the sixth and seventh embodiments.

The high frequency circuit shown in FIG. 43 includes the antenna 501, a switch 451, and the IC 402. The switch 451 has five ports 451a, 451b, 451c, 451d and 451e, and connects the port 451a selectively to one of the ports 451b, 451c, 451d and 451e. The port 451a is connected to the antenna 501.

In the eighth embodiment, the IC 402 generates and outputs a UMTS transmission signal UMTS Tx and two GSM transmission signals GSM Tx1 and GSM Tx2 as in the seventh embodiment. The transmission signal UMTS Tx outputted by the IC 402 is in the form of an unbalanced signal. The two transmission signals GSM Tx1 and GSM Tx2 outputted by the IC 402 are each in the form of a balanced signal. The IC 402 receives a UMTS reception signal UMTS Rx and two GSM reception signals GSM Rx1 and GSM Rx2 as in the seventh embodiment. The reception signals UMTS Rx, GSM Rx1 and GSM Rx2 received by the IC 402 are each in the form of a balanced signal.

In the eighth embodiment, in the case where the transmission signal GSM Tx1 and the reception signal GSM Rx1 are a transmission signal and a reception signal of one of GSM850 (AGSM) and GSM900 (EGSM), which are two of the four systems shown in Table 1 and are close to each other in frequency band, the transmission signal GSM Tx2 and the reception signal GSM Rx2 are a transmission signal and a reception signal of the other of GSM850 (AGSM) and GSM900 (EGSM). In this case, the transmission signal UMTS Tx and the reception signal UMTS Rx are a transmission signal and a reception signal of one of the bands V, VI and VIII, the frequency bands of which are close to those of GSM850 (AGSM) and GSM900 (ESGM), among the 10 bands shown in Table 2.

In the case where the transmission signal GSM Tx1 and the reception signal GSM Rx1 are a transmission signal and a reception signal of one of GSM1800 (DCS) and GSM1900 (PCS), which are the other two of the four systems shown in Table 1 and are close to each other in frequency band, the transmission signal GSM Tx2 and the reception signal GSM Rx2 are a transmission signal and a reception signal of the other of GSM1800 (DCS) and GSM1900 (PCS). In this case, the transmission signal UMTS Tx and the reception signal UMTS Rx are a transmission signal and a reception signal of one of the bands I, II, III, IV, IX and X, the frequency bands of which are close to those of GSM1800 (DCS) and GSM1900 (PCS), among the 10 bands shown in Table 2.

The high frequency circuit of the eighth embodiment includes the high frequency electronic component 446 of the embodiment, instead of the high frequency electronic component 410 of the seventh embodiment. The high frequency circuit of the eighth embodiment further includes a BPF 413A. The remainder of configuration of the high frequency circuit of the eighth embodiment is the same as that of the high frequency circuit of the seventh embodiment shown in FIG. 41.

The high frequency electronic component 446 has input terminals 446a, 446b and 446c, output terminals 446d1 and 446d2, a switch 447, and a balun 412. The switch 447 has three input ports 447a, 447b and 447c and an output port 447d, and connects the output port 447d selectively to one of the input ports 447a, 447b and 447c. The balun 412 has an unbalanced input and two balanced outputs.

The first port of the duplexer 409 is connected to the port 451b of the switch 451. The second port of the duplexer 409 is connected to the output of the power amplifier 408. The third port of the duplexer 409 is connected to the input terminal 446a of the high frequency electronic component 446.

The unbalanced output of the power amplifier 404 for amplifying the transmission signals GSM Tx1 and GSM Tx2 is connected to the port 451e of the switch 451 via the LPF 405.

Each of the BPFs 413A and 413B has an unbalanced input and an unbalanced output. The inputs of the BPFs 413A and 413B are respectively connected to the ports 451c and 451d of the switch 451. The outputs of the BPFs 413A and 413B are respectively connected to the input terminals 446b and 446c of the high frequency electronic component 446.

The input ports 447a, 447b and 447c of the switch 447 are respectively connected to the input terminals 446a, 446b and 446c of the high frequency electronic component 446. The output port 447d of the switch 447 is connected to the unbalanced input of the balun 412. The two balanced outputs of the balun 412 are connected to the output terminals 446d1 and 446d2 of the high frequency electronic component 446. The two differential inputs of the low-noise amplifier 414 are connected to the two output terminals 446d1 and 446d2 of the high frequency electronic component 446.

In the high frequency circuit of the eighth embodiment, the BPF 409b of the duplexer 409, the high frequency electronic component 446, the BPFs 413A and 413B and the low-noise amplifier 414 constitute the reception circuit.

The function of the high frequency circuit including the high frequency electronic component 446 of the eighth embodiment will now be described. The IC 402 generates and outputs the transmission signals GSM Tx1 and GSM Tx2 each in the form of a balanced signal, and the transmission signal UMTS Tx in the form of an unbalanced signal.

When transmitting the transmission signal GSM Tx1 or GSM Tx2, the port 451a of the switch 451 is connected to the port 451e. When in this state, the transmission signal GSM Tx1 or GSM Tx2 in the form of a balanced signal outputted by the IC 402 is converted by the balun 403 to a transmission signal GSM Tx1 or GSM Tx2 in the form of an unbalanced signal. This transmission signal passes in succession through the power amplifier 404, the LPF 405 and the switch 451 into the antenna 501, and is transmitted from the antenna 501.

When transmitting the transmission signal UMTS Tx, the port 451a of the switch 451 is connected to the port 451b. When in this state, the transmission signal UMTS Tx outputted by the IC 402 passes in succession through the BPF 407, the power amplifier 408, the BPF 409a of the duplexer 409 and the switch 451 into the antenna 501, and is transmitted from the antenna 501.

When receiving the reception signal GSM Rx1, the port 451a of the switch 451 is connected to the port 451c, and the output port 447d of the switch 447 is connected to the input port 447b. When in this state, the reception signal GSM Rx1 received by the antenna 501 passes in succession through the switch 451, the BPF 413A and the switch 447, and enters the balun 412. The balun 412 converts the reception signal GSM Rx1 in the form of an unbalanced signal outputted from the switch 447 to a reception signal GSM Rx1 in the form of a balanced signal, and outputs this signal to the differential input/output low-noise amplifier 414. The reception signal GSM Rx1 received at the low-noise amplifier 414 is amplified by the low-noise amplifier 414, and enters the IC 402.

When receiving the reception signal GSM Rx2, the port 451a of the switch 451 is connected to the port 451d, and the output port 447d of the switch 447 is connected to the input port 447c. When in this state, the reception signal GSM Rx2 received by the antenna 501 passes in succession through the switch 451, the BPF 413B and the switch 447, and enters the balun 412. The balun 412 converts the reception signal GSM Rx2 in the form of an unbalanced signal outputted from the switch 447 to a reception signal GSM Rx2 in the form of a balanced signal, and outputs this signal to the differential input/output low-noise amplifier 414. The reception signal GSM Rx2 received at the low-noise amplifier 414 is amplified by the low-noise amplifier 414, and enters the IC 402.

When receiving the reception signal UMTS Rx, the port 451a of the switch 451 is connected to the port 451b, and the output port 447d of the switch 447 is connected to the input port 447a. When in this state, the reception signal UMTS Rx in the form of an unbalanced signal received by the antenna 501 passes in succession through the switch 451, the BPF 409b of the duplexer 409 and the switch 447, and enters the balun 412. The balun 412 converts the reception signal UMTS Rx in the form of an unbalanced signal outputted from the switch 447 to a reception signal UMTS Rx in the form of a balanced signal, and outputs this signal to the differential input/output low-noise amplifier 414. The reception signal UMTS Rx received at the low-noise amplifier 414 is amplified by the low-noise amplifier 414, and enters the IC 402. The plurality of reception signals received at the input ports 447a, 447b and 447c of the switch 447 correspond to the plurality of high frequency signals each in the form of an unbalanced signal in the present invention.

According to the eighth embodiment, a single low-noise amplifier 414 is used in common for the three reception signals UMTS Rx, GSM Rx1 and GSM Rx2. The eighth embodiment thus requires only one low-noise amplifier in the reception circuit, thereby allowing reductions in size and cost of the reception circuit and the high frequency circuit of a cellular phone including the reception circuit. Furthermore, according to the eighth embodiment, the balun 412 converts the reception signal in the form of an unbalanced signal outputted from the output port 447d of the switch 447 to a reception signal in the form of a balanced signal, and outputs this signal to the low-noise amplifier 414. The eighth embodiment thus allows the use of the differential input/output low-noise amplifier 414, thereby allowing an improvement in reception sensitivity.

The high frequency electronic component of the eighth embodiment may include at least one of the low-noise amplifier 414 and the BPFs 413A and 413B in addition to the switch 411 and the balun 412, like the first to third modification examples of the fifth embodiment. The remainder of configuration, functions and advantages of the eighth embodiment are similar to those of the seventh embodiment.

### [Ninth Embodiment]

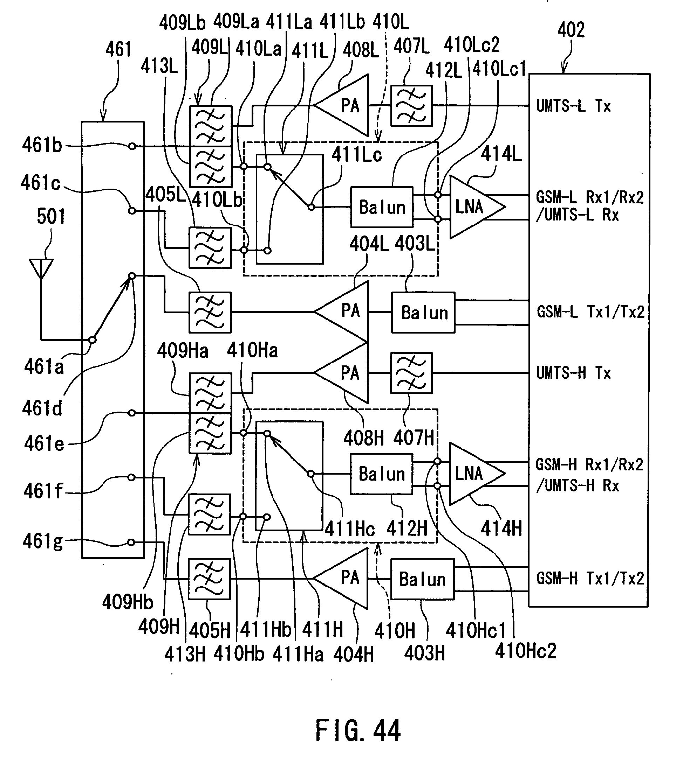

A high frequency electronic component of a ninth embodiment of the invention will now be described with reference to FIG. 44. FIG. 44 shows a high frequency circuit including two high frequency electronic components 410L and 410H of the ninth embodiment. This high frequency circuit processes four GSM signals and two UMTS signals.

The high frequency circuit shown in FIG. 44 includes the antenna 501, a switch 461, and the IC 402. The switch 461 has seven ports 461a, 461b, 461c, 461d, 461e, 461f and 461g, and connects the port 461a selectively to one of the ports 461b, 461c, 461d, 461e, 461f and 461g. The port 461a is connected to the antenna 501.

In the ninth embodiment, the IC 402 generates and outputs two UMTS transmission signals UMTS-L Tx and UMTS-H Tx, and four GSM transmission signals GSM-L Tx1, GSM-L Tx2, GSM-H Tx1 and GSM-H Tx2. The two UMTS transmission signals UMTS-L Tx and UMTS-H Tx outputted by the IC 402 are each in the form of an unbalanced signal. The four GSM transmission signals GSM-L Tx1, GSM-L Tx2, GSM-H Tx1 and GSM-H Tx2 outputted by the IC 402 are each in the form of a balanced signal. The IC 402 receives two UMTS reception signals UMTS-L Rx and UMTS-H Rx, and four GSM reception signals GSM-L Rx1, GSM-L Rx2, GSM-H Rx1 and GSM-H Rx2. The reception signals UMTS-L Rx, UMTS-H Rx, GSM-L Rx1, GSM-L Rx2, GSM-H Rx1 and GSM-H Rx2 received by the IC 402 are each in the form of a balanced signal.

In the ninth embodiment, the transmission signal GSM-L Tx1 and the reception signal GSM-L Rx1 are a transmission signal and a reception signal of one of GSM850 (AGSM) and GSM900 (EGSM), which are close to each other in frequency band, among the four systems shown in Table 1.

In the case where the transmission signal GSM-L Tx1 and the reception signal GSM-L Rx1 are a transmission signal and a reception signal of GSM850 (AGSM), the transmission signal GSM-L Tx2 and the reception signal GSM-L Rx2 are a transmission signal and a reception signal of GSM900 (EGSM) whose frequency band is close to that of GSM850 (AGSM), and the transmission signal UMTS-L Tx and the reception signal UMTS-L Rx are a transmission signal and a reception signal of the band V, among the 10 bands shown in Table 2, the frequency band of which is the same as that of GSM850 (AGSM).

In the case where the transmission signal GSM-L Tx1 and the reception signal GSM-L Rx1 are a transmission signal and a reception signal of GSM900 (EGSM), the transmission signal GSM-L Tx2 and the reception signal GSM-L Rx2 are a transmission signal and a reception signal of GSM850 (AGSM) whose frequency band is close to that of GSM900 (EGSM), and the transmission signal UMTS-L Tx and the reception signal UMTS-L Rx are a transmission signal and a reception signal of the band VIII, among the 10 bands shown in Table 2, the frequency band of which is the same as that of GSM900 (EGSM).

The transmission signal GSM-H Tx1 and the reception signal GSM-H Rx1 are a transmission signal and a reception signal of one of GSM1800 (DCS) and GSM1900 (PCS), which are close to each other in frequency band, among the four systems shown in Table 1.

In the case where the transmission signal GSM-H Tx1 and the reception signal GSM-H Rx1 are a transmission signal and a reception signal of GSM1800 (DCS), the transmission signal GSM-H Tx2 and the reception signal GSM-H Rx2 are a transmission signal and a reception signal of GSM1900 (PCS) whose frequency band is close to that of GSM1800 (DCS), and the transmission signal UMTS-H Tx and the reception signal UMTS-H Rx are a transmission signal and a reception signal of the band III, among the 10 bands shown in Table 2, the frequency band of which is the same as that of GSM1800 (DCS).

In the case where the transmission signal GSM-H Tx1 and the reception signal GSM-H Rx1 are a transmission signal and a reception signal of GSM1900 (PCS), the transmission signal GSM-H Tx2 and the reception signal GSM-H Rx2 are a transmission signal and a reception signal of GSM1800 (DCS) whose frequency band is close to that of GSM1900 (PCS), and the transmission signal UMTS-H Tx and the reception signal UMTS-H Rx are a transmission signal and a reception signal of the band II, among the 10 bands shown in Table 2, the frequency band of which is the same as that of GSM1900 (PCS).

The high frequency circuit of the ninth embodiment includes: the two high frequency electronic components 410L and 410H of the embodiment; two duplexers 409L and 409H; four BPFs 407L, 407H, 413L and 413H; two LPFs 405L and 405H; two baluns 403L and 403H; four power amplifiers 404L, 404H, 408L and 408H; and two low-noise amplifiers 414L and 414H.

The high frequency electronic component 410L has input terminals 410La and 410Lb, output terminals 410Lc1 and 410Lc2, a switch 411L, and a balun 412L. The switch 411L has two input ports 411La and 411Lb and an output port 411Lc, and connects the output port 411Lc selectively to one of the input ports 411La and 411Lb. The balun 412L has an unbalanced input and two balanced outputs.

The input port 411La of the switch 411L is connected to the input terminal 410La of the high frequency electronic component 410L. The input port 411Lb of the switch 411L is connected to the input terminal 410Lb of the high frequency electronic component 410L. The output port 411Lc of the switch 411L is connected to the unbalanced input of the balun 412L. The two balanced outputs of the balun 412L are connected to the output terminals 410Lc1 and 410Lc2 of the high frequency electronic component 410L.

The high frequency electronic component 410H has input terminals 410Ha and 410Hb, output terminals 410Hc1 and 410Hc2, a switch 411H, and a balun 412H. The switch 411H has two input ports 411Ha and 411Hb and an output port 411Hc, and connects the output port 411Hc selectively to one of the input ports 411Ha and 411Hb. The balun 412H has an unbalanced input and two balanced outputs.

The input port 411Ha of the switch 411H is connected to the input terminal 410Ha of the high frequency electronic component 410H. The input port 411Hb of the switch 411H is connected to the input terminal 410Hb of the high frequency electronic component 410H. The output port 411Hc of the switch 411H is connected to the unbalanced input of the balun 412H. The two balanced outputs of the balun 412H are connected to the output terminals 410Hc1 and 410Hc2 of the high frequency electronic component 410H.

The duplexer 409L has first to third ports and two BPFs 409La and 409Lb. The first port is connected to the port 461b of the switch 461. The BPF 409La is provided between the first and second ports. The BPF 409Lb is provided between the first and third ports. The second port of the duplexer 409L is connected to the output of the power amplifier 408L. The third port of the duplexer 409L is connected to the input terminal 410La of the high frequency electronic component 410L.

The duplexer 409H has first to third ports and two BPFs 409Ha and 409Hb. The first port is connected to the port 461e of the switch 461. The BPF 409Ha is provided between the first and second ports. The BPF 409Hb is provided between the first and third ports. The second port of the duplexer 409H is connected to the output of the power amplifier 408H. The third port of the duplexer 409H is connected to the input terminal 410Ha of the high frequency electronic component 410H.

Each of the BPFs 407L and 407H has an unbalanced input and an unbalanced output. The unbalanced inputs of the BPFs 407L and 407H respectively receive the transmission signals UMTS-L Tx and UMTS-H Tx each in the form of an unbalanced signal outputted from the IC 402. The unbalanced outputs of the BPFs 407L and 407H are respectively connected to the inputs of the power amplifiers 408L and 408H.

Each of the baluns 403L and 403H has two balanced inputs and an unbalanced output. The two balanced inputs of the balun 403L receive the transmission signal GSM-L Tx1 or GSM-L Tx2 outputted from the IC 402. The two balanced inputs of the balun 403H receive the transmission signal GSM-H Tx1 or GSM-H Tx2 outputted from the IC 402. Each of the power amplifiers 404L and 404H has an unbalanced input and an unbalanced output. The unbalanced inputs of the power amplifiers 404L and 404H are respectively connected to the unbalanced outputs of the baluns 403L and 403H. The unbalanced outputs of the power amplifiers 404L and 404H are respectively connected to the ports 461d and 461g of the switch 461 via the LPFs 405L and 405H.

Each of the BPFs 413L and 413H has an unbalanced input and an unbalanced output. The unbalanced inputs of the BPFs 413L and 413H are respectively connected to the ports 461c and 461f of the switch 461. The unbalanced output of the BPF 413L is connected to the input terminal 410Lb of the high frequency electronic component 410L, and the unbalanced output of the BPF 413H is connected to the input terminal 410Hb of the high frequency electronic component 410H.

The low-noise amplifier 414L has two differential inputs and two differential outputs. The two differential inputs of the low-noise amplifier 414L are connected to the two output terminals 410Lc1 and 410Lc2 of the high frequency electronic component 410L. The two differential outputs of the low-noise amplifier 414L output a reception signal in the form of a balanced signal to the IC 402.

The low-noise amplifier 414H has two differential inputs and two differential outputs. The two differential inputs of the low-noise amplifier 414H are connected to the two output terminals 410Hc1 and 410Hc2 of the high frequency electronic component 410H. The two differential outputs of the low-noise amplifier 414H output a reception signal in the form of a balanced signal to the IC 402.

In the high frequency circuit of the ninth embodiment, the BPF 409Lb of the duplexer 409L, the BPF 409Hb of the duplexer 409H, the high frequency electronic components 410L and 410H, the BPFs 413L and 413H and the low-noise amplifiers 414L and 414H constitute the reception circuit.

The function of the high frequency circuit including the high frequency electronic components 410L and 410H of the ninth embodiment will now be described. The IC 402 generates and outputs the transmission signals GSM-L Tx1, GSM-L Tx2, GSM-H Tx1 and GSM-H Tx2 each in the form of a balanced signal, and the transmission signals UMTS-L Tx and UMTS-H Tx each in the form of an unbalanced signal.

When transmitting the transmission signal GSM-L Tx1 or GSM-L Tx2, the port 461a of the switch 461 is connected to the port 461d. When in this state, the transmission signal GSM-L Tx1 or GSM-L Tx2 in the form of a balanced signal outputted by the IC 402 is converted by the balun 403L to a transmission signal GSM-L Tx1 or GSM-L Tx2 in the form of an unbalanced signal. This transmission signal passes in succession through the power amplifier 404L, the LPF 405L and the switch 461 into the antenna 501, and is transmitted from the antenna 501.

When transmitting the transmission signal UMTS-L Tx, the port 461a of the switch 461 is connected to the port 461b. When in this state, the transmission signal UMTS-L Tx outputted from the IC 402 passes in succession through the BPF 407L, the power amplifier 408L, the BPF 409La of the duplexer 409L and the switch 461 into the antenna 501, and is transmitted from the antenna 501.

When transmitting the transmission signal GSM-H Tx1 or GSM-H Tx2, the port 461a of the switch 461 is connected to the port 461g. When in this state, the transmission signal GSM-H Tx1 or GSM-H Tx2 in the form of a balanced signal outputted by the IC 402 is converted by the balun 403H to a transmission signal GSM-H Tx1 or GSM-H Tx2 in the form of an unbalanced signal. This transmission signal passes in succession through the power amplifier 404H, the LPF 405H and the switch 461 into the antenna 501, and is transmitted from the antenna 501.

When transmitting the transmission signal UMTS-H Tx, the port 461a of the switch 461 is connected to the port 461e. When in this state, the transmission signal UMTS-H Tx outputted from the IC 402 passes in succession through the BPF 407H, the power amplifier 408H, the BPF 409Ha of the duplexer 409H and the switch 461 into the antenna 501, and is transmitted from the antenna 501.

When receiving the reception signal GSM-L Rx1, the port 461a of the switch 461 is connected to the port 461b, and the output port 411Lc of the switch 411L is connected to the input port 411La. When in this state, the reception signal GSM-L Rx1 in the form of an unbalanced signal received by the antenna 501 passes in succession through the switch 461, the BPF 409Lb of the duplexer 409L and the switch 411L, and enters the balun 412L. The balun 412L converts the reception signal GSM-L Rx1 in the form of an unbalanced signal outputted from the switch 411L to a reception signal GSM-L Rx1 in the form of a balanced signal, and outputs this signal to the differential input/output low-noise amplifier 414L. The reception signal GSM-L Rx1 received at the low-noise amplifier 414L is amplified by the low-noise amplifier 414L, and enters the IC 402.

When receiving the reception signal GSM-L Rx2, the port 461a of the switch 461 is connected to the port 461c, and the output port 411Lc of the switch 411L is connected to the input port 411Lb. When in this state, the reception signal GSM-L Rx2 in the form of an unbalanced signal received by the antenna 501 passes in succession through the switch 461, the BPF 413L and the switch 411L, and enters the balun 412L. The balun 412L converts the reception signal GSM-L Rx2 in the form of an unbalanced signal outputted from the switch 411L to a reception signal GSM-L Rx2 in the form of a balanced signal, and outputs this signal to the differential input/output low-noise amplifier 414L. The reception signal GSM-L Rx2 received at the low-noise amplifier 414L is amplified by the low-noise amplifier 414L, and enters the IC 402.

When receiving the reception signal UMTS-L Rx, the port 461a of the switch 461 is connected to the port 461b, and the output port 411Lc of the switch 411L is connected to the input port 411La. When in this state, the reception signal UMTS-L Rx in the form of an unbalanced signal received by the antenna 501 passes in succession through the switch 461, the BPF 409Lb of the duplexer 409L and the switch 411L, and enters the balun 412L. The balun 412L converts the reception signal UMTS-L Rx in the form of an unbalanced signal outputted from the switch 411L to a reception signal UMTS-L Rx in the form of a balanced signal, and outputs this signal to the differential input/output low-noise amplifier 414L. The reception signal UMTS-L Rx received at the low-noise amplifier 414L is amplified by the low-noise amplifier 414L, and enters the IC 402. The plurality of reception signals received at the input ports 411La and 411Lb of the switch 411L correspond to the plurality of high frequency signals each in the form of an unbalanced signal in the present invention.

When receiving the reception signal GSM-H Rx1, the port 461a of the switch 461 is connected to the port 461e, and the output port 411Hc of the switch 411H is connected to the input port 411Ha. When in this state, the reception signal GSM-H Rx1 in the form of an unbalanced signal received by the antenna 501 passes in succession through the switch 461, the BPF 409Hb of the duplexer 409H and the switch 411H, and enters the balun 412H. The balun 412H converts the reception signal GSM-H Rx1 in the form of an unbalanced signal outputted from the switch 411H to a reception signal GSM-H Rx1 in the form of a balanced signal, and outputs this signal to the differential input/output low-noise amplifier 414H. The reception signal GSM-H Rx1 received at the low-noise amplifier 414H is amplified by the low-noise amplifier 414H, and enters the IC 402.

When receiving the reception signal GSM-H Rx2, the port 461a of the switch 461 is connected to the port 461f, and the output port 411Hc of the switch 411H is connected to the input port 411Hb. When in this state, the reception signal GSM-H Rx2 in the form of an unbalanced signal received by the antenna 501 passes in succession through the switch 461, the BPF 413H and the switch 411H, and enters the balun 412H. The balun 412H converts the reception signal GSM-H Rx2 in the form of an unbalanced signal outputted from the switch 411H to a reception signal GSM-H Rx2 in the form of a balanced signal, and outputs this signal to the differential input/output low-noise amplifier 414H. The reception signal GSM-H Rx2 received at the low-noise amplifier 414H is amplified by the low-noise amplifier 414H, and enters the IC 402.

When receiving the reception signal UMTS-H Rx, the port 461a of the switch 461 is connected to the port 461e, and the output port 411Hc of the switch 411H is connected to the input port 411Ha. When in this state, the reception signal UMTS-H Rx in the form of an unbalanced signal received by the antenna 501 passes in succession through the switch 461, the BPF 409Hb of the duplexer 409H and the switch 411H, and enters the balun 412H. The balun 412H converts the reception signal UMTS-H Rx in the form of an unbalanced signal outputted from the switch 411H to a reception signal UMTS-H Rx in the form of a balanced signal, and outputs this signal to the differential input/output low-noise amplifier 414H. The reception signal UMTS-H Rx received at the low-noise amplifier 414H is amplified by the low-noise amplifier 414H, and enters the IC 402. The plurality of reception signals received at the input ports 411Ha and 411Hb of the switch 411H correspond to the plurality of high frequency signals each in the form of an unbalanced signal in the present invention.

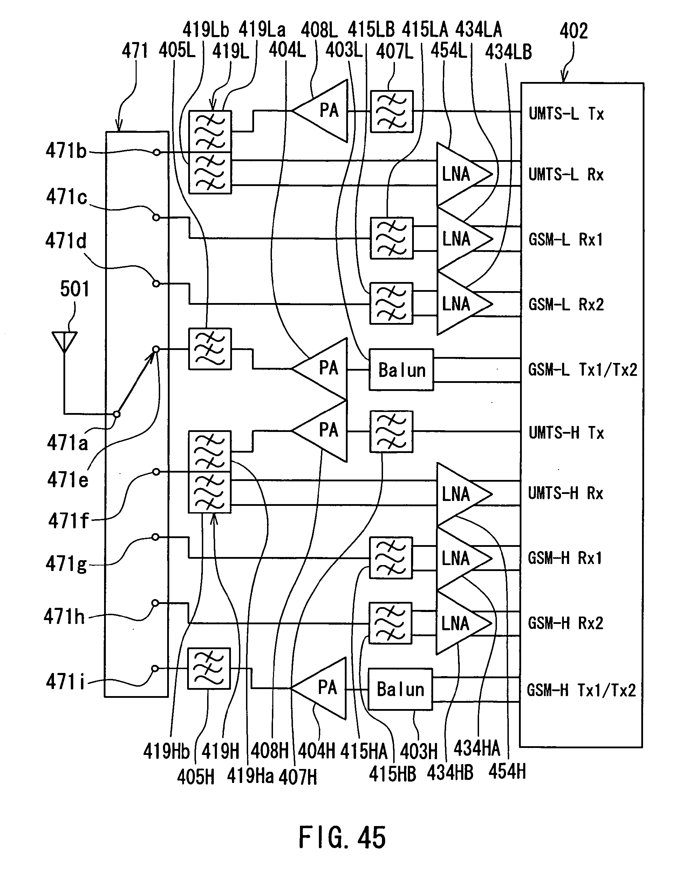

The advantages of the ninth embodiment will now be described with reference to a comparative example. FIG. 45 is a block diagram illustrating the circuit configuration of a high frequency circuit of the comparative example. The high frequency circuit of the comparative example does not have the switches 411L and 411H and the baluns 412L and 412H provided in the high frequency circuit shown in FIG. 44, but has a switch 471 instead of the switch 461 of the high frequency circuit shown in FIG. 44, and has duplexers 419L and 419H instead of the duplexers 409L and 409H of the high frequency circuit shown in FIG. 44. Furthermore, the high frequency circuit of the comparative example has two BPFs 415LA and 415LB instead of the BPF 413L of the high frequency circuit shown in FIG. 44, has two BPFs 415HA and 415HB instead of the BPF 413H of the high frequency circuit shown in FIG. 44, has three low-noise amplifiers 434LA, 434LB and 454L instead of the low-noise amplifier 414L of the high frequency circuit shown in FIG. 44, and has three low-noise amplifiers 434HA, 434HB and 454H instead of the low-noise amplifier 414H of the high frequency circuit shown in FIG. 44.

The switch 471 has nine ports 471a, 471b, 471c, 471d, 471e, 471f, 471g, 471h and 471i, and connects the port 471a selectively to one of the ports 471b, 471c, 471d, 471e, 471f, 471g, 471h and 471i. The port 471a is connected to the antenna 501. The duplexer 419L has first to third ports, and two BPFs 419La and 419Lb. The duplexer 419H has first to third ports, and two BPFs 419Ha and 419Hb.

The port 471b is connected to the first port of the duplexer 419L. The port 471c is connected to the input of the BPF 415LA. The port 471d is connected to the input of the BPF 415LB. The port 471e is connected to the output of the BPF 405L. The port 471f is connected to the first port of the duplexer 419H. The port 471g is connected to the input of the BPF 415HA. The port 471h is connected to the input of the BPF 415HB. The port 471i is connected to the output of the BPF 405H.

In the duplexer 419L, the BPF 419La is provided between the first and second ports, and the BPF 419Lb is provided between the first and third ports. The second port of the duplexer 419L is connected to the output of the power amplifier 408L. The third port of the duplexer 419L outputs a reception signal in the form of a balanced signal. The third port of the duplexer 419L is connected to an input of the low-noise amplifier 454L. The low-noise amplifier 454L is of the differential input/output type.

In the duplexer 419H, the BPF 419Ha is provided between the first and second ports, and the BPF 419Hb is provided between the first and third ports. The second port of the duplexer 419H is connected to the output of the power amplifier 408H. The third port of the duplexer 419H outputs a reception signal in the form of a balanced signal. The third port of the duplexer 419H is connected to an input of the low-noise amplifier 454H. The low-noise amplifier 454H is of the differential input/output type.

The outputs of the BPF 415LA are connected to the inputs of the low-noise amplifier 434LA. The outputs of the BPF 415LB are connected to the inputs of the low-noise amplifier 434LB. Each of the BPFs 415LA and 415LB outputs a reception signal in the form of a balanced signal. Each of the low-noise amplifiers 434LA and 434LB is of the differential input/output type.

The outputs of the BPF 415HA are connected to the inputs of the low-noise amplifier 434HA. The outputs of the BPF 415HB are connected to the inputs of the low-noise amplifier 434HB. Each of the BPFs 415HA and 415HB outputs a reception signal in the form of a balanced signal. Each of the low-noise amplifiers 434HA and 434HB is of the differential input/output type.

According to the high frequency circuit of the comparative example, when transmitting the transmission signal GSM-L Tx1 or GSM-L Tx2, the port 471a of the switch 471 is connected to the port 471e. When in this state, the transmission signal GSM-L Tx1 or GSM-L Tx2 in the form of a balanced signal outputted by the IC 402 is converted by the balun 403L to a transmission signal GSM-L Tx1 or GSM-L Tx2 in the form of an unbalanced signal. This transmission signal passes in succession through the power amplifier 404L, the LPF 405L and the switch 471 into the antenna 501, and is transmitted from the antenna 501. When transmitting the transmission signal UMTS-L Tx, the port 471a of the switch 471 is connected to the port 471b. When in this state, the transmission signal UMTS-L Tx outputted by the IC 402 passes in succession through the BPF 407L, the power amplifier 408L, the BPF 419La of the duplexer 419L and the switch 471 into the antenna 501, and is transmitted from the antenna 501.

When receiving the reception signal GSM-L Rx1, the port 471a of the switch 471 is connected to the port 471c. When in this state, the reception signal GSM-L Rx1 in the form of an unbalanced signal received by the antenna 501 passes through the switch 471, and through the BPF 415LA to be converted to a reception signal GSM-L Rx1 in the form of a balanced signal, and is then amplified by the low-noise amplifier 434LA and enters the IC 402. When receiving the reception signal GSM-L Rx2, the port 471a of the switch 471 is connected to the port 471d. When in this state, the reception signal GSM-L Rx2 in the form of an unbalanced signal received by the antenna 501 passes through the switch 471, and through the BPF 415LB to be converted to a reception signal GSM-L Rx2 in the form of a balanced signal, and is then amplified by the low-noise amplifier 434LB and enters the IC 402. When receiving the reception signal UMTS-L Rx, the port 471a of the switch 471 is connected to the port 471b. When in this state, the reception signal UMTS-L Rx in the form of an unbalanced signal received by the antenna 501 passes through the switch 471, and through the BPF 419Lb of the duplexer 419L to be converted to a reception signal UMTS-L Rx in the form of a balanced signal, and is then amplified by the low-noise amplifier 454L and enters the IC 402.

When transmitting the transmission signal GSM-H Tx1 or GSM-H Tx2, the port 471a of the switch 471 is connected to the port 471i. When in this state, the transmission signal GSM-H Tx1 or GSM-H Tx2 in the form of a balanced signal outputted by the IC 402 is converted by the balun 403H to a transmission signal GSM-H Tx1 or GSM-L Tx2 in the form of an unbalanced signal. This transmission signal passes in succession through the power amplifier 404H, the LPF 405H and the switch 471 into the antenna 501, and is transmitted from the antenna 501. When transmitting the transmission signal UMTS-H Tx, the port 471a of the switch 471 is connected to the port 471f. When in this state, the transmission signal UMTS-H Tx outputted from the IC 402 passes in succession through the BPF 407H, the power amplifier 408H, the BPF 419Ha of the duplexer 419H and the switch 471 into the antenna 501, and is transmitted from the antenna 501.

When receiving the reception signal GSM-H Rx1, the port 471a of the switch 471 is connected to the port 471g. When in this state, the reception signal GSM-H Rx1 in the form of an unbalanced signal received by the antenna 501 passes through the switch 471, and through the BPF 415HA to be converted to a reception signal GSM-H Rx1 in the form of a balanced signal, and is then amplified by the low-noise amplifier 434HA and enters the IC 402. When receiving the reception signal GSM-H Rx2, the port 471a of the switch 471 is connected to the port 471h. When in this state, the reception signal GSM-H Rx2 in the form of an unbalanced signal received by the antenna 501 passes through the switch 471, and through the BPF 415HB to be converted to a reception signal GSM-H Rx2 in the form of a balanced signal, and is then amplified by the low-noise amplifier 434HB and enters the IC 402. When receiving the reception signal UMTS-H Rx, the port 471a of the switch 471 is connected to the port 471f. When in this state, the reception signal UMTS-H Rx in the form of an unbalanced signal received by the antenna 501 passes through the switch 471, and through the BPF 419Hb of the duplexer 419H to be converted to a reception signal UMTS-H Rx in the form of a balanced signal, and is then amplified by the low-noise amplifier 454H and enters the IC 402.

In the high frequency circuit of the comparative example, the BPF 419Lb of the duplexer 419L, the BPF 419Hb of the duplexer 419H, the BPFs 415LA, 415LB, 415HA and 415HB and the low-noise amplifiers 434LA, 434LB, 434HA, 434HB, 454L and 454H constitute the reception circuit. The remainder of configuration of the high frequency circuit of the comparative example is the same as that of the high frequency circuit shown in FIG. 44.

The comparative example shown in FIG. 45 requires six low-noise amplifiers, each of which is relatively expensive. This impedes reductions in size and cost of the reception circuit and the high frequency circuit of a cellular phone including the reception circuit. In contrast, according to the ninth embodiment, a single low-noise amplifier 414L is used in common for the three reception signals UMTS-L Rx, GSM-L Rx1 and GSM-L Rx2, and a single low-noise amplifier 414H is used in common for the three reception signals UMTS-H Rx, GSM-H Rx1 and GSM-H Rx2. Compared with the comparative example, the ninth embodiment thus allows a reduction in the number of low-noise amplifiers to be included in the reception circuit by four, and thereby allows reductions in size and cost of the reception circuit and the high frequency circuit of a cellular phone including the reception circuit. Furthermore, according to the ninth embodiment, the baluns 412L and 412H convert the reception signals each in the form of an unbalanced signal outputted from the output ports 411Lc and 411Hc of the switches 411L and 411H, respectively, to reception signals each in the form of a balanced signal, and output these signals to the low-noise amplifiers 414L and 414H, respectively. The ninth embodiment thus allows the use of the differential input/output low-noise amplifiers 414L and 414H, thereby allowing an improvement in reception sensitivity According to the ninth embodiment, while the number of low-noise amplifiers is reduced by four compared with the comparative example, additional switches 411L and 411H are required. However, since a switch is less expensive than a low-noise amplifier, the ninth embodiment allows a cost reduction compared with the comparative example.

The high frequency electronic component 410L of the ninth embodiment may include at least one of the low-noise amplifier 414L and the BPF 413L in addition to the switch 411L and the balun 412L, like the first to third modification examples of the fifth embodiment. Similarly, the high frequency electronic component 410H of the ninth embodiment may include at least one of the low-noise amplifier 414H and the BPF 413H in addition to the switch 411H and the balun 412H. The remainder of configuration, functions and advantages of the ninth embodiment are similar to those of the fifth embodiment.

### [Tenth Embodiment]

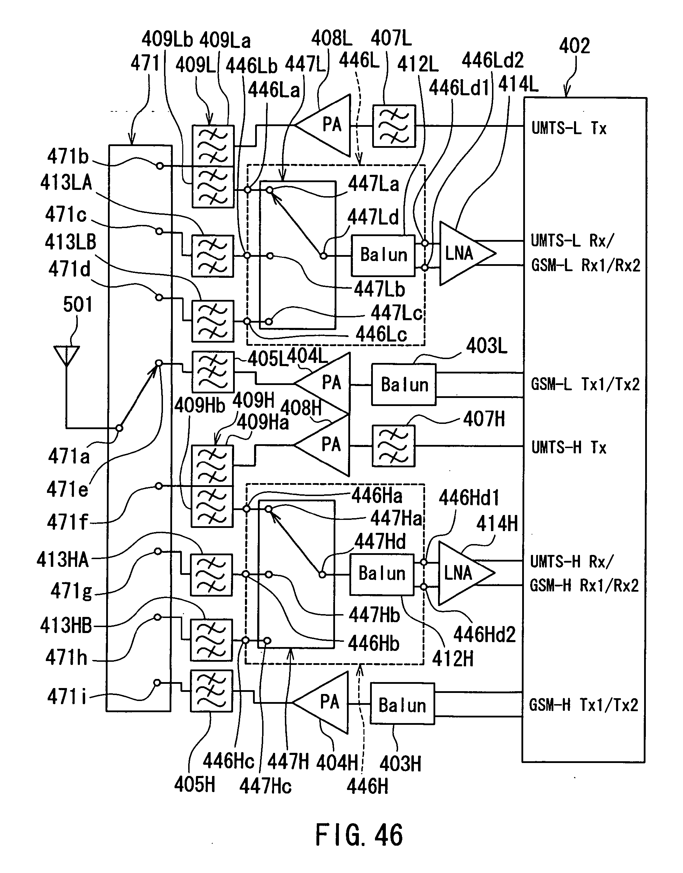

A high frequency electronic component of a tenth embodiment of the invention will now be described with reference to FIG. 46. FIG. 46 shows a high frequency circuit including two high frequency electronic components 446L and 446H of the tenth embodiment. This high frequency circuit processes four GSM signals and two UMTS signals, as in the ninth embodiment.

The high frequency circuit shown in FIG. 46 includes the antenna 501, a switch 471, and the IC 402. The switch 471 has nine ports 471a, 471b, 471c, 471d, 471e, 471f, 471g, 471h and 471i, and connects the port 471a selectively to one of the ports 471b, 471c, 471d, 471e, 471f, 471g, 471h and 471i. The port 471a is connected to the antenna 501.

In the tenth embodiment, the IC 402 generates and outputs two UMTS transmission signals UMTS-L Tx and UMTS-H Tx, and four GSM transmission signals GSM-L Tx1, GSM-L Tx2, GSM-H Tx1 and GSM-H Tx2, as in the ninth embodiment. The two UMTS transmission signals UMTS-L Tx and UMTS-H Tx outputted by the IC 402 are each in the form of an unbalanced signal. The four GSM transmission signals GSM-L Tx1, GSM-L Tx2, GSM-H Tx1 and GSM-H Tx2 outputted by the IC 402 are each in the form of a balanced signal. The IC 402 receives two UMTS reception signals UMTS-L Rx and UMTS-H Rx, and four GSM reception signals GSM-L Rx1, GSM-L Rx2, GSM-H Rx1 and GSM-H Rx2, as in the ninth embodiment. The reception signals UMTS-L Rx, UMTS-H Rx, GSM-L Rx1, GSM-L Rx2, GSM-H Rx1 and GSM-H Rx2 received by the IC 402 are each in the form of a balanced signal.

In the tenth embodiment, the transmission signal GSM-L Tx1 and the reception signal GSM-L Rx1 are a transmission signal and a reception signal of one of GSM850 (AGSM) and GSM900 (EGSM), which are close to each other in frequency band, among the four systems shown in Table 1. The transmission signal GSM-L Tx2 and the reception signal GSM-L Rx2 are a transmission signal and a reception signal of the other of GSM850 (AGSM) and GSM900 (EGSM). The transmission signal UMTS-L Tx and the reception signal UMTS-L Rx are a transmission signal and a reception signal of one of the bands V, VI and VIII, the frequency bands of which are close to those of GSM850 (AGSM) and GSM900 (ESGM), among the 10 bands shown in Table 2.

The transmission signal GSM-H Tx1 and the reception signal GSM-H Rx1 are a transmission signal and a reception signal of one of GSM1800 (DCS) and GSM1900 (PCS), which are close to each other in frequency band, among the four systems shown in Table 1. The transmission signal GSM-H Tx2 and the reception signal GSM-H Rx2 are a transmission signal and a reception signal of the other of GSM1800 (DCS) and GSM1900 (PCS). The transmission signal UMTS-H Tx and the reception signal UMTS-H Rx are a transmission signal and a reception signal of one of the bands I, II, III, IV, IX and X, the frequency bands of which are close to those of GSM1800 (DCS) and GSM1900 (PCS), among the 10 bands shown in Table 2.

The high frequency circuit of the tenth embodiment includes the high frequency electronic components 446L and 446H of the embodiment, instead of the two high frequency electronic components 410L and 410H of the ninth embodiment. The high frequency circuit of the tenth embodiment further includes four BPFs 413LA, 413LB, 413HA and 413HB, instead of the two BPFs 413L and 413H of the ninth embodiment. The remainder of configuration of the high frequency circuit of the tenth embodiment is the same as that of the high frequency circuit of the ninth embodiment shown in FIG. 44.

The high frequency electronic component 446L has input terminals 446La, 446Lb and 446Lc, output terminals 446Ld1 and 446Ld2, a switch 447L, and a balun 412L. The switch 447L has three input ports 447La, 447Lb and 447Lc and an output port 447Ld, and connects the output port 447Ld selectively to one of the input ports 447La, 447Lb and 447Lc. The balun 412L has an unbalanced input and two balanced outputs.

The high frequency electronic component 446H has input terminals 446Ha, 446Hb and 446Hc, output terminals 446Hd1 and 446Hd2, a switch 447H, and a balun 412H. The switch 447H has three input ports 447Ha, 447Hb and 447Hc and an output port 447Hd, and connects the output port 447Hd selectively to one of the input ports 447Ha, 447Hb and 447Hc. The balun 412H has an unbalanced input and two balanced outputs.

The first port of the duplexer 409L is connected to the port 471b of the switch 471. The second port of the duplexer 409L is connected to the output of the power amplifier 408L. The third port of the duplexer 409L is connected to the input terminal 446La of the high frequency electronic component 446L.

The first port of the duplexer 409H is connected to the port 471f of the switch 471. The second port of the duplexer 409H is connected to the output of the power amplifier 408H. The third port of the duplexer 409H is connected to the input terminal 446Ha of the high frequency electronic component 446H.

The unbalanced output of the power amplifier 404L for amplifying the transmission signals GSM-L Tx1 and GSM-L Tx2 is connected to the port 471e of the switch 471 via the LPF 405L. The unbalanced output of the power amplifier 404H for amplifying the transmission signals GSM-H Tx1 and GSM-H Tx2 is connected to the port 471i of the switch 471 via the LPF 405H.

Each of the BPFs 413LA, 413LB, 413HA and 413HB has an unbalanced input and an unbalanced output. The inputs of the BPFs 413LA, 413LB, 413HA and 413HB are respectively connected to the ports 471c, 471d, 471g and 451h of the switch 471. The outputs of the BPFs 413LA and 413LB are respectively connected to the input terminals 446Lb and 446Lc of the high frequency electronic component 446L. The outputs of the BPFs 413HA and 413HB are respectively connected to the input terminals 446Hb and 446Hc of the high frequency electronic component 446H.

The input ports 447La, 447Lb and 447Lc of the switch 447L are respectively connected to the input terminals 446La, 446Lb and 446Lc of the high frequency electronic component 446L. The output port 447Ld of the switch 447L is connected to the unbalanced input of the balun 412L. The two balanced outputs of the balun 412L are connected to the output terminals 446Ld1 and 446Ld2 of the high frequency electronic component 446L.

The input ports 447Ha, 447Hb and 447Hc of the switch 447H are respectively connected to the input terminals 446Ha, 446Hb and 446Hc of the high frequency electronic component 446H. The output port 447Hd of the switch 447H is connected to the unbalanced input of the balun 412H. The two balanced outputs of the balun 412H are connected to the output terminals 446Hd1 and 446Hd2 of the high frequency electronic component 446H.

The two differential inputs of the low-noise amplifier 414L are connected to the two output terminals 446Ld1 and 446Ld2 of the high frequency electronic component 446L. The two differential inputs of the low-noise amplifier 414H are connected to the two output terminals 446Hd1 and 446Hd2 of the high frequency electronic component 446H.

In the high frequency circuit of the tenth embodiment, the BPF 409Lb of the duplexer 409L, the BPF 409Hb of the duplexer 409H, the high frequency electronic components 446L and 446H, the BPFs 413LA, 413LB, 413HA and 413HB and the low-noise amplifiers 414L and 414H constitute the reception circuit.

The function of the high frequency circuit including the high frequency electronic components 446L and 446H of the tenth embodiment will now be described. The IC 402 generates and outputs the transmission signals GSM-L Tx1, GSM-L Tx2, GSM-H Tx1 and GSM-H Tx2 each in the form of a balanced signal, and the transmission signals UMTS-L Tx and UMTS-H Tx each in the form of an unbalanced signal.

When transmitting the transmission signal GSM-L Tx1 or GSM-L Tx2, the port 471a of the switch 471 is connected to the port 471e. When in this state, the transmission signal GSM-L Tx1 or GSM-L Tx2 in the form of a balanced signal outputted by the IC 402 is converted by the balun 403L to a transmission signal GSM-L Tx1 or GSM-L Tx2 in the form of an unbalanced signal. This transmission signal passes in succession through the power amplifier 404L, the LPF 405L and the switch 471 into the antenna 501, and is transmitted from the antenna 501.

When transmitting the transmission signal UMTS-L Tx, the port 471a of the switch 471 is connected to the port 471b. When in this state, the transmission signal UMTS-L Tx outputted by the IC 402 passes in succession through the BPF 407L, the power amplifier 408L, the BPF 409La of the duplexer 409L and the switch 471 into the antenna 501, and is transmitted from the antenna 501.

When transmitting the transmission signal GSM-H Tx1 or GSM-H Tx2, the port 471a of the switch 471 is connected to the port 471i. When in this state, the transmission signal GSM-H Tx1 or GSM-H Tx2 in the form of a balanced signal outputted by the IC 402 is converted by the balun 403H to a transmission signal GSM-H Tx1 or GSM-H Tx2 in the form of an unbalanced signal. This transmission signal passes in succession through the power amplifier 404H, the LPF 405H and the switch 471 into the antenna 501, and is transmitted from the antenna 501.

When transmitting the transmission signal UMTS-H Tx, the port 471a of the switch 471 is connected to the port 471f. When in this state, the transmission signal UMTS-H Tx outputted by the IC 402 passes in succession through the BPF 407H, the power amplifier 408H, the BPF 409Ha of the duplexer 409H and the switch 471 into the antenna 501, and is transmitted from the antenna 501.

When receiving the reception signal GSM-L Rx1, the port 471a of the switch 471 is connected to the port 471c, and the output port 447Ld of the switch 447L is connected to the input port 447Lb. When in this state, the reception signal GSM-L Rx1 in the form of an unbalanced signal received by the antenna 501 passes in succession through the switch 471, the BPF 413LA and the switch 447L, and enters the balun 412L. The balun 412L converts the reception signal GSM-L Rx1 in the form of an unbalanced signal outputted from the switch 447L to a reception signal GSM-L Rx1 in the form of a balanced signal, and outputs this signal to the differential input/output low-noise amplifier 414L. The reception signal GSM-L Rx1 received at the low-noise amplifier 414L is amplified by the low-noise amplifier 414L, and enters the IC 402.

When receiving the reception signal GSM-L Rx2, the port 471a of the switch 471 is connected to the port 471d, and the output port 447Ld of the switch 447L is connected to the input port 447Lc. When in this state, the reception signal GSM-L Rx2 in the form of an unbalanced signal received by the antenna 501 passes in succession through the switch 471, the BPF 413LB and the switch 447L, and enters the balun 412L. The balun 412L converts the reception signal GSM-L Rx2 in the form of an unbalanced signal outputted from the switch 447L to a reception signal GSM-L Rx2 in the form of a balanced signal, and outputs this signal to the differential input/output low-noise amplifier 414L. The reception signal GSM-L Rx2 received at the low-noise amplifier 414L is amplified by the low-noise amplifier 414L, and enters the IC 402.

When receiving the reception signal UMTS-L Rx, the port 471a of the switch 471 is connected to the port 471b, and the output port 447Ld of the switch 447L is connected to the input port 447La. When in this state, the reception signal UMTS-L Rx in the form of an unbalanced signal received by the antenna 501 passes in succession through the switch 471, the BPF 409Lb of the duplexer 409L and the switch 447L, and enters the balun 412L. The balun 412L converts the reception signal UMTS-L Rx in the form of an unbalanced signal outputted from the switch 447L to a reception signal UMTS-L Rx in the form of a balanced signal, and outputs this signal to the differential input/output low-noise amplifier 414L. The reception signal UMTS-L Rx received at the low-noise amplifier 414L is amplified by the low-noise amplifier 414L, and enters the IC 402. The plurality of reception signals received at the input ports 447La, 447Lb and 447Lc of the switch 447L correspond to the plurality of high frequency signals each in the form of an unbalanced signal in the present invention.

When receiving the reception signal GSM-H Rx1, the port 471a of the switch 471 is connected to the port 471g, and the output port 447Hd of the switch 447H is connected to the input port 447Hb. When in this state, the reception signal GSM-H Rx1 in the form of an unbalanced signal received by the antenna 501 passes in succession through the switch 471, the BPF 413HA and the switch 447H, and enters the balun 412H. The balun 412H converts the reception signal GSM-H Rx1 in the form of an unbalanced signal outputted from the switch 447H to a reception signal GSM-H Rx1 in the form of a balanced signal, and outputs this signal to the differential input/output low-noise amplifier 414H. The reception signal GSM-H Rx1 received at the low-noise amplifier 414H is amplified by the low-noise amplifier 414H, and enters the IC 402.

When receiving the reception signal GSM-H Rx2, the port 471a of the switch 471 is connected to the port 471h, and the output port 447Hd of the switch 447H is connected to the input port 447Hc. When in this state, the reception signal GSM-H Rx2 in the form of an unbalanced signal received by the antenna 501 passes in succession through the switch 471, the BPF 413HB and the switch 447H, and enters the balun 412H. The balun 412H converts the reception signal GSM-H Rx2 in the form of an unbalanced signal outputted from the switch 447H to a reception signal GSM-H Rx2 in the form of a balanced signal, and outputs this signal to the differential input/output low-noise amplifier 414H. The reception signal GSM-H Rx2 received at the low-noise amplifier 414H is amplified by the low-noise amplifier 414H, and enters the IC 402.

When receiving the reception signal UMTS-H Rx, the port 471a of the switch 471 is connected to the port 471f, and the output port 447Hd of the switch 447H is connected to the input port 447Ha. When in this state, the reception signal UMTS-H Rx in the form of an unbalanced signal received by the antenna 501 passes in succession through the switch 471, the BPF 409Hb of the duplexer 409H and the switch 447H, and enters the balun 412H. The balun 412H converts the reception signal UMTS-H Rx in the form of an unbalanced signal outputted from the switch 447H to a reception signal UMTS-H Rx in the form of a balanced signal, and outputs this signal to the differential input/output low-noise amplifier 414H. The reception signal UMTS-H Rx received at the low-noise amplifier 414H is amplified by the low-noise amplifier 414H, and enters the IC 402. The plurality of reception signals received at the input ports 447Ha, 447Hb and 447Hc of the switch 447H correspond to the plurality of high frequency signals each in the form of an unbalanced signal in the present invention.

According to the tenth embodiment, a single low-noise amplifier 414L is used in common for the three reception signals UMTS-L Rx, GSM-L Rx1 and GSM-L Rx2, and a single low-noise amplifier 414H is used in common for the three reception signals UMTS-H Rx, GSM-H Rx1 and GSM-H Rx2. The tenth embodiment thus requires only two low-noise amplifiers in the reception circuit, thereby allowing reductions in size and cost of the reception circuit and the high frequency circuit of a cellular phone including the reception circuit. Furthermore, according to the tenth embodiment, the baluns 412L and 412H convert the reception signals each in the form of an unbalanced signal outputted from the output ports 411Lc and 411Hc of the switches 411L and 411H, respectively, to reception signals each in the form of a balanced signal, and output these signals to the low-noise amplifiers 414L and 414H, respectively. The tenth embodiment thus allows the use of the differential input/output low-noise amplifiers 414L and 414H, thereby allowing an improvement in reception sensitivity.

The high frequency electronic component 446L of the tenth embodiment may include at least one of the low-noise amplifier 414L and the BPFs 413LA and 413LB, in addition to the switch 447L and the balun 412L, like the first to third modification examples of the fifth embodiment. Similarly, the high frequency electronic component 446H of the tenth embodiment may include at least one of the low-noise amplifier 414H and the BPFs 413HA and 413HB, in addition to the switch 447H and the balun 412H. The remainder of configuration, functions and advantages of the tenth embodiment are similar to those of the ninth embodiment.

### [Eleventh Embodiment]

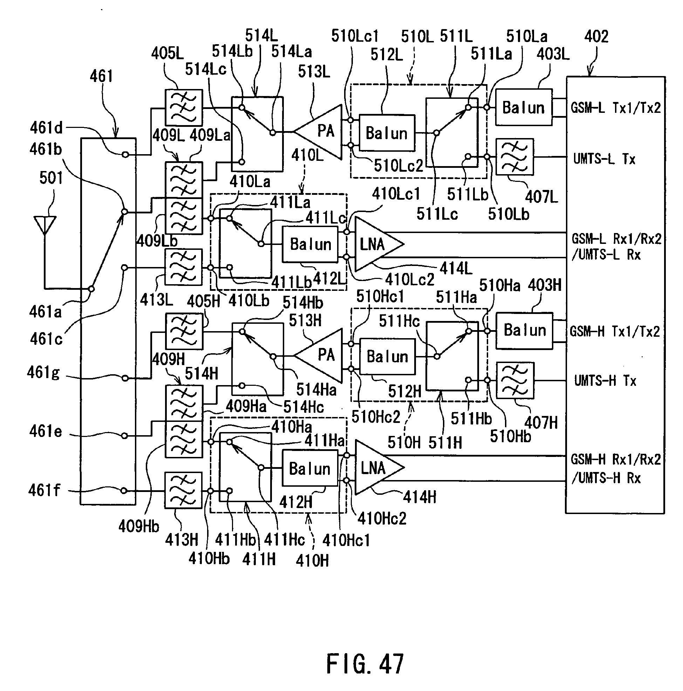

A high frequency electronic component of an eleventh embodiment of the invention will now be described with reference to FIG. 47. FIG. 47 shows a high frequency circuit including four high frequency electronic components 410L, 410H, 510L and 510H of the eleventh embodiment. This high frequency circuit processes four GSM signals and two UMTS signals, as in the ninth embodiment.

The high frequency circuit of the eleventh embodiment includes the high frequency electronic component 510L, a balanced input power amplifier 513L and a switch 514L, instead of the power amplifiers 404L and 408L of the ninth embodiment. The high frequency circuit of the eleventh embodiment further includes the high frequency electronic component 510H, a balanced input power amplifier 513H and a switch 514H, instead of the power amplifiers 404H and 408H of the ninth embodiment. The remainder of configuration of the high frequency circuit of the eleventh embodiment is the same as that of the high frequency circuit of the ninth embodiment shown in FIG. 44.

The high frequency electronic component 510L has input terminals 510La and 510Lb, output terminals 510Lc1 and 510Lc2, a switch 511L, and a balun 512L. The switch 511L has two input ports 511La and 511Lb and an output port 511Lc, and connects the output port 511Lc selectively to one of the input ports 511La and 511Lb. The balun 512L has an unbalanced input and two balanced outputs.

The input port 511La of the switch 511L is connected to the input terminal 510La of the high frequency electronic component 510L. The input port 511Lb of the switch 511L is connected to the input terminal 510Lb of the high frequency electronic component 510L. The output port 511Lc of the switch 511L is connected to the unbalanced input of the balun 512L. The two balanced outputs of the balun 512L are connected to the output terminals 510Lc1 and 510Lc2 of the high frequency electronic component 510L.

The unbalanced output of the balun 403L is connected to the input terminal 510La of the high frequency electronic component 510L. The output of the BPF 407L is connected to the input terminal 510Lb of the high frequency electronic component 510L.

The power amplifier 513L has two balanced inputs and an unbalanced output. The output terminals 510Lc1 and 510Lc2 of the high frequency electronic component 510L are connected to the two balanced inputs of the power amplifier 513L.

The switch 514L has an input port 514La and two output ports 514Lb and 514Lc, and connects the input port 514La selectively to one of the output ports 514Lb and 514Lc. The output of the power amplifier 513L is connected to the input port 514La. The output port 514Lb is connected to the input of the LPF 405L. The output port 514Lc is connected to the second port of the duplexer 409L, that is, the input of the BPF 409La.

The high frequency electronic component 510H has input terminals 510Ha and 510Hb, output terminals 510Hc1 and 510Hc2, a switch 511H, and a balun 512H. The switch 511H has two input ports 511Ha and 511Hb and an output port 511Hc, and connects the output port 511Hc selectively to one of the input ports 511Ha and 511Hb. The balun 512H has an unbalanced input and two balanced outputs.

The input port 511Ha of the switch 511H is connected to the input terminal 510Ha of the high frequency electronic component 510H. The input port 511Hb of the switch 511H is connected to the input terminal 510Hb of the high frequency electronic component 510H. The output port 511Hc of the switch 511H is connected to the unbalanced input of the balun 512H. The two balanced outputs of the balun 512H are connected to the output terminals 510Hc1 and 510Hc2 of the high frequency electronic component 510H.

The unbalanced output of the balun 403H is connected to the input terminal 510Ha of the high frequency electronic component 510H. The output of the BPF 407H is connected to the input terminal 510Hb of the high frequency electronic component 510H.

The power amplifier 513H has two balanced inputs and an unbalanced output. The output terminals 510Hc1 and 510Hc2 of the high frequency electronic component 510H are connected to the two balanced inputs of the power amplifier 513H.

The switch 514H has an input port 514Ha and two output ports 514Hb and 514Hc, and connects the input port 514Ha selectively to one of the output ports 514Hb and 514Hc. The output of the power amplifier 513H is connected to the input port 514Ha. The output port 514Hb is connected to the input of the LPF 405H. The output port 514Hc is connected to the second port of the duplexer 409H, that is, the input of the BPF 409Ha.

According to the eleventh embodiment, when transmitting the transmission signal GSM-L Tx1 or GSM-L Tx2, the port 461a of the switch 461 is connected to the port 461d, the port 511Lc of the switch 511L is connected to the port 511La, and the port 514La of the switch 514L is connected to the port 514Lb. When in this state, the transmission signal GSM-L Tx1 or GSM-L Tx2 in the form of a balanced signal outputted by the IC 402 is converted by the balun 403L to a transmission signal GSM-L Tx1 or GSM-L Tx2 in the form of an unbalanced signal. This transmission signal passes through the switch 511L and is converted by the balun 512L to a transmission signal GSM-L Tx1 or GSM-L Tx2 in the form of a balanced signal. This signal is amplified by the power amplifier 513L and is outputted as a transmission signal GSM-L Tx1 or GSM-L Tx2 in the form of an unbalanced signal. This signal passes in succession through the switch 514L, the LPF 405L and the switch 461 into the antenna 501, and is transmitted from the antenna 501.

When transmitting the transmission signal UMTS-L Tx, the port 461a of the switch 461 is connected to the port 461b, the port 511Lc of the switch 511L is connected to the port 511Lb, and the port 514La of the switch 514L is connected to the port 514Lc. When in this state, the transmission signal UMTS-L Tx in the form of an unbalanced signal outputted by the IC 402 passes in succession through the BPF 407L and the switch 511L, and is converted by the balun 512L to a transmission signal UMTS-L Tx in the form of a balanced signal. This signal is amplified by the power amplifier 513L and is outputted as a transmission signal UMTS-L Tx in the form of an unbalanced signal. This signal passes in succession through the switch 514L, the BPF 409La of the duplexer 409L and the switch 461 into the antenna 501, and is transmitted from the antenna 501.

When transmitting the transmission signal GSM-H Tx1 or GSM-H Tx2, the port 461a of the switch 461 is connected to the port 461g, the port 511Hc of the switch 511H is connected to the port 511Ha, and the port 514Ha of the switch 514H is connected to the port 514Hb. When in this state, the transmission signal GSM-H Tx1 or GSM-H Tx2 in the form of a balanced signal outputted by the IC 402 is converted by the balun 403H to a transmission signal GSM-H Tx1 or GSM-H Tx2 in the form of an unbalanced signal. This transmission signal passes through the switch 511H and is converted by the balun 512H to a transmission signal GSM-H Tx1 or GSM-H Tx2 in the form of a balanced signal. This signal is amplified by the power amplifier 513H and is outputted as a transmission signal GSM-H Tx1 or GSM-H Tx2 in the form of an unbalanced signal. This signal passes in succession through the switch 514H, the LPF 405H and the switch 461 into the antenna 501, and is transmitted from the antenna 501.

When transmitting the transmission signal UMTS-H Tx, the port 461a of the switch 461 is connected to the port 461e, the port 511Hc of the switch 511H is connected to the port 511Hb, and the port 514Ha of the switch 514H is connected to the port 514Hc. When in this state, the transmission signal UMTS-H Tx in the form of an unbalanced signal outputted by the IC 402 passes in succession through the BPF 407H and the switch 511H, and is converted by the balun 512H to a transmission signal UMTS-H Tx in the form of a balanced signal. This signal is amplified by the power amplifier 513H and is outputted as a transmission signal UMTS-H Tx in the form of an unbalanced signal. This signal passes in succession through the switch 514H, the BPF 409Ha of the duplexer 409H and the switch 461 into the antenna 501, and is transmitted from the antenna 501.

According to the eleventh embodiment, a single power amplifier 513L is used in common for the three transmission signals UMTS-L Tx, GSM-L Tx1 and GSM-L Tx2, and a single power amplifier 513H is used in common for the three transmission signals UMTS-H Tx, GSM-H Tx1 and GSM-H Tx2. Compared with the ninth embodiment, the eleventh embodiment thus allows a reduction in the number of the power amplifiers by two, thereby allowing reductions in size and cost of the high frequency circuit of a cellular phone. The remainder of configuration, functions and advantages of the eleventh embodiment are similar to those of the ninth embodiment.

The present invention is not limited to the foregoing embodiments but can be carried out in various modifications. For example, the present invention is applicable not only to a transmission circuit and a reception circuit of a cellular phone but also to any transmission circuit that processes a plurality of transmission signals or any reception circuit that processes a plurality of reception signals.

It is apparent that the present invention can be carried out in various forms and modifications in the light of the foregoing descriptions. Accordingly, within the scope of the following claims and equivalents thereof, the present invention can be carried out in forms other than the foregoing most preferable embodiments.

## Claims

1. A high frequency electronic component for use in a signal processing circuit that processes a plurality of high frequency signals and that includes a balanced input amplifier for amplifying a high frequency signal in the form of a balanced signal, the high frequency electronic component comprising:
a switch having an output port and a plurality of input ports, the input ports respectively receiving a plurality of high frequency signals each in the form of an unbalanced signal, the switch performing switching between the plurality of high frequency signals each in the form of an unbalanced signal received at the plurality of input ports, and outputting one of the high frequency signals from the output port; and
a balun that converts the high frequency signal in the form of an unbalanced signal outputted from the output port to a high frequency signal in the form of a balanced signal, and outputs this high frequency signal in the form of a balanced signal to the balanced input amplifier.

2. The high frequency electronic component according to claim 1, further comprising the balanced input amplifier.

3. The high frequency electronic component according to claim 1, further comprising a band-pass filter provided in at least one of signal paths that are respectively connected to the plurality of input ports.

4. The high frequency electronic component according to claim 1, further comprising a capacitor provided in at least one of signal paths that are respectively connected to the output port and the plurality of input ports.

5. The high frequency electronic component according to claim 1, further comprising a layered substrate including a plurality of dielectric layers stacked, wherein the layered substrate further includes a plurality of conductor layers provided within the layered substrate, the balun is formed using the plurality of conductor layers, and the switch is mounted on the layered substrate.

6. The high frequency electronic component according to claim 1, wherein:
the signal processing circuit is a transmission circuit that processes a plurality of transmission signals;
the plurality of high frequency signals each in the form of an unbalanced signal are a plurality of transmission signals each in the form of an unbalanced signal; and
the balanced input amplifier is a power amplifier.

7. The high frequency electronic component according to claim 6, further comprising a second balun that is provided in one of signal paths respectively connected to the plurality of input ports and that converts a transmission signal in the form of a balanced signal to a transmission signal in the form of an unbalanced signal.

8. The high frequency electronic component according to claim 1, wherein:
the signal processing circuit is a reception circuit that processes a plurality of receptions signals;
the plurality of high frequency signals each in the form of an unbalanced signal are a plurality of reception signals each in the form of an unbalanced signal; and
the balanced input amplifier is a differential input/output low-noise amplifier.
